(19) Europäisches Patentamt
European Patent Office
Office européen des brevets

(11) EP 1 369 231 A2

# (12) EUROPEAN PATENT APPLICATION

(43) Date of publication:
**10.12.2003 Bulletin 2003/50**

(51) Int Cl.$^7$: **B41C 1/10**, G03F 7/027

(21) Application number: **03012195.8**

(22) Date of filing: **05.06.2003**

(84) Designated Contracting States:
**AT BE BG CH CY CZ DE DK EE ES FI FR GB GR HU IE IT LI LU MC NL PT RO SE SI SK TR**
Designated Extension States:
**AL LT LV MK**

(30) Priority: **05.06.2002 JP 2002164699**
**21.06.2002 JP 2002181417**
**30.07.2002 JP 2002221550**
**30.07.2002 JP 2002221551**

(71) Applicant: **FUJI PHOTO FILM CO., LTD.**
**Kanagawa-ken (JP)**

(72) Inventors:
- **Goto, Takahiro**
  **Yoshida-cho, Haibara-gun, Shizuoka-ken (JP)**
- **Yanaka, Hiromitsu**
  **Yoshida-cho, Haibara-gun, Shizuoka-ken (JP)**
- **Shibuya, Akinori**
  **Yoshida-cho, Haibara-gun, Shizuoka-ken (JP)**
- **Kunita, Kazuto**
  **Yoshida-cho, Haibara-gun, Shizuoka-ken (JP)**

(74) Representative: **HOFFMANN - EITLE**
**Patent- und Rechtsanwälte**
**Arabellastrasse 4**
**81925 München (DE)**

## (54) Infrared photosensitive composition and image recording material for infrared exposure

(57) The invention provides a photopolymerizable composition hardenable by an infrared exposure, and an image recording material including such composition in a recording layer. The recording layer contained in the image recording material satisfies at least one of the following conditions (1) the recording layer, when exposed with an infrared laser after film formation, has a ratio of an electrostatic capacitance rate of increase in an exposed area to that in an unexposed area of 0.7 or less, (2) an image obtained by an exposure to an infrared laser and a development has a gradation (γ) of at least 4, (3) a ratio of a film hardness after exposure to that before exposure is 1.1 or higher, and (4) a ratio of a surface contact angle after exposure to that before exposure is 1.1 or higher.

EP 1 369 231 A2

## Description

CROSS-REFERENCE TO RELATED APPLICATIONS

This application claims benefit of and priority to Japanese Patent Applications Nos. 2002-164699 filed on June 5, 2002, 2002-181417 filed on June 21, 2002, and 2002-221550 and 2002-221551 filed on July 30, 2002, which are incorporated herein by reference in their entirety for all purposes.

BACKGROUND OF THE INVENTION

Field of the Invention

The present invention relates to a photopolymerizable composition hardenable by exposure to an infrared ray, and more particularly to an infrared sensitive composition useful for a recording layer of a negative working planographic printing plate precursor. The present invention also relates to an image recording material using a photopolymerizable composition hardenable by an exposure to an infrared ray.

Description of the Related Art

Conventionally, various systems for making a printing plate directly from digital data of a computer have been developed, for example, an image recording material of a photopolymerization system exposed by a laser emitting a visible light of blue or green color is attracting attention as an image recording layer of a planographic printing plate, capable of achieving a long printing durability based on a high strength of a coated film hardened by photopolymerization, since such material is sensitive to an argon laser and the like and enables high-speed direct platemaking utilizing a photopolymerization initiating system.

As an example of a laser printing plate utilizing a photopolymerization initiating system sensitive to a visible light emitting laser, such as an argon laser or the like, there is known a printing plate including, on an aluminum plate used as a substrate, a layer of a photopolymerizable composition which is formed by a compound containing an ethylenic double bond and capable of addition polymerization and a photopolymerization initiator, and which may further contain if desired an organic polymer binder, a thermal polymerization inhibitor and the like, and thereon an oxygen intercepting layer for intercepting oxygen which inhibits the polymerization. In such photopolymerizable planographic printing plates, an imagewise exposure of a desired image is conducted to polymerize and harden an exposed portion and an unexposed portion is removed (developed) with an aqueous alkali solution to form an image on the printing plate.

Recent advances in the laser technology have been remarkable, and solid-state lasers and semiconductor lasers emitting an infrared ray within a wavelength region of 760 to 1200 nm with a high output power and a compact size have become easily available. Such lasers are extremely useful as a recording light source when direct platemaking from the digital data such as that of a computer. For this reason, in addition to the various photosensitive recording materials having a sensitive wavelength in a practically useful visible light region not exceeding 760 nm, materials recordable with such infrared lasers are also being developed.

Among the materials selectively sensitive to the infrared ray, there are known image recording materials of a positive working type and a negative working type. For the positive-working type, JP-A No. 9-43847 discloses a material utilizing a phase change of a novolac resin, but such material has poor scratch resistance and poor handlability.

On the other hand, the negative image recording material, superior in the scratch resistance, uses a recording method of inducing a polymerization reaction utilizing radicals generated by light or heat as an initiator, thereby hardening the recording layer in an exposed area and forming an image portion. Such image forming material of negative working type has a low image forming property in comparison with the positive working type in which the recording layer is solubilized by an energy of infrared ray irradiation, and is usually subjected to a heating process prior to a developing step in order to accelerate the hardening reaction by polymerization thereby forming a strong image portion.

For a printing plate having a recording layer of such a system polymerization by light or heat, there are known technologies using a photopolymerizable or thermally polymerizable composition as a photosensitive layer, as described in JP-A Nos. 8-108621 and 9-34110. Such photosensitive layers, though having excellent image forming properties with high sensitivity, have a drawback in that adhesion at an interface of a recording layer and a substrate is insufficient, when using a substrate subjected to a hydrophilic treatment, and thus, that printing durability is insufficient.

Negative image forming materials that do not require such pre-heating are disclosed for example in JP-A Nos. 6-1088, and 9-43845, but such materials have a problem regarding image quality, particularly in a screen dot reproducibility.

SUMMARY OF THE INVENTION

The present invention provides a photosensitive composition and an image recording material, hardenable by an infrared laser, adapted for use as an image recording layer of a negative working planographic printing plate precursor capable of direct recording from digital data such as from a computer, and capable of forming an image which is excellent in printing properties such as a screen dot reproducibility.

The inventors of the present invention have found that the aforementioned objectives can be attained by regulating a difference in an electrostatic capacitance rate of increase between an exposed area and an unexposed area in a coated film after exposure to an infrared laser, at a predetermined ratio, and have thus made a first embodiment of an image recording material of the invention.

More specifically, a first embodiment of the invention provides an image recording material comprising a substrate and an image recording layer provided thereon by coating the substrate with a photosensitive composition, wherein:

the photosensitive composition comprising a compound capable of causing a hardening reaction by being exposed by an infrared ray; and
after being exposed by an infrared laser, an electrostatic capacitance rate of increase ratio of the photosensitive composition, which ratio is calculated from the following equation, is no more than 0.7.

Electrostatic capacitance rate of increase ratio =

(electrostatic capacitance rate of increase in an

exposed area/

electrostatic capacitance rate of increase in an

unexposed area)

The invention further provides a photosensitive composition comprising a compound capable of causing a hardening reaction by being exposed by an infrared ray; and

after being exposed by an infrared laser, an electrostatic capacitance rate of increase ratio of the photosensitive composition, which ratio is calculated from the following equation, is no more than 0.7.

Electrostatic capacitance rate of increase ratio =

(electrostatic capacitance rate of increase in an

exposed area/

electrostatic capacitance rate of increase in an

unexposed area)

The present inventors have further found that the aforementioned objectives can be attained by controlling a gradation of an image obtained after an exposure to an infrared laser light, and have thus made a second embodiment of the image recording material of the invention.

More specifically, the second embodiment of the invention provides an image recording material comprising a substrate and an image recording layer provided on the substrate, wherein the image recording layer comprises an infrared absorbing agent; a radical generating agent; and a radical polymerizable compound, and in the image recording layer, an image obtained by an exposure to an infrared laser and a development has a gradation (γ) of at least 4.

From a standpoint of effects, the photosensitive composition constituting the image recording layer of the aforementioned planographic printing plate precursor preferably comprises at least one structural unit represented by the following general formulae (1), (2) and (3) in an amount equal to or higher than 0.1 mol% and less than 30 mol%, and a polymer compound which can be one of dissolved and swollen by one of water and an alkaline aqueous solution.

General formula (1)

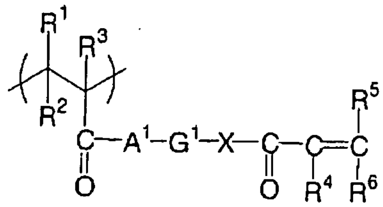

General formula (2)

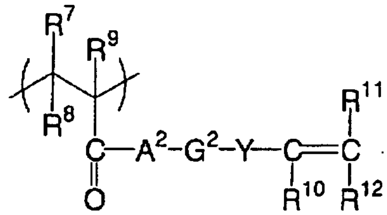

General formula (3)

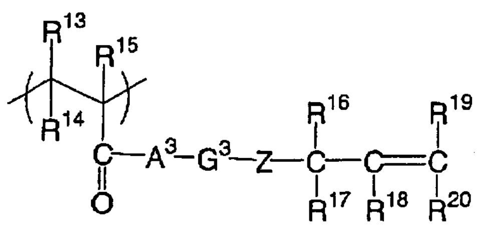

wherein $A^1$, $A^2$ and $A^3$ each independently represents an oxygen atom, a sulfur atom or $-N(R^{21})-$; $R^{21}$ represents an alkyl group which may include one or more of substituent(s); $G^1$, $G^2$ and $G^3$ each independently represents a divalent organic group; X and Z each independently represents an oxygen atom, a sulfur atom or $-N(R^{22})-$; $R^{22}$ represents an alkyl group which may include one or more of substituent(s); Y represents an oxygen atom, a sulfur atom, a phenylene group which may include one or more of substituent(s), or $-N(R^{23})-$; $R^{23}$ represents an alkyl group which may include one or more of substituent(s); and $R^1$ to $R^{20}$ each independently represents a monovalent organic group.

The radical generating agent which can be used in the image recording layer is preferably an onium salt or a triazine compound.

The present inventors have also found that the aforementioned objectives can be attained by a heat-mode negative image recording material in which a ratio of a film hardness in a recording layer after and before an exposure and/or a ratio of a surface contact angle of the recording layer after and before an exposure, and have thus made a third embodiment of the image recording material of the invention.

More specifically, the third embodiment of the invention provides an image recording material comprising a substrate and a recording layer, which is provided on the substrate and capable of image formation by heat mode exposure, wherein the recording layer comprises:

a polymerizable compound;
a photothermal converting agent; and

a radical generating agent, and
in the recording layer, a ratio of a film hardness after exposure to a film hardness before exposure is at least 1.1.

Further, a fourth embodiment of the invention provides an image recording material comprising a substrate and a recording layer, which is provided on the substrate and capable of image formation by heat mode exposure, wherein the recording layer comprises:

a polymerizable compound;
a photothermal converting agent; and
a radical generating agent, and
in the recording layer, a ratio of a surface contact angle after exposure to a surface contact angle before exposure is at least 1.1.

The aforementioned polymerizable compound is preferably a radical polymerizable compound having at least four aromatic rings, or a polymer compound having a polymerizable group in a side chain and insoluble in water and soluble in an alkali aqueous solution.

In the image recording material of the third embodiment of the invention, a mechanism of improvement in the printing durability is not clarified, but, in a recording layer hardened by a heat-mode exposure, in case a ratio of a film hardness in an exposed area (such hardness being hereinafter suitably represented as "X1") to a film hardness before exposure (such hardness being hereinafter suitably represented as "X2") is 1.1 or higher, it is assumed that the hardened area in the recording layer has a sufficiently high crosslinking density to form a firmer film, thereby effectively inhibiting penetration of a developing solution and reducing a damage to the image portion, thus achieving an improvement in the printing durability.

Also in the image recording material of the fourth embodiment of the invention, a mechanism of improvement in the printing durability is not clarified, but, in a recording layer hardened by a heat-mode exposure, in case a ratio of a surface contact angle in an exposed area (such surface contact angle being hereinafter suitably represented as "Y1") to a surface contact angle before exposure (such surface contact angle being hereinafter suitably represented as "Y2") is 1.1 or higher, such ratio indicates an increased hydrophobicity of the surface of the recording layer, thereby effectively inhibiting penetration of a developing solution and reducing a damage to the image portion, thus suppressing a deterioration of the film property in the image portion and achieving an improvement in the printing durability.

It is also conceived that a ratio Y1/Y2 of 1.1 or higher (preferably 1.2 or higher) effectively inhibits penetration of a fountain solution, used in a printing operation, into the image portion, thereby suppressing a destruction by coagulation of the image portion cause by a penetration of the fountain solution or a peeling of the recording layer from the interface of the substrate, thereby achieving an improvement in the printing durability.

Particularly in the image recording material of the third or fourth embodiment of the invention, in case the recording layer includes, as the polymerizable compound, a radical polymerizable compound having at least four aromatic rings, the ratio of film hardness (X1/X2) and/or the ratio of surface contact angle (Y1/Y2) to provide a significant effect of improving the printing durability.

Though a cause of such effect is not yet clarified, it is estimated that the radical polymerizable compound having at least four aromatic rings shows a large quadrupole interaction resulting from the aromatic groups to generate a strong monomer/monomer interaction, thereby forming a firmer film particularly with a large film hardness after exposure and an increased hydrophobicity after hardening by exposure, thus suppressing the penetration of the developing solution or the fountain solution.

Also in case, as the polymerizable compound, there is included a polymer compound having a polymerizable group in a side chain and insoluble in water and soluble in an alkali aqueous solution, the effect of improving the printing durability is further enhanced. A cause for this phenomenon is estimated that an interaction is also generated between the polymer compound and a monomer in addition to the aforementioned monomer/monomer interaction and that such polymer compound itself has excellent film properties.

It is also conceived that such polymerizable compound having at least four aromatic rings can be rearranged in the vicinity of the surface of the recording layer, by a heating at the heat mode exposure. Such phenomenon is estimated to contribute to an increase in the Y1/Y2 ratio at the surface of the recording layer after the exposure, thus leading to an improvement in the printing durability.

In the present invention, "heat mode capable" means that a recording by a heat mode exposure is possible.

In the following there will be explained a definition of a heat mode exposure in the invention. As described in Hans-Joachim Timpe, IS&Ts NIP 15: 1999 International Conference on Digital Printing Technologies, p.209, it is known, for optically exciting a light absorbing substance (for example a dye) in a photosensitive material and forming an image through a chemical or physical change, that two major modes are present in a process from the photoexcitation of the light absorbing substance to the chemical or physical change. One is so-called photon mode in which the photoexcited

light absorbing substance is deactivated upon executing a certain photochemical interaction (such as an energy transfer or an electron transfer) with another reactive substance in the photosensitive material and thus activated reactive substance causes a chemical or physical change necessary for the aforementioned image formation. The other is so-called heat mode in which the photoexcited light absorbing substance is deactivated upon generating a heat, and such heat is utilized by a reactive substance to cause a chemical or physical change necessary for the aforementioned image formation. There are also other special modes such as an ablation mode in which a substance scatters in an explosive manner by a locally concentrated optical energy, and a multi-photon absorption mode in which a molecule absorbs plural photons at a same time, but such special modes will not be explained further.

Exposure processes utilizing the aforementioned modes are respectively called a photon mode exposure and a heat mode exposure. A technical difference between the photon mode exposure and the heat mode exposure lies in a fact whether energies of exposing several photons can be utilized in addition for an energy of a desired reaction. For example, let us consider a case of inducing a reaction with n photons. In the photon mode exposure, utilizing a photochemical interaction, it is not possible to add up energies of individual photons, because of a requirement of the law of conservation of quantum energy and momentum. Stated differently, in order to induce any reaction, there is required a condition "energy of a photon ≥ energy of reaction". On the other hand, in the heat mode exposure, it is possible to add up energies since a photoexcitation is followed by a heat generation whereby the optical energy is converted into heat. Therefore, there is only required a condition "energy of n photons ≥ energy of reaction". However, such addition of energies is restricted by a diffusion of heat. More specifically, in case, in an object exposure area (reaction point), a next photoexcitation-deactivation process occurs to generate heat before heat is dissipated by thermal diffusion, the heat is securely accumulated and added thereby elevating the temperature of such point. However, in case a next heat generation is late, the heat is dissipated and is not accumulated. Thus, in the heat mode exposure, for a same total exposure energy, a short irradiation of the light of a higher energy amount and a long irradiation of the light of a lower energy amount give different results, and the short irradiation is advantageous for heat accumulation.

The photon mode exposure is basically free from such phenomenon, although a similar phenomenon may naturally arise by an influence of diffusion of succeeding reaction species.

Thus, from the standpoint of characteristics of a photosensitive material, a specific sensitivity (energy amount for a reaction required for image formation) of a photosensitive material in the photon mode becomes constant with respect to an exposure power density ($W/cm^2$) (= energy density per unit time), but, in the heat mode, the specific sensitivity of the photosensitive material increases with an increase in the exposure power density. Therefore, in a comparison of these modes with a fixed exposure time capable of maintaining a practically required productivity in an image recording material, the photon mode exposure can usually achieve a high sensitivity of about 0.1 $mJ/cm^2$ but may results in a low-exposure fog in an unexposed area because of the reaction can be induced at any low exposure amount. On the other hand, the heat mode exposure generally requires an exposure of about 50 $mJ/cm^2$ since the reaction can only be induced beyond a certain exposure amount and also in consideration of thermal stability of the photosensitive material, but can avoid the drawback of low-exposure fog.

In practice, in the heat mode exposure, there is required an exposure power density of 5,000 $W/cm^2$ or higher on the surface of the photosensitive material, preferably 10,000 $W/cm^2$ or higher. However, the use of a laser of a high power density of $5.0 \times 10^5$ $W/cm^2$ or higher causes an ablation phenomenon and is undesirable for example for a smear of the light source, though such phenomena has not been explained in detail.

## BRIEF DESCRIPTION OF THE DRAWINGS

Fig. 1 is a chart showing a relationship between an immersion time of a photosensitive composition in a model solution and an electrostatic capacitance, to be used for calculating an electrostatic capacitance rate of increase ratio.

## DETAILED DESCRIPTION OF THE INVENTION

In the following, the present invention will be clarified in detail.

In an image recording material of the first embodiment of the present invention, such as in a planographic printing plate precursor, a photosensitive composition included in an image recording layer coated on a substrate is required, after a film formation and being exposed by an infrared laser, to have an electrostatic capacitance rate of increase ratio of 0.7 or less in an exposed area to an unexposed area.

The electrostatic capacitance rate of increase ratio used in the invention is calculated from an rate of increase of an electrostatic capacitance to be explained in the following. The electrostatic capacitance is obtained by immersing a photosensitive composition coated on a conductive substrate (aluminum) and a counter electrode (such as aluminum,

stainless steel or platinum) in a model solution (in the invention, an alkali aqueous solution to be explained in the following) and measuring an impedance between the electrode with a sinusoidal AC current of 1 kHz. In the actual measurement, the conductive substrate has be prevented from direct contact with the model solution, so that the immersion in the model solution is executed after covering the photosensitive composition, formed into a film, with a shield material which the model solution does not permeate except for an aperture of a predetermined area, provided at a side of the surface coated with the photosensitive composition and exposing the photosensitive composition as a measurement sample in the solution. The electrostatic capacitance increases with the permeation of the model solution into the coated film of the photosensitive composition which in contact with the model solution in the above-mentioned aperture. In such process, an rate of increase of the electrostatic capacitance becomes larger as the permeation of the model solution is faster into the coated film of the photosensitive composition. The measurement on such coated film of the photosensitive composition is executed for both of a sample prior to the exposure to the infrared laser and a sample after a flush exposure. In the invention, an electrostatic capacitance rate of increase ratio is calculated from a following equation:

Electrostatic capacitance rate of increase ratio =

(electrostatic capacitance rate of increase in an

exposed area/

electrostatic capacitance rate of increase in an

unexposed area).

In the following, a measured value used in the invention indicates an electrostatic capacitance rate of increase ratio of an exposed area and an unexposed area at a time when the electrostatic capacitance rate of increase in the unexposed area becomes maximum. At the measurement, the model solution has to be maintained at a constant temperature, and the invention uses values measured at 25°C.

Fig. 1 is a chart showing a plotting of the electrostatic capacitance as a function of the immersion time of the photosensitive composition in the model solution, and, as shown in Fig. 1, an inclination of the graph indicates the electrostatic capacitance rate of increase. As an example, in case a change in the electrostatic capacitance is obtained in the exposed area and the unexposed area as shown in Fig. 1, the unexposed area shows a maximum electrostatic capacitance rate of increase at an immersion time of 25 seconds, with an inclination of 35 nF/sec. As explained in the foregoing, the electrostatic capacitance rate of increase ratio used in the invention is determined from the electrostatic capacitance rate of increase at a time when the electrostatic capacitance rate of increase in the unexposed area becomes maximum, so that the electrostatic capacitance rate of increase in the exposed area at an immersion time of 25 seconds is measured as 1.8 nF/sec. Consequently, in such photosensitive composition, the electrostatic capacitance rate of increase ratio is determined as 0.05.

A smaller electrostatic capacitance rate of increase ratio indicates a stronger inhibition for the penetration of the model solution into the exposed area, corresponding to a larger discrimination between the unexposed area and the exposed area to the model solution (basically an alkali aqueous solution of a predetermined pH value). The present inventors have found that a smaller electrostatic capacitance rate of increase ratio provides a better image forming property also in an actual developing solution constituted by an alkali aqueous solution. The electrostatic capacitance rate of increase ratio providing such satisfactory image is 0.7 or less, preferably 0.5 or less and further preferably 0.3 or less.

As a reference, in an ordinary photosensitive composition usable as a recording layer of a planographic printing plate precursor for infrared laser exposure, the electrostatic capacitance rate of increase ratio without a post-heating is about 0.8 to 1.0, and an image with excellent screen dot reproducibility can be obtained by regulating such value to 0.7 or less by means to be explained later.

Also, the specified model solution to be used in the invention is selected according to a pKa value of an acid group of the binder polymer to be used in the compostion.

For a pKa value less than 9, there is used a model solution 1 (pH 11.8) to be explained later, and, for a pKa value of 9 or higher, there is used a model solution 2 (pH 13) to be explained later.

Preparation of model solution 1 (pH 11.8)

There are used potassium hydroxide and potassium carbonate as alkaline agents, polyethylene glycol mononaphthyl ether as a solubilizing agent and water as a solvent, and pH value is adjusted to 11.8 with tetrasodium ethylenediamine tetraacetate as a buffer. An example of specific formulation is shown in the following:

| Model solution 1 | |
|---|---|
| potassium hydroxide | 0.7 g |
| potassium carbonate | 1.7 g |
| polyethylene glycol mononaphthyl ether | 53 g |
| tetrasodium ethylenediamine tetraacetate | 1.5 g |
| water | 955 g |

Preparation of model solution 2 (pH 13)

There are used potassium hydroxide and 1K potassium silicate as alkaline agents, and water as a solvent, and pH value is adjusted to 13 with tetrasodium ethylenediamine tetraacetate as a buffer. An example of specific formulation is shown in the following:

| Model solution 2 | |
|---|---|
| potassium hydroxide | 10 g |
| 1K potassium silicate (CAS-1312-76-1) | 50 g |
| tetrasodium ethylenediamine tetraacetate | 0.03 g |
| water | 970 g |

By measuring the electrostatic capacitance rate of increase in this manner, it is possible to estimate a level of discrimination of the photosensitive composition in a state of a coated film, to the model solution. For example, in case the photosensitive composition of the invention is utilized as a recording layer of a planographic printing plate precursor, it is possible to estimate the level of discrimination, by using an alkaline developing solution, to be used in the development process, as the model solution.

As explained in the foregoing, a lower electrostatic capacitance rate of increase ratio is preferred, and the electrostatic capacitance rate of increase can be lowered by regulating a compound relating to a film hardening in the photosensitive composition, and, for example in case of a photosensitive composition hardenable by polymerization, by adjusting a type and an addition amount of a radial generating agent or a radical polymerizable compound.

More specifically, there can be used, for example, a method of increasing an amount of the radical generating agent, using a radical generating agent of a higher sensitivity, increasing an amount of the radical polymerizable compound, or using a radical polymerizable compound of polyfunctional character.

In case the photosensitive composition is used as an image recording layer of a planographic printing plate precursor and is hardened by a crosslinking reaction or a polymerization reaction induced by an exposure, the photosensitive composition in an exposed area, namely in an image portion, may be hardened uniformly over the entire coated film or hardened in an upper layer portion of the coated film, namely only the vicinity of a surface of the exposed recording layer, while the hardening reaction does not proceed sufficiently in a deeper part of the recording layer, but it is particularly preferred that only an upper layer portion of the image is hardened. In case the upper layer portion alone of the image is hardened, the lower layer portion of the image is not hardened by crosslinking and is dissolved in a developing solution, thereby providing a sharp-cut image. Such state is preferred as it provides a sharp image of a high resolution in a print.

Such film hardened state can be attained also by regulating a type and an addition amount of an infrared absorbing agent, in addition to those of the radical generating agent and the radical polymerizable compound explained in the foregoing. This is because an increase in the amount of the infrared absorbing agent improves a photothermal conversion efficiency at the exposed surface thereby stimulating an efficient hardening, but reduces the optical transmission of the entire film thereby suppressing the hardening in a deeper part of the film.

In an image recording material of the second embodiment of the invention, a gradation ($\gamma$) of an image obtained by coating an image recording layer on a substrate, followed by an exposure with an infrared laser light and a development process, satisfies a condition $\gamma \geq 4$, preferably $\gamma \geq 6$.

In the invention, a gradation ($\gamma$) of an image means an inclination of a characteristic curve indicating a correlation between an image density on the printing plate and an exposure amount.

The characteristic curve, to be used for determining the $\gamma$ value in the image recording material of the second embodiment of the invention (preferably a negative working planographic printing plate precursor for infrared exposure),

can be prepared by forming an image recording layer on a substrate, executing exposures under different exposure amounts varied by an output of a plate setter, measuring densities of images obtained by development processes, and plotting dependancies of image densities on the exposure amounts. A maximum density of the image densities is used as normalized value 1. In case the photosensitive composition is used as the image recording layer of the planographic printing plate precursor, a coloring agent is usually added for the purpose of plate inspection, so that the image density can be directly measured.

In the invention, the γ value defined as an image gradation indicates an inclination of the characteristic curve within a density range from 0.4 to 0.8 [(0.8 - 0.4)/(difference in exposure amounts (logarithmic) providing densities 0.4 and 0.8)]. The density was measured with a Macbeth reflective densitometer RD-918 (trade name, manufactured by Macbeth), and at a cyan density utilizing a red filter equipped on the densitometer. s

In general, the gradation (γ) of the image is varied depending on, for example, an exposure amount, an exposure time, a developing method, a type of a developing solution and the like. However, as is understood from the fact that photo-curable compositions used in the image recording layer of the planographic printing plate precursor usually have a γ value of about 0.5 to 3.5, there has not been attained a gradation (γ) of 4 or higher in the image obtained by an infrared laser exposure and a development process.

An effective method for controlling the gradation (γ) of the image can be a method of varying the reactivity of a polymerization initiator contained in a photopolymerizable compound. For example, in case the polymerization initiator is a compound capable of generating a radical by the light, the reactivity becomes higher as a LUMO level (lowest unoccupied molecular orbital) of the polymerization initiator becomes lower under a LUMO level of a dye for generating an electron by a light absorption, namely as the polymerization initiator has a higher electron accepting property. Also in case the polymerization initiator is a compound capable of generating a radical by heat, the reactivity becomes higher as a thermal decomposition temperature of the polymerization initiator becomes lower.

Based on such standpoints, compounds of following structures can be advantageously used in the photosensitive composition constituting the image recording layer of the invention, but such examples are not restrictive.

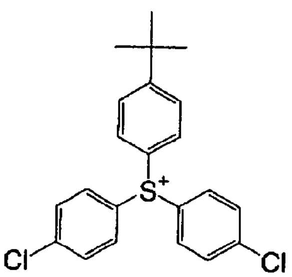

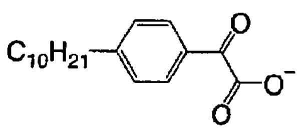

In order to realize such image gradation, the photosensitive composition constituting the image recording layer preferably includes a polymer compound which includes at least one of structural units represented by following structural formulas (1), (2) and (3) in an amount of 0.1 mol% or more and less than 30 mol% and which can be one of dissolved and swollen by one of water and an alkaline aqueous solution.

General formula (1)

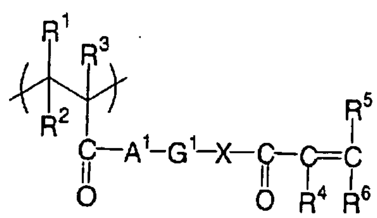

General formula (2)

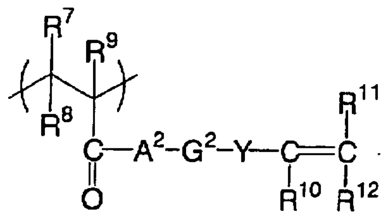

General formula (3)

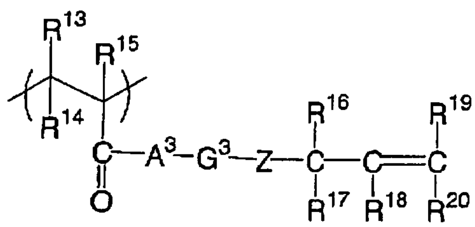

wherein $A^1$, $A^2$ and $A^3$ each independently represents an oxygen atom, a sulfur atom or $-N(R^{21})-$; $R^{21}$ represents an alkyl group which may have substituent(s); $G^1$, $G^2$ and $G^3$ each independently represents a divalent organic group; X and Z each independently represents an oxygen atom, a sulfur atom or $-N(R^{22})-$; $R^{22}$ represents an alkyl group which may have substituent(s); Y represents an oxygen atom, a sulfur atom, a phenylene group which may have substituent (s), or $-N(R^{23})$ -; $R^{23}$ represents an alkyl group which may have substituent(s); and $R^1$ to $R^{20}$ each independently represents a monovalent organic group.

Such high gradation of the image means that the image forming property of the photosensitive composition does not significantly depend on an exposure energy, and it is considered that the film crosslinked and hardened by the light, namely the image portion of the invention, shows excellent printing properties such as a dot sharpness and provides a sufficient printing durability even to a screen dot of a small area.

For obtaining an image gradation suitable for the invention, there can be adopted a method of using a polymerization initiator of a high reactivity in the image recording layer, or a method of adding a polymer of a high reactivity in the composition, and, in particular, the use of a reactive polymer stimulates a rapid proceeding of the hardening reaction after the exposure, thereby providing an image of a high gradation. Such reactive polymer can be arbitrarily selected among polymers having specified reactive functions groups, but particularly advantageous is a polymer compound which includes at least one of structural units represented by the foregoing structural formulas (1), (2) and (3) in an amount of 0.1 mol% or more and less than 30 mol% and which can be one of dissolved and swollen by one of water and an alkaline aqueous solution.

A mechanism of obtaining a high gradation, by the addition of a polymer compound having a high reactivity and serving as a binder into the composition, has not been clarified yet, however it is estimated as follows. The structural unit represented by the general formula (1), (2) or (3), having a functional group of a high radical reactivity, causes a crosslinking reaction among the binder polymers promptly after the radical generation by the scanned exposure with the infrared laser. It is thus estimated that the presence of such structural unit in the polymer composition very rapidly induces a formation of a hardened film, namely an insolubilization in the developing solution or in an organic solvent, thereby providing a hardened film of a sufficient hardness to form a strong image portion even in a screen dot or a fine line, thus attaining a high gradation.

The polymer compound advantageously employable in the invention is a polymer compound which includes at least one of structural units represented by the foregoing structural formulas (1), (2) and (3) in an amount of 0.1 mol% or more and less than 30 mol% and which can be one of dissolved and swollen by one of water and an alkaline aqueous solution.

In the foregoing general formula (1), $R^1$ to $R^3$ each independently represents a monovalent organic group, which can be a hydrogen atom, or an alkyl group that may have substituent(s), and, a hydrogen atom is preferred for $R^1$ and $R^2$, and a hydrogen atom or a methyl group is preferred for $R^3$.

$R^4$ to $R^6$ each independently represents a monovalent organic group, which, for $R^4$, can be a hydrogen atom or an alkyl group that may have substituent(s), preferably a hydrogen atom, a methyl group, or an ethyl group. $R^5$ and $R^6$ each independently represents a hydrogen atom, a halogen atom, an alkoxycarbonyl group, a sulfo group, a nitro group, a cyano group, an alkyl group which may have substituent(s), an aryl group which may have substituent(s), an alkoxy group which may have substituent(s), an aryloxy group which may have substituent(s), an alkylsulfonyl group which may have substituent(s), or an arylsulfonyl which may have substituent(s), among which preferred is a hydrogen atom, an alkoxycarbonyl group, an alkyl group which may have substituent(s) or an aryl group which may have substituent(s).

Examples of the substituent that can be introduced include a methoxycarbonyl group, an ethoxycarbonyl group, an isopropyloxycarbonyl group, a methyl group, an ethyl group and a phenyl group.

$A^1$ and X each independently represents an oxygen atom, a sulfur atom or $-N(R^{21})-$, wherein $R^{21}$ can be a hydrogen atom or an alkyl group which may have substituent(s).

$G^1$ represents a divalent organic group, preferably an alkyl group which may have substituent(s). More preferably it can be an alkyl group having from 1 to 20 carbon atoms which may have substituent(s), a cycloalkyl group having from 3 to 20 carbon atoms which may include a substituent, or an aromatic group having from 6 to 20 carbon atoms which may have substituent(s), and, in consideration of a strength and a developing property, further preferred is a linear or ramified alkyl group having from 1 to 10 carbon atoms which may have substituent(s), a cycloalkyl group having from 3 to 10 carbon atoms which may include a substituent, or an aromatic group having from 6 to 12 carbon atoms which may have substituent(s).

A substituent in $G^1$ preferably does not include a group in which a hydrogen atom is bonded to a hetero atom, such as a hydroxyl group, an amino group, a thiol group or a carboxyl group. A compound including such group, containing a hydrogen atom bonded to a hetero atom, in a connecting group portion may deteriorate a storage stability when used in combination with an onium salt as an initiator to be explained later.

In the foregoing general formula (2), $R^7$ to $R^9$ each independently represents a monovalent organic group, which can be a hydrogen atom, or an alkyl group that may have substituent(s), and, a hydrogen atom is preferred for $R^7$ and $R^8$, and a hydrogen atom or a methyl group is preferred for $R^9$.

$R^{10}$ to $R^{12}$ each independently represents a monovalent organic group, which can be a hydrogen atom, a halogen atom, a dialkylamino group, an alkoxycarbonyl group, a sulfo group, a nitro group, a cyano group, an alkyl group which may have substituent(s), an aryl group which may have substituent(s), an alkoxy group which may have substituent(s), an aryloxy group which may have substituent(s), an alkylsulfonyl group which may have substituent(s), or an arylsulfonyl which may have substituent(s), among which preferred is a hydrogen atom, an alkoxycarbonyl group, an alkyl group which may have substituent(s) or an aryl group which may have substituent(s).

Examples of the substituent that can be introduced are similar to those cited in the general formula (1).

$A^2$ represents an oxygen atom, a sulfur atom or $-N(R^{21})-$, wherein $R^{21}$ can be a hydrogen atom or an alkyl group which may have substituent(s).

$G^2$ represents a divalent organic group, preferably an alkyl group which may have substituent(s). More preferably it can be an alkyl group having from 1 to 20 carbon atoms, a cycloalkyl group having from 3 to 20 carbon atoms which may include a substituent, or an aromatic group having from 6 to 20 carbon atoms which may have substituent (s), and, in consideration of a strength and a developing property, further preferred is a linear or ramified alkyl group having from 1 to 10 carbon atoms which may have substituent(s), a cycloalkyl group having from 3 to 10 carbon atoms which may include a substituent, or an aromatic group having from 6 to 12 carbon atoms which may have substituent(s).

A substituent in $G^2$ preferably does not include a group in which a hydrogen atom is bonded to a hetero atom, such as a hydroxyl group, an amino group, a thiol group or a carboxyl group. A compound including such group, containing a hydrogen atom bonded to a hetero atom, in a connecting group portion may deteriorate a storage stability when used in combination with an onium salt as an initiator to be explained later.

Y represents an oxygen atom, a sulfur atom, $-N(R^{23})-$or a phenylene group which may have substituent(s), wherein $R^{23}$ can be a hydrogen atom or an alkyl group which may have substituent(s).

In the foregoing general formula (3), $R^{13}$ to $R^{15}$ each independently represents a monovalent organic group, which can be a hydrogen atom, or an alkyl group that may have substituent(s), and, a hydrogen atom is preferred for $R^{13}$ and $R^{14}$, and a hydrogen atom or a methyl group is preferred for $R^{15}$.

$R^{16}$ to $R^{20}$ each independently represents a monovalent organic group, which can be a hydrogen atom, a halogen atom, a dialkylamino group, an alkoxycarbonyl group, a sulfo group, a nitro group, a cyano group, an alkyl group which may have substituent(s), an aryl group which may have substituent(s), an alkoxy group which may have substituent(s), an aryloxy group which may have substituent(s), an alkylsulfonyl group which may have substituent(s), or an arylsulfonyl which may have substituent(s), among which preferred is a hydrogen atom, an alkoxycarbonyl group,

an alkyl group which may have substituent(s) or an aryl group which may have substituent(s). Examples of the substituent that can be introduced are similar to those cited in the general formula (1). $A^3$ and Z each independently represents an oxygen atom, a sulfur atom or -N($R^{21}$)-, wherein $R^{21}$ is similar to that in the general formula (1).

$G^3$ represents a divalent organic group, preferably an alkyl group which may have substituent(s). More preferably it can be an alkyl group having from 1 to 20 carbon atoms, a cycloalkyl group having from 3 to 20 carbon atoms which may include a substituent, or an aromatic group having from 6 to 20 carbon atoms which may have substituent (s), and, in consideration of a strength and a developing property, further preferred is a linear or ramified alkyl group having from 1 to 10 carbon atoms which may have substituent(s), a cycloalkyl group having from 3 to 10 carbon atoms which may include a substituent, or an aromatic group having from 6 to 12 carbon atoms which may have substituent(s).

A substituent in $G^3$ preferably does not include a group in which a hydrogen atom is bonded to a hetero atom, such as a hydroxyl group, an amino group, a thiol group or a carboxyl group. A compound including such group, containing a hydrogen atom bonded to a hetero atom, in a connecting group portion may deteriorate a storage stability of the photosensitive composition of the present invention when used in combination with an onium salt as an initiator to be explained later.

Such polymer compound can be synthesized according to a method described for example in JP-A No. 2002-62648, for example a method copolymerizing at least a radical polymerizable compound represented by a following general formula (4) in an amount of 0.1 mol% or higher and less than 30 mol%, and at least one of other radical polymerizable compounds not including a structural unit represented by the following general formula (4) in an ordinary radical polymerization to obtain a precursor of a desired polymer compound, and then extracting a proton with a base to cleave a group L, thereby obtained a desired polymer compound having a structure represented by the foregoing general formula (1).

General formula (4)

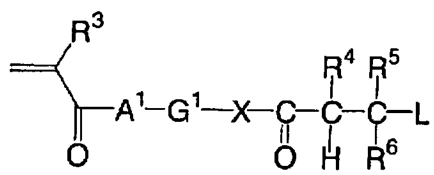

Specific examples of the reactive polymer compound advantageously employable in the invention are shown below together with a weight-averaged molecular weights thereof, however, the invention is not limited to such examples.

| | | MW |
|---|---|---|
| 1 | 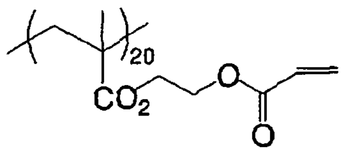 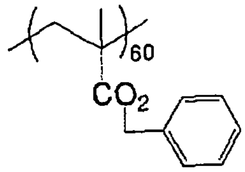 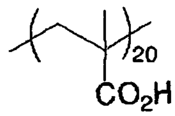 | 97000 |
| 2 | 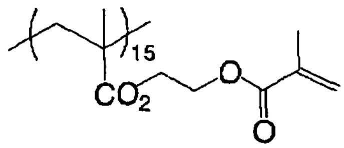 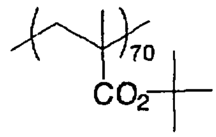 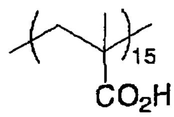 | 128000 |
| 3 | 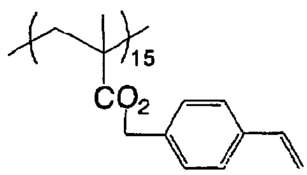 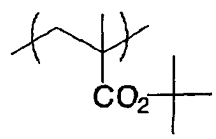 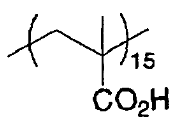 | 135000 |
| 4 | 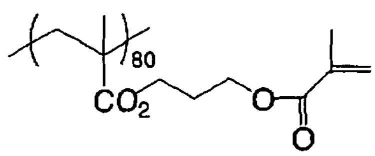 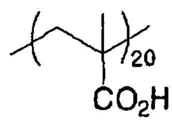 | 95000 |

| | | MW |
|---|---|---|
| 5 | 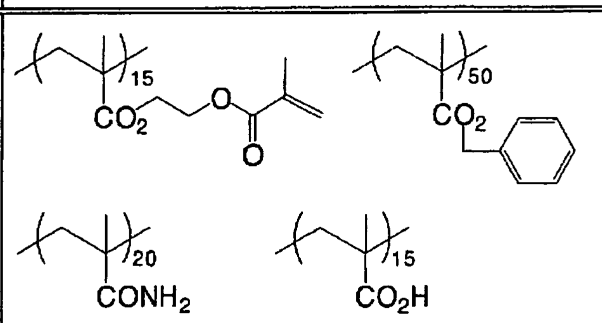 | 120000 |
| 6 | 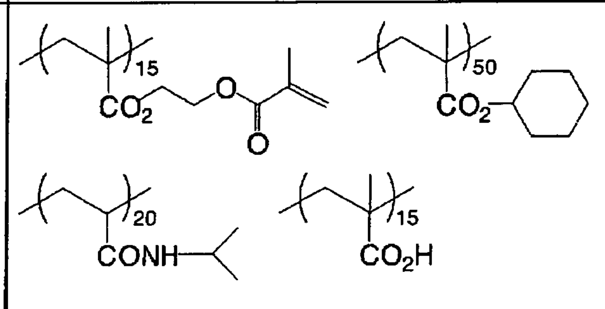 | 100000 |
| 7 | 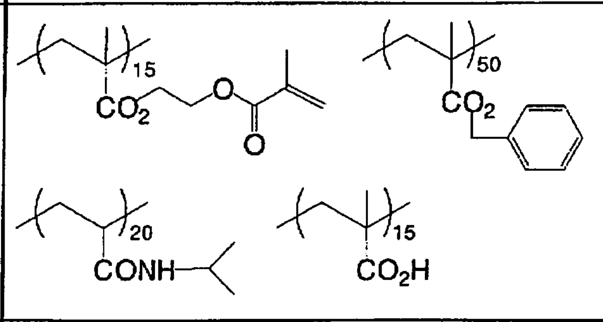 | 133000 |
| 8 | 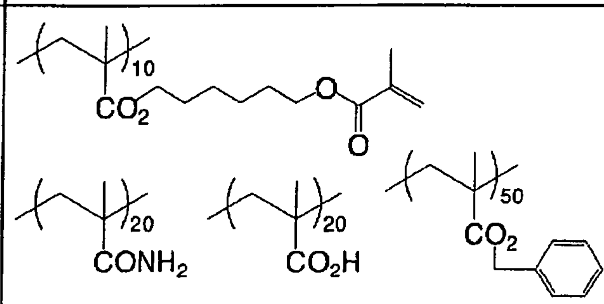 | 103000 |

In consideration of the effect of the invention, Such polymer compound having a high reactivity is preferably contained in an mount from 20 to 80 wt.%, more preferably from 40 to 70 wt.%, in a solid content of the photosensitive composition constituting the image recording material of the invention. An effect for improving the gradation cannot be obtained sufficiently when the content of polymer compounds are excessively low.

An image recording material of the third embodiment of the invention is provided, on a substrate, with a recording layer capable of image formation by a heat mode exposure and including a polymerizable compound, a photothermal converting agent and a radical generating agent (a compound generating a radical by an exposure to a light of a wavelength absorbable by the photothermal converting agent), wherein a ratio (X1/X2) of a film hardness after exposure (X1) and a film hardness before exposure (X2) is 1.1 or higher.

Also, an image recording material of the fourth embodiment of the invention is provided, on a substrate, with

a recording layer capable of image formation by a heat mode exposure and including a polymerizable compound, a photothermal converting agent and a radical generating agent (a compound generating a radical by an exposure to a light of a wavelength absorbable by the photothermal converting agent), wherein a ratio (Y1/Y2) of a surface contact angle after exposure (Y1) and a surface contact angle before exposure (Y2) is 1.1 or higher.

The film hardness and the surface contact angle in the image recording material of the invention, measuring methods therefor, and compounds employable in the image recording material are explained below. Film hardness

In an image recording material of the third embodiment of the invention, a ratio (X1/X2) of a film hardness after exposure (X1) and a film hardness before exposure (X2) in the recording layer is required to be 1.1 or higher, preferably 1.2 or higher for further improving the printing durability.

In a negative working image recording material, there may be applied a post-heating process (burning process) in order to further increase the strength of a formed image portion, but the film hardness after the exposure, in the invention, means a film hardness in a state after the exposure but not subjected to the post-heating process.

In the invention, the film hardness can be measured by methods known in the art. Specifically, it can be determined, for example, from a displacement curve that is prepared by applying pressures to an image recording layer by a pressing member having a triangular pyramidal end equipped with an ultra micro press-in hardness measuring apparatus, that is constituted by combining a microscope equipped with a piezo actuator and a transducer, and then by measuring displacements and loads for obtaining the displacement curve.

The film hardness (hereinafter represented as "H") is given by $H = L_{max}/A$, wherein $L_{max}$ is a maximum load and A indicates a contact cross section of the pressure member when such maximum load is recorded. The contact cross section A can be determined by calculation, based on an aspect ratio of the pressure member, from an inclination $h_{plastic}$ of a tangential line linearly approximating initial 30 % of a gradual loading curve. Based on such film hardness measuring method, a press-in depth ($h_{total}$) of the pressure member is regulated to obtain the film hardness of an upper part of the recording layer and of the entire recording layer. More specifically, there can utilized a method described in X. Yun, R. Hsiao, D. B. Bogy, C. S. Bhatia, *"Computer Mechanics Laboratory, Technical Report",* No. 96-015, 1(1996). In the invention, there was used a press-in apparatus (trade name: Triboscope, manufactured by Hysitron Inc.), which was mounted on an atomic force microscope (AFM) (trade name: SPA300, manufactured by Seiko Instruments Inc.).

A method for regulating the film hardness ratio of the recording layer at 1.1 or higher is not particularly restricted, but, in view of increasing the film hardness after the exposure, a control is possible for example by selecting, as the polymerizable compound, a compound having a satisfactory reactivity and capable of showing a strong interaction after the hardening. Surface contact angle

In an image recording material of the fourth embodiment of the invention, a ratio (Y1/Y2) of a surface contact angle after exposure (Y1) and a surface contact angle before exposure (Y2) in the recording layer is required to be 1.1 or higher, preferably 1.2 or higher for further improving the printing durability.

In the invention, the surface contact angle is obtained by dropping water onto a recording layer and measuring a contact angle of the water with a contact angle meter (trade name: CA-Z, manufactured by Kyowa Kaimen Kagaku Co.).

In a negative working image recording material, there may be applied a post-heating process (burning process) in order to further increase the strength of a formed image portion, but the surface contact angle after the exposure, in the invention, means a surface contact angle in a state after the exposure but not subjected to the post-heating process.

A method for controlling the surface contact angle ratio of the recording layer at 1.1 or higher is not particularly restricted. However, in view of increasing the surface contact angle after the exposure, there may be preferably used a method of adding a hydrophobic compound which can move to and can be localized in the vicinity of the surface of the recording layer by an exposure or by heating, or a method of adding, as a polymerizable compound, a compound having a satisfactory reactivity and capable of inducing a partial hardening thereby suppressing a diffusing movement of a hydrophilic component in the recording layer (for example a compound having an acryl group or a methacryl group).

The image recording layer of the image recording material of the invention includes an infrared absorbing agent (photothermal converting agent), a radical generating agent, a polymerizable compound, and, preferably for improving the film property, a general binder polymer other than the aforementioned polymerizable compound. These components will be explained below. Infrared Absorbing Agent (Photothermal converting agent)

A photothermal converting agent is used in the image recording material of the invention in order to execute a recording by a heat mode exposure by, representatively, a laser that emits an infrared ray. The photothermal converting agent has a function to absorb light of a specified wavelength and to convert it to heat. By thus generated heat, namely by a heat mode exposure with the light of a wavelength absorbable by the photothermal converting agent, the radical generating agent is decomposed to generate a radical. The photothermal converting agent to be used in the invention can be any substance capable of converting absorbed light into heat. Generally, a dye or a pigment having an absorption maximum at a wavelength of an infrared laser to be used for information writing, namely in a wavelength region of 760 to 1200 nm, which are known as an infrared absorbing agent, can be used.

As the dye, commercially available dyes and known those described for example in *"Senryo Binran* (Dye Handbook)" (edited by Organic Synthetic Chemical Society, 1970) can be used. Specific examples of such dye include azo dyes, metal complex azo dyes, pyrazolone azo dyes, naphthoquinone dyes, anthraquinone dyes, phthalocyanine dyes, carbonium dyes, quinonimine dyes, methine dyes, cyanine dyes, squalirium dyes, pyrilium dyes, and metal thiolate dyes.

Preferred dyes include, for example, cyanine dyes described in JP-A Nos. 58-125246, 59-84356, 59-202829 and 60-78787, methine dyes described in JP-A Nos. 58-173696, 58-181690 and 58-194595, naphthoquinone dyes described in JP-A Nos. 58-112793, 58-224793, 59-48187, 59-73996, 60-52940 and 60-63744, squalirium dyes described in JP-A No. 58-112792 and cyanine dyes described in BP No. 434,875.

There can also be advantageously used a near infrared absorption sensitizer described in USP No. 5,156,938, and there can be preferably used substituted arylbenzo(thio)pyrilium salts described in USP No. 3,881,924, trimethinethiapyrilium salts described in JP-A No. 57-142645 (USP No. 4,327,169), pyrilium compounds described in JP-A Nos. 58-181051, 58-220143, 59-41363, 59-84248, 59-84249, 59-146063 and 59-146061, cyanine dyes described in JP-A No. 59-216146, pentamethinethiopyrilium salts described in USP No. 4,283,475 and pyrilium compounds described in JP-B No. 5-13514 and 5-19702.

Also other preferred examples of the dye are near infrared absorbing dyes described in U.S.P. No. 4,756,993 by formulas (I) and (II).

Among these dyes, particularly preferred are cyanine dyes, squalirium dyes, pyrilium salts, and nickel thiolate complexes. Further, more preferred are cyanine dyes, and most preferred is a cyanine dye represented by a following general formula (a):

General formula (a)

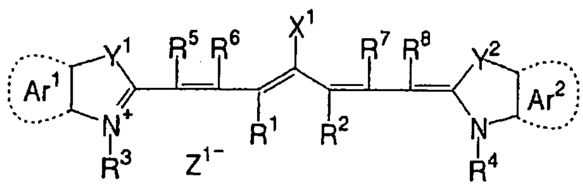

In the general formula (a), $X^1$ represents a hydrogen atom, a halogen atom, $-NPh_2$, $X^2$-$L^1$ or a following group; $X^2$ represents an oxygen atom, a nitrogen atom or a sulfur atom; $L^1$ represents a hydrocarbon group having from 1 to 12 carbon atoms, an aromatic ring having a hetero atom, or a hydrocarbon group having from 1 to 12 carbon atoms including a hetero group; a hetero atom indicates N, S, O, a halogen atom or Se; Xa has a definition same as Za to be explained later; and Ra represents a substituent group selected from a hydrogen atom, an alkyl group, an aryl group, a substituted or non-substituted amino group and a halogen atom:

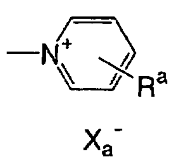

$R^1$ and $R^2$ each independently represents a hydrocarbon group having 1 to 12 carbon atoms. In consideration of stability in storage of the recording layer coating liquid, each of $R^1$ and $R^2$ is preferably a hydrocarbon group having from 2 or more carbon atoms, and more preferably $R^1$ and $R^2$ are mutually bonded to form a five-membered ring or a six-membered ring.

$Ar^1$ and $Ar^2$, which may be same or different, each represents an aromatic hydrocarbon group which may have substituent(s). Preferred examples of the aromatic hydrocarbon group include a benzene ring and a naphthalene ring. Also preferred examples of the substituent include a hydrocarbon group having 12 or less carbon atoms, a halogen atom, and an alkoxy group having 12 or less carbon atoms. $Y^1$ and $Y^2$, which may be same or different, each represents a sulfur atom or a dialkylmethylene group having 12 or less carbon atoms. $R^3$ and $R^4$, which may be same or different, each represents a hydrocarbon group having 20 or less carbon atoms, which may have substituent(s). Preferred examples of the substituent include an alkoxy group having 12 or less carbon atoms, a carboxyl group and a sulfo group.

$R^5$, $R^6$, $R^7$ and $R^8$, which may be same or different, each represents a hydrogen atom, or a hydrocarbon group having 12 or less carbon atoms. Hydrogen atom is preferred because of the availability of the raw material. Za represents a counter anion. However, Za is not required in case a cyanine dye represented by the general formula (a) has an anionic substituent in the structure does not require a charge neutralization. In consideration of the stability in storage of the recording layer coating liquid, Za is preferably a halogen ion, a perchlorate ion, a tetrafluoroborate ion, a hexafluorophosphate ion, or a sulfonate ion, and more preferably a perchlorate ion, a hexafluorophosphate ion or an arylsulfonate ion.

Specific examples of the cyanine dyes represented by the general formula (a) and advantageously employable in the invention are described in JP-A No. 2001-133969, paragraphs [0017] to [0019].

Other particularly preferred examples include specified indolenincyanine dyes described in the aforementioned Japanese Patent Applications Nos. 2001-6326 and 2001-237840.

Examples of the pigment employable in the invention include commercially available pigments and pigments described in Color Index (C. I.), *"Saishin Ganryo Binran* (Latest Pigment Handbook)" (Pigment Technology Society of Japan, 1977), *"Saishin Ganryo Ouyou Gijutsu* (Latest Pigment Application Technology)" (CMC Press, 1986), and *"Insatsu Ink Gijutsu* (Printing Ink Technology)" (CMC Press, 1984).

The type of the pigment can be a black pigment, an yellow pigment, an orange pigment, a brown pigment, a red pigment, a purple pigment, a blue pigment, a green pigment, a fluorescent pigment, a metal powder pigment, or a polymer bonded pigment. Specific examples include insoluble azo pigments, azo rake pigments, condensed azo pigments, chelate azo pigments, phthalocyanine pigments, anthraquinone pigments, perylene and perynone pigments, thioindigo pigments, quinachrydone pigments, dioxazine pigments, isoindolinone pigments, quinophthalone pigments, vat rake pigments, azine pigments, nitroso pigments, nitro pigments, natural pigments, fluorescent pigments, inorganic pigments and carbon black, among which preferred is carbon black.

These pigments may be used with or without a surface treatment. The surface treating method can be, for example, a method of surface coating with resin or wax, a method of depositing a surfactant, or a method of bonding a reactive substance (for example a silane coupling agent, an epoxy compound or polyisocyanate) to the pigment surface. These surface treating methods are described in "Kinzoku *Sekken no Seishitsu to Ouyou* (Properties and Applications of Metal Soaps)" (Saiwai Shobo), "Insatsu *Ink Gijutsu* (Printing Ink Technology)" (CMC Press, 1984) and *"Saishin Ganryo Ouyou Gijutsu* (Latest Pigment Application Technology)" (CMC Press, 1986).

The particle size of the pigment is preferably within a range of 0.01 to 10 μm, more preferably 0.05 to 1 μm and most preferably 0.1 to 1 μm. A particle size of the pigment less than 0.01 μm is undesirable in the stability of dispersion in the image recording layer coating liquid, and a particle size exceeding 10 μm is undesirable in the uniformity of the image recording layer.

In order to disperse the pigment, there can be used a known technology used in ink manufacture or toner manufacture. A dispersing machine can be an ultrasonic dispersing device, a sand mill, an attriter, a pearl mill, a super mill, a ball mill, an impeller, a disperser, a KD mill, a colloid mill, a dynatron, a three-roll mill or a pressurized kneader. Details are described in *"Saishin Ganryo Ouyou Gijutsu* (Latest Pigment Application Technology)" (CMC Press, 1986).

In case of applying the photosensitive composition of the present invention to a recording layer of a negative working planographic printing plate precursor, the photosensitive layer preferably has an optical density within a range of from 0.1 to 3.0 at the absorption maximum within the wavelength range of from 760 to 1200 nm. A value outside such range tends to result in a lowered sensitivity. As the optical density is determined by an amount of addition of the infrared absorbing agent and a thickness of the image recording layer, a desired optical density can be obtained by controlling both parameters. The optical density of the image recording layer can be measured by an ordinary method. The measurement can be achieved, for example, by forming, on a transparent or white substrate, an image recording layer of a thickness suitably determined within a range of a dry coating amount required for the planographic printing plate, and executing a measurement with a transmission optical densitometer, or forming an image recording layer on a reflective substrate such as of aluminum and measuring a reflective density.

Radical Ggenerating Agent

In the presentinvention, it is necessary to add a radical generating agent, which generates a radical by an exposure of a wavelength absorbable by the infrared absorbing agent (photothermal converting agent).

The radical generating agent to be used in the invention is a compound capable of generating radicals by an exposure at a wavelength absorbable by the photo thermal converting agent, initiating a polymerization reaction of the radical polymerizable compound, and accelerating the polymerization reaction, depending on a reaction mechanism of such compound.

The radical generating agent can preferably be, for example, (a) an aromatic ketone, (b) an onium salt, (c) an organic peroxide, (d) a thio compound, (e) a hexaarylbiimidazole compound, (f) a ketoxime ester, (g) a borate compound, (h) an azinium compound, (i) a metalocene compound, (j) an active ester compound, or (k) a compound

having a carbon-halogen bond. Specific examples of (a) to (k) are shown in the following, but the present invention is not limited by such examples.

(a) Aromatic ketones

For the aforementioned (a) aromatic ketones, there can be used compounds having a benzophenone skeleton or a thioxanthone skeleton, described in "Radiation Curing in Polymer Science and Technology", J. P. Fouassieur, J. F. Rabek (1993), pp.77-117. For example, there can be used following compounds:

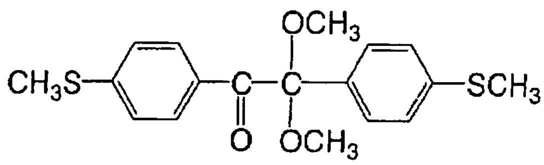

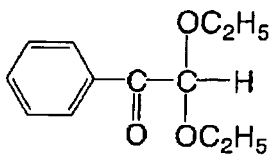

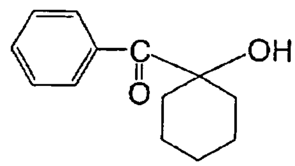

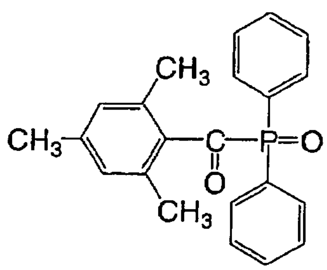

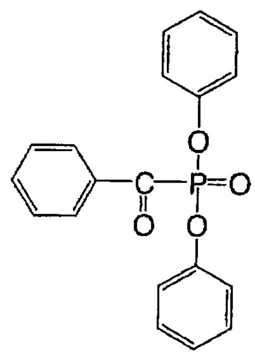

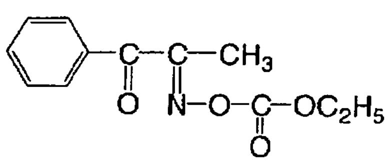

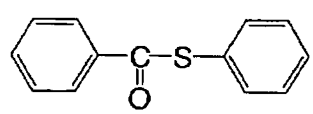

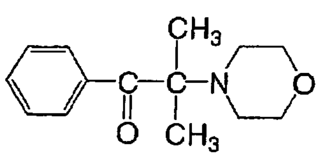

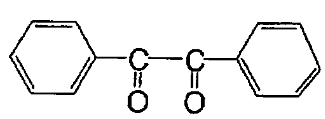

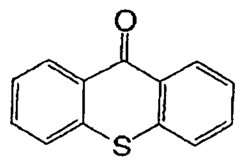

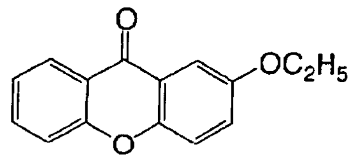

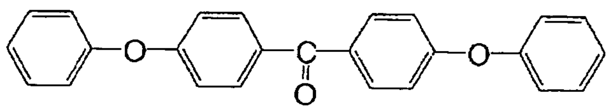

Particularly preferable examples of the (a) aromatic ketone include an α-thiobenzophenone compound described in JP-B No. 47-6416 and a benzoin ether compound described in JP-B No. 47-3981, such as a following compound:

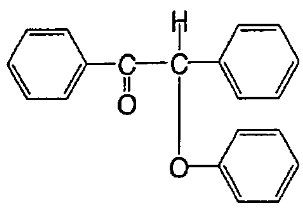

There can also be used an α-substituted benzoin compound described in JP-B No. 47-22326, such as a following compound:

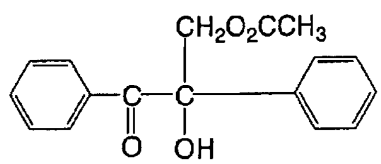

There can also be used a benzoin derivative described in JP-B No. 47-23664, an alloyl phosphonic acid ester described in JP-A No. 57-30704, or a dialkoxybenzophenone described in JP-B No. 60-26483, for example a following compound:

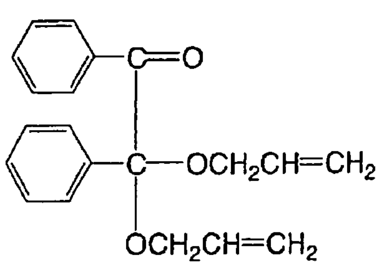

There can also be used a benzoin ether described in JP-B No. 60-26403 and JP-A No. 62-81345, for example

a following compound:

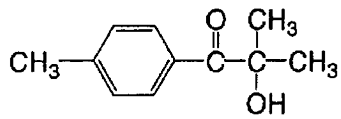

There can also be used an α-aminobenzophenone described in JP-B No. 1-34242, USP No. 4,318,791 and EP No. 0284561A1, for example following compounds:

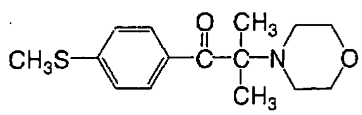

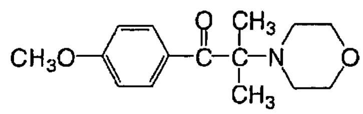

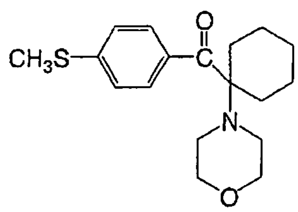

There can also, be used p-di(dimethylaminobenzoyl)benzene described in JP-A No. 2-211452, for example a following compound:

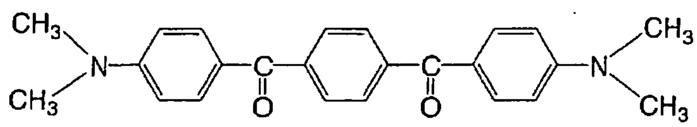

There can also be used a thio-substituted aromatic ketone described in JP-A No. 61-194062, for example a following compound:

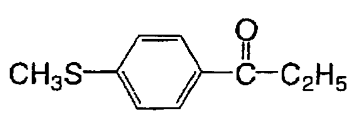

There can also be used an acylphosphine sulfide described in JP-B No. 2-9597, for example following compounds:

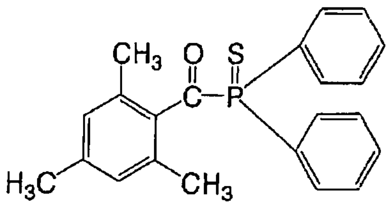

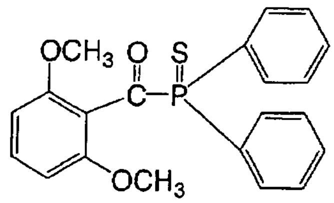

There can also be used an acyl phosphine described in JP-B No. 2-9596, for example a following compound:

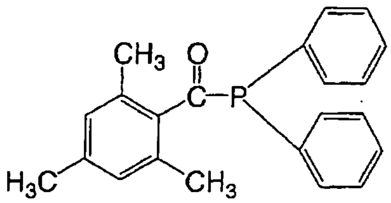

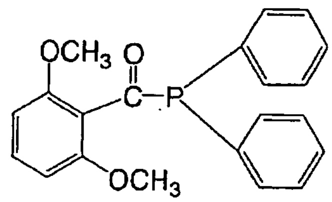

There can also be used a thioxanthone described in JP-B No. 63-61950 and a coumarin described in JP-B No. 59-42864.

(b) Onium salt compound

The aforementioned (b) onium salt compound can be compounds represented by followinggeneral formula (II) to (IV):

General formula (II)

$$Ar^1-I^+-Ar^2 \quad (Z^2)^-$$

General formula (III)

$$Ar^3-N^+\equiv N \quad (Z^3)^-$$

General formula (IV)

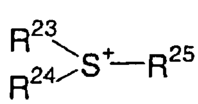

$(Z^4)^-$

In the formula (II), $Ar^1$ and $Ar^2$ each independently represents an aryl group having 20 or less carbon atoms

which may have a substitutent. In case the aryl group has a substituent, preferred examples of the substituent include a halogen atom, a nitro group, an alkyl group having 12 or less carbon atoms, an alkoxy group having 12 or less carbon atoms, and an aryloxy group having 12 or less carbon atoms. ($Z^2$) represents a counter ion selected from a group of a halogen ion, a perchlorate ion, a carboxylate ion, a tetrafluoroborate ion, a hexafluorophosphate ion, and a sulfonate ion, and is preferably a perchlorate ion, a hexafluorophosphate ion, or an arylsulfonate ion.

In the formula (III), $Ar^3$ represents an aryl group having 20 or less carbon atoms, which may have substituent (s). Preferred examples of the substituent include a halogen atom, a nitro group, an alkyl group having 12 or less carbon atoms, an alkoxy group having 12 or less carbon atoms, an aryloxy group having 12 or less carbon atoms, an alkylamino group having 12 or less carbon atoms, a dialkylamino group having 12 or less carbon atoms, an arylamino group having 12 or less carbon atoms, and a diarylamino group having 12 or less carbon atoms. ($Z^3$) represents a counter ion of a same definition as ($Z^2$) in the general formula (II).

In the formula (IV), $R^{23}$, $R^{24}$ and $R^{25}$, which may be same or different, each independently represents a hydrocarbon group having 20 or less carbon atoms, which may have substituent(s). Preferred examples of the substituent include a halogen atom, a nitro group, an alkyl group having 12 or less carbon atoms, an alkoxy group having 12 or less carbon atoms, and an aryloxy group having 12 or less carbon atoms. ($Z^4$) represents a counter ion of a same definition as ($Z^2$) in the general formula (II).

Specific examples of the onium salt advantageously employable in the invention are described in Japanese Patent Application 11-310623, paragraphs [0030] to [0033], and Japanese Patent Application No. 2000-160323, paragraphs [0015] to [0046].

The onium salt to be used in the invention preferably has a maximum absorption wavelength not exceeding 400 nm, more preferably not exceeding 360 nm. The absorption wavelength in such ultraviolet region allows to handle the planographic printing plate precursor under a white light. In the image forming material of the first and second embodiments of the invention, it is particularly preferred to employ an onium salt as the radical generating agent.

(c) Organic peroxide

The aforementioned (c) organic peroxide includes most of organic compounds containing at least an oxygen-oxygen bond in the molecule, of which examples include methyl ethyl ketone peroxide, cyclohexanone peroxide, 3,3,5-trimethylcyclohexanone peroxide, methylcyclohexanone peroxide, acetylacetone peroxide, 1,1-bis(tert-butylperoxy)-3,3,5-trimethylcyclohexanone, 1,1-bis(tert-butylperoxy)-cyclohexane, 2,2-bis(tert-butylperoxy)-butane, tert-butyl hydroperoxide, cumene hydroperoxide, diisopropylbenzene hydroperoxide, paramethane hydroperoxide, 2,5-dimethylhexane-2,5-dihydroperoxide, 1,1,3,3-tetramethylbutyl hydroperoxide, di-tert-butyl peroxide, tert-butylcumyl peroxide, dicumyl peroxide, bis(tert-butylperoxyisopropyl)benzene, 2,5-dimethyl-2,5-di(tert-butylperoxy)hexane, 2,5-xanoyl peroxide, succinoyl peroxide, benzoyl peroxide, 2,4-dichlorobenzoyl peroxide, meta-toluoyl peroxide, diisopropyl peroxydicarbonate, di-2-ethylhexyl peroxydicarbonate, di-2-ethoxyethyl peroxydicarbonate, dimethoxyisopropyl peroxycarbonate, di(3-methyl-3-methoxybutyl) peroxydicarbonate, tert-butyl peroxyacetate, tert-butyl peroxypivalate, tert-butyl peroxy neodecanoate, tert-butyl peroxyoctanoate, tert-butylperoxy-3,5,5-trimethylhexanoate, tert-butyl peroxylaurate, tert-carbonate, 3,3',4,4'-tetra-(t-butylperoxycarbonyl)benzophenone, 3,3',4,4'-tetra-(t-amylperoxycarbonyl)benzophenone, 3,3',4,4'-tetra-(t-hexylperoxycarbonyl)benzophenone, 3,3',4,4'-tetra-(t-octylperoxycarbonyl)benzophenone, 3,3',4,4'-tetra-(cumylperoxycarbonyl)benzophenone, 3,3',4,4'-tetra-(p-isopropylcumylperoxycarbonyl)benzophenone, carbonyldi(t-butylperoxy dihydrogen diphthalate) and carbonyldi(t-hexylperoxy dihydrogen diphthalate).

Among these, preferred is a peroxyester such as 3,3',4,4'-tetra-(t-butylperoxycarbonyl)benzophenone, 3,3',4,4'-tetra-(t-amylperoxycarbonyl)benzophenone, 3,3',4,4'-tetra-(t-hexylperoxycarbonyl)benzophenone, 3,3',4,4'-tetra-(t-octylperoxycarbonyl)benzophenone, 3,3',4,4'-tetra-(cumylperoxycarbonyl)benzophenone, 3,3',4,4'-tetra-(p-isopropylcumylperoxycarbonyl) benzophenone, or di-t-butyldiperoxy isophthalate.

(d) Thio compound

For the aforementioned (d) thio compound, there can be used a compound of a structure indicated by a following general formula (V):

General formula (V)

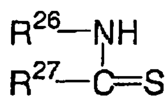

or

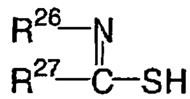

In the general formula (V), $R^{26}$ represents an alkyl group, an aryl group or a substituted aryl group; and $R^{27}$ represents a hydrogen atom or an alkyl group. $R^{26}$ and $R^{27}$ may represent non-metal atomic groups which are required for being mutually bonded to form a 5- to 7-membered ring, which may contain a hetero atom selected from an oxygen atom, a sulfur atom and a nitrogen atom.

In the foregoing general formula (V), an alkyl group preferably has 1 to 4 carbon atoms. Also an aryl group preferably has 6 to 10 carbon atoms, such as phenyl or naphthyl, and a substituted aryl group can be an aforementioned aryl group substituted with a halogen atom such as chlorine atom, an alkyl group such as methyl group, or an alkoxy group such as methoxy group or ethoxy group. $R^{27}$ represents an alkyl group preferably with 1 to 4 carbon atoms. Specific examples of the thio compound represented by the general formula (V) include Nos. 1 to 32 shown in the following.

| No. | $R^{26}$ | $R^{27}$ |
|---|---|---|
| 1 | $-H$ | $-H$ |
| 2 | $-H$ | $-CH_3$ |
| 3 | $-CH_3$ | $-H$ |
| 4 | $-CH_3$ | $-CH_3$ |
| 5 | $-C_6H_5$ | $-C_2H_5$ |
| 6 | $-C_6H_5$ | $-C_4H_9$ |
| 7 | $-C_6H_4Cl$ | $-CH_3$ |
| 8 | $-C_6H_4Cl$ | $-C_4H_9$ |
| 9 | $-C_6H_4-CH_3$ | $-C_4H_9$ |
| 10 | $-C_6H_4-OCH_3$ | $-CH_3$ |
| 11 | $-C_6H_4-OCH_3$ | $-C_2H_5$ |
| 12 | $-C_6H_4-OC_2H_5$ | $-CH_3$ |
| 13 | $-C_6H_4-OC_2H_5$ | $-C_2H_5$ |
| 14 | $-C_6H_4-OCH_3$ | $-C_4H_9$ |
| 15 | $-(CH_2)_2-$ | |
| 16 | $-(CH_2)_2-S-$ | |
| 17 | $-CH(CH_3)-CH_2-S-$ | |
| 18 | $-CH_2-CH(CH_3)-S-$ | |
| 19 | $-C(CH_3)_2-CH_2-S-$ | |
| 20 | $-CH_2-C(CH_3)_2-S-$ | |
| 21 | $-(CH_2)_2-O-$ | |
| 22 | $-CH(CH_3)-CH_2-O-$ | |
| 23 | $-C(CH_3)_2-CH_2-O-$ | |
| 24 | $-CH=CH-N(CH_3)-$ | |
| 25 | $-(CH_2)_3-S-$ | |
| 26 | $-(CH_2)_2-CH(CH_3)-S-$ | |
| 27 | $-(CH_2)_3-O-$ | |
| 28 | $-(CH_2)_5-$ | |
| 29 | $-C_6H_4-O-$ | |
| 30 | $-N=C(SCH_3)-S-$ | |
| 31 | $-C_6H_4-NH-$ | |
| 32 | 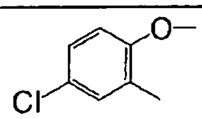 | |

(e) Hexaarylbiimidazole compound

For the aforementioned hexaarylbiimidazole compound, there can be used lophine dimers described in JP-B Nos. 45-37377 and 44-86516, for example 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o, p-dichloropheynyl)-4,4',5,5'-tetraphenylbiimidazole, 2,2'-bis(o-chlorophenyl)-4,4',5,5'-tetra(m-methoxyphenyl)-biimidazole, 2,2'-bis(o,o'-dichloropheynyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole, or 2,2'-bis(o-trifluorophenyl)-4,4',5,5'-tetraphenylbiimidazole.

(f) Ketoxime ester compound

For the aforementioned (f) ketoxime ester compound, there can be used, for example, 3-benzoyloxyiminobutan-2-one, 3-acetoxyiminobutan-2-one, 3-propionyloxyiminobutan-2-one, 2-acetoxyiminopentan-3-one, 2-acetoxyimino-1-phenylpropan-1-one, 2-benzoyloxyimino-1-phenylpropan-1-one, 3-p-toluenesulfonyloxyiminobutan-2-one, or 2-ethoxycarbonyloxylimino-1-phenylpropan-1-one.

(g) Borate compound

For the aforementioned (g) borate compound, there can be used a compound represented by a following general formuola (VI):

General formula (VI)

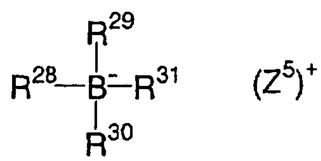

In the general formula (VI), $R^{28}$, $R^{29}$, $R^{30}$ and $R^{31}$, which may be mutually same or different, each independently represents a substituted or non-substituted alkyl group, a substituted or non-substituted aryl group, a substituted or non-substituted alkenyl group, a substituted or non-substituted alkinyl group, or a substituted or non-substituted heterocyclic group, and two or more of $R^{28}$, $R^{29}$, $R^{30}$ and $R^{31}$ may be combined to form a cyclic structure. However, at least one of $R^{28}$, $R^{29}$, $R^{30}$ and $R^{31}$ is a substituted or non-substituted alkyl group. $(Z^5)^+$ represents an alkali metal cation or a quaternary ammonium cation.

An alkyl group in from $R^{28}$ to $R^{31}$ includes linear, ramified and cyclic ones, and preferably has from 1 to 18 carbon atoms. Specific examples include methyl, ethyl, propyl, isopropyl, butyl, pentyl, hexyl, octyl, stearyl, cyclobutyl, cyclopentyl and cyclohexyl. Also a substituted alkyl group includes the aforementioned alkyl group which is provided, as a substituent, with a halogen atom (such as -Cl or -Br), a cyano group, a nitro group, an aryl group(preferably a phenyl group), a hydroxyl group, - $COOR^{32}$ (wherein $R^{32}$ represents a hydrogen atom, an alkyl group having from 1 to 14 carbon atoms or an aryl group), - $OCOR^{33}$ or $-OR^{34}$ (wherein each of $R^{33}$ and $R^{34}$ represents an alkyl group having from 1 to 14 carbon atoms or an aryl group), or a group represented by a following formula:

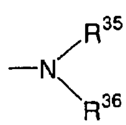

wherein $R^{35}$ and $R^{36}$ each independently represents a hydrogen atom, an alkyl group having from 1 to 14 carbon atoms, or an aryl group.

In $R^{28}$ to $R^{31}$, the aryl group includes an aryl group having from 1 to 3 rings such as a phenyl group or a naphthyl group, and the substituted aryl group includes an above-mentioned aryl group having a substituent of the aforementioned substituted alkyl group or an alkyl group having from 1 to 14 carbon atoms. Also the alkenyl group in $R^{28}$ to $R^{31}$ includes a linear, ramified or cyclic group having from 2 to 18 carbon atoms, and the substituent of the substituted alkenyl group includes a substituent cited for the aforementioned substituted alkyl group. The alkinyl group in $R^{28}$ to $R^{31}$ includes a linear or ramified group having from 2 to 28 carbon atoms, and the substituent of the substituted alkinyl group includes a substituent cited for the aforementioned substituted alkyl group. The heterocyclic group in $R^{28}$ to $R^{31}$ may include a group of 5 or more members, preferably 5 to 7 members, including at least either of N, S and O, and such heterocyclic group may include a condensed ring. It may also contain a substituent, which is cited for the aforementioned substituted aryl group. Specific examples of the compound represented by the general formula (vi) include those described in USP Nos. 3,567,453 and 4,343,891, EP Nos. 109,772 and 109,773 and those shown in the

following.

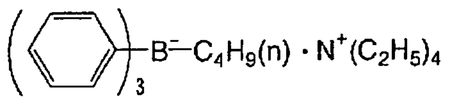

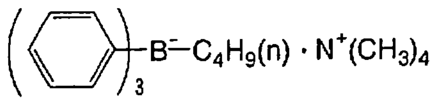

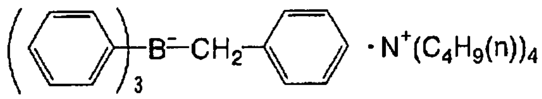

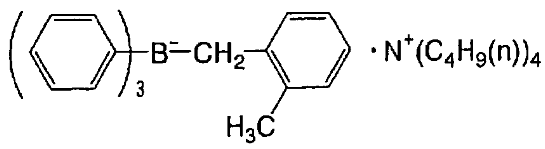

(h) Azinium compound

Examples of the (h) azinium compound include compounds having an N-0 bond, described in JP-A Nos. 63-138345, 63-142345, 63-142346 and 63-143537 and JP-B No. 46-42363.

(i) Metalocene compound

Examples of the (i) metalocene compound include titanocene compounds described in JP-A Nos. 59-152396, 61-151197, 63-41484, 2-249 and 2-4705, and iron-arene complexes described in JP-A Nos. 1-304453 and 1-152109.

Specific examples of the titanocene compound include di-cyclopentadienyl-Ti-dichloride, di-cyclopentadienyl-Ti-bisphenyl, di-cyclopentadienyl-Ti-bis-2,3,4,5,6-pentafluorophen-1-yl, di-cyclopentadienyl-Ti-bis-2,3,5,6-tetrafluorophen-1-yl, di-cyclopentadienyl-Ti-bis-2,4,6-trifluorophen-1-yl, di-cyclopentadienyl-Ti-bis-2,6-difluorophen-1-yl, di-cyclopentadienyl-Ti-bis-2,4-difluorophen-1-yl, di-methylcyclopentadienyl-Ti-bis-2,3,4,5,6-pentafluorophen-1-yl, di-methylcyclopentadienyl-Ti-bis-2,3,5,6-tetrafluorophen-1-yl, di-methylcyclopentadienyl-Ti-bis-2,4-difluorophen-1-yl, bis(cyclopentadienyl)-bis(2,6-difluoro-3-(pyr-1-yl)phenyl) titanium bis(cyclopentadienyl)bis[2,6-difluoro-3-(methylsulfonamide)phenyl]titanium, bis(cyclopentadienyl)bis[2,6-difluoro-3-(N-butylpivaroylamino)phenyl]titanium, bis(cyclopentadienyl)bis [2,6-difluoro-3- (N-butyl-(4-chlorobenzoyl)amino)phenyl]titanium, bis(cyclopentadienyl)bis[2,6-difluoro-3-(N-benzyl-2,2-dimethylpentanoylamino)phenyl]titanium, bis(cyclopentadienyl)bis[2,6-difluoro-3-(N-(2-ethylhexyl)-4-tolyl-sulfonyl)amino]phenyl]titanium, bis(cyclopentadienyl)bis[2,6-difluoro-3-(N-(3-oxaheptyl)-benzoylamino)phenyl]titanium, bis(cyclopentadienyl)bis[2,6-difluoro-3-(N-(3,6-dioxadecyl)-benzoylamino)phenyl]titanium, bis(cyclopentadienyl)bis[2,6-difluoro-3-(trifluoromethylsulfonylamino)phenyl]titanium, bis(cyclopentadienyl)bis[2,6-difluoro-3-(trifluoroacetyl)amino]phenyl]titanium, bis(cyclopentadienyl)bis[2,6-difluoro-3-(2-chlorobenzoyl)amino)phenyl]titanium, bis(cyclopentadienyl)bis[2,6-difluoro-3-(4-chlorobenzoyl)amino]phenyl]titanium, bis(cyclopentadienyl)bis[2,6-difluoro-3-(N-(3,6-dioxadecyl)-2,2-dimethylpentanoylamino)phenyl]titanium, bis(cyclopentadienyl)bis[2,6-difluoro-3-(N-(3,7-dimethyl-7-methoxyoctyl)benzoylamino)phenyl]titanium, and bis(cyclopentadienyl)bis[2,6-difluoro-3-(N-cyclohexylbenzoylamino)phenyl]titanium.

(j) Active ester compound

For the aforementioned (j) active ester compound, there can be used an imide sulfonate compound described in JP-B No. 62-6223, or an active sulfonate described in JP-B No. 63-14340 and JP-A No. 59-174831.

(k) Compound containing carbon-halogen bond

For the aforementioned (k) compound having a carbon-halogen bond, there can be used compounds represented by following general formulas (VII) to (XIII).

General formula (VII)

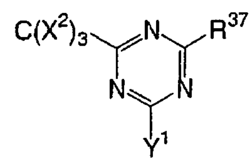

In the general formula (VII), $X^2$ represents a halogen atom; $Y^1$ represents $-C(X^2)_3$, $-NH_2$, $-NHR^{38}$, $-NR^{38}$ or $-OR^{38}$; $R^{38}$ represents an alkyl group, a substituted alkyl group, an aryl group or a substituted aryl group; and $R^{37}$ represents $-C(X^2)_3$, an alkyl group, a substituted alkyl group, an aryl group, a substituted aryl group, or a substituted alkenyl group.

General formula (VIII)

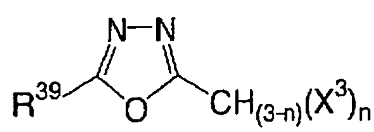

In the general formula (VIII), $R^{39}$ represents an alkyl group, a substituted alkyl group, an alkenyl group, a substituted alkenyl group, an aryl group, a substituted aryl group, a halogen atom, an alkoxy group, a substituted alkoxy group, a nitro group or a cyano group; $X^3$ represents a halogen atom; and n indicates an integer from 1 to 3.

General formula (IX)

$$R^{40}-Z^{5}-CH_{(2-m)}(X^{3})_{m}R^{41}$$

In the general formula (IX), $R^{40}$ represents an aryl group, or a substituted aryl group; $R^{41}$ is a group shown in the following or a halogen atom; and $Z^6$ is -C(=O)-, -C(=S)- or $-SO_2-$.

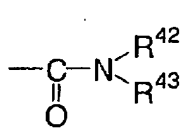 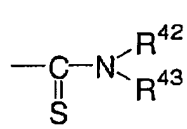 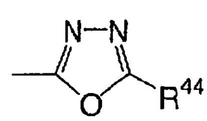

wherein each of $R^{42}$ and $R^{43}$ is an alkyl group, a substituted alkyl group, an alkenyl group, a substituted alkenyl group, an aryl group or a substituted aryl group; $R^{44}$ has a same meaning as $R^{38}$ in the general formula (VII); $X^3$ represents a halogen atom; and m is 1 or 2.

General formula (X)

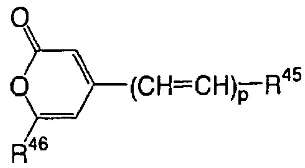

In the general formula (X), $R^{45}$ represents an aryl or heterocyclic group which may have substituent(s); $R^{46}$ represents a trihaloalkyl or trihaloalkenyl group having from 1 to 3 carbon atoms; and p indicates 1, 2 or 3.

General formula (XI)

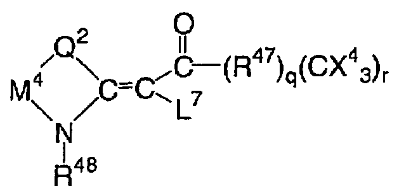

The general formula (XI) represents a carbonylmethylene heterocyclic compound having a trihalogenomethyl group, in which $L^7$ represents a hydrogen atom or a substituent group having a structure $CO\text{-}(R^{47})_q(C(X^4)_3)_r$; $Q^2$ represents a sulfur atom, a selenium atom, an oxygen atom, a dialkylmethylene group, an alken-1,2-ylene group, 1,2-phenylene group or an N-R group; $M^4$ is a substituted or non-substituted alkylene or alkenylene group, or a 1,2-arylene group; $R^{48}$ represents an alkyl group, aralkyl group or an alkoxyalkyl group; $R^{47}$ represents a divalent aromatic group of carbon ring type or heterocyclic type; $X^4$ represents a chlorine atom, a bromine atom or an iodine atom; and q = 0 and r = 1 or q = 1 and r = 1 or 2.

General formula (XII)

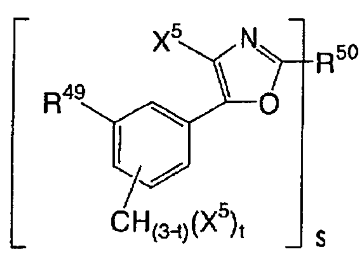

The general formula (XII) represents a 4-halogeno-5-(halogenomethyl-phenyl)-oxazole derivative, in which $X^5$ represents a halogen atom; t represents an integer from 1 to 3; s represents an integer from 1 to 4; $R^{49}$ represents a hydrogen atom or a $CH_{3-t}X^5{}_t$ group; and $R^{50}$ represents an unsaturated organic group having a valence number s, which may have substituent(s).

General formula (XIII)

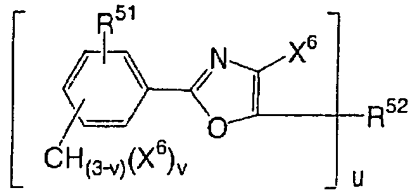

The general formula (XIII) represents a 2-(halogenomethyl-phenyl)-4-halogeno-oxazole derivative, in which $X^6$ represents a halogen atom; v represents an integer from 1 to 3; u represents an integer from 1 to 4; $R^{51}$ represents a hydrogen atom or a $CH_{3-v}X^6{}_v$ group; and $R^{52}$ represents an unsaturated organic group having a valence number u, which may have substituent(s).

Specific examples of such compound having a carbon-halogen bond include, for example, compounds described in Wakabayashi et al., Bull. Chem. Soc. Japan, 42, 2924(1969), such as 2-phenyl-4,6-bis(trichloromethyl)-S-triazine, 2- (p-chlorophenyl)-4,6-bis(trichloromethyl)-S-triazine, 2-(p-tollyl)-4,6-bis(trichloromethyl)-S-triazine, 2-(p-methoxyphenyl)-4,6-bis(trichloromethyl)-S-triazine, 2-(2',4'-dichlorophenyl)-4,6-bis(trichloromethyl)-S-triazine, 2,4,6-tris(trichloromethyl)-S-triazine, 2-methyl-4,6-bis(trichloromethyl)-S-triazine, 2-n-nonyl-4,6-bis(trichloromethyl)-S-triazine, and 2- (α,α, βtrichloroethyl)-4,6-bis(trichloromethyl)-S-triazine. There are also included compounds described in BP No. 1388492, such as 2-styryl-4,6-bis(trichloromethyl)-S-triazine, 2-(p-methylstyryl)-4,6-bis(trichloromethyl)-S-triazine, and 2-(p-methylstyryl)-4-amino-6-trichloromethyl-S-triazine, compounds described in JP-A No. 53-133428 such as 2-(4-methoxy-naphtho-1-yl)-4,6-bis-trichloromethyl-S-triazine, 2- (4-ethoxy-naphtho-1-yl)-4,6-bis-trichloromethyl-S-triazine, 2-[4-(2-ethoxyethyl)-naphtho-1-yl]-4,6-bis-trichloromethyl-S-triazine, 2-(4,7-dimethoxy-naphtho-1-yl)-4,6-bis-trichloromethyl-S-triazine, and 2-(acenaphtho-5-yl)-4,6-bis-trichloromethyl-S-triazine, and those described in GP No. 3337024 such as following compounds:

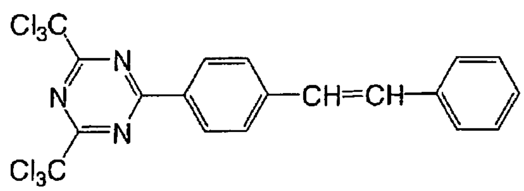

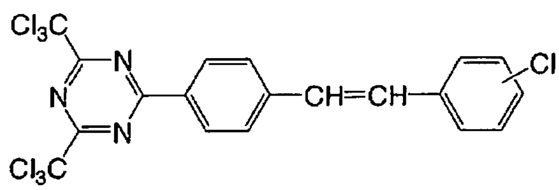

Also there can be included compounds described in F. C. Schaefer et al., J. Org. Chem, 29, 1527(1964), such as 2-methyl-4,6-bis(tribromomethyl)-S-triazine, 2,4,6-tris(tribromomethyl)-S-triazine, 2,4,6-tris(dibromomethyl)-S-triazine, 2-amino-4-methyl-6-tribromomethyl-S-triazine, and 2-methoxy-4-methyl-6-trichloromethyl-S-triazine. Also there can be included compounds described in JP-A No. 62-58241, such as those shown in the following:

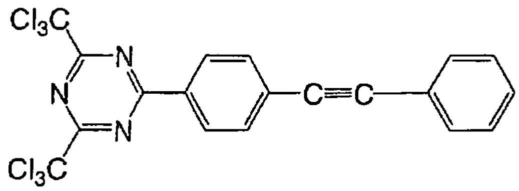

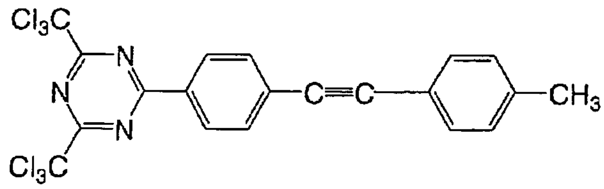

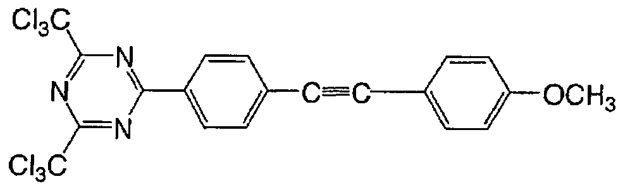

Furthermore, there can be included compounds described in JP-A No. 5-281728, such as those shown in the following:

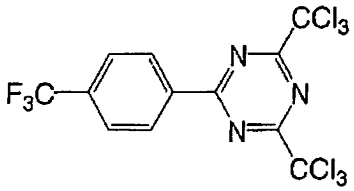

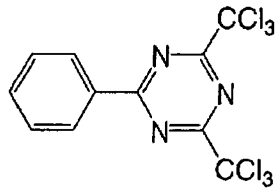

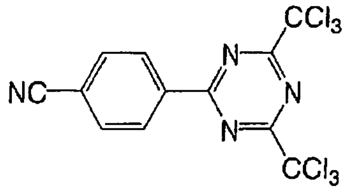

Furthermore, there may be included compounds which can be easily synthesized by those skilled in the art according to a method described by M. P. Hutt, E. F. Elsinger and L. M. Herbel, *"Journal of Heterocyclic Chemistry",* vol.7 (No.3), p.511- (1970), such as those shown in the following:

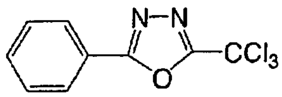

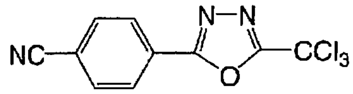

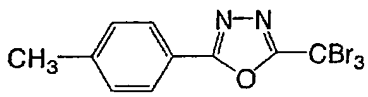

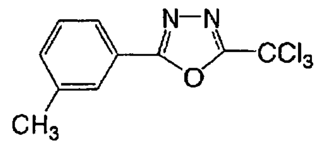

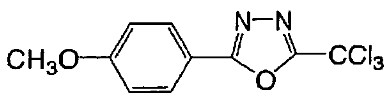

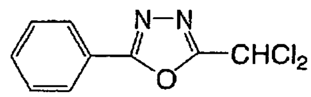

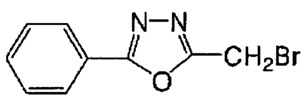

More preferred examples of the radical generating agent to be used in the invention include (a) an aromatic ketone, (b) an onium salt compound, (c) an organic peroxide, (e) a hexaarylbiimidazole compound, (i) a metalocene compound, and (k) a compound having a carbon-halogen bond. Further preferred examples include a diazonium salt, an iodonium salt, a sulfonium salt, an ammonium salt and pyridinium salt which belong to (b) onium salt compound, because of a high sensitivity, and among these, an iodonium salt, a diazonium salt and a sulfonium are most preferably used.

In the image recording material of the invention, the radical generating agent, also in case of being used in a recording layer of the image recording material, is preferably used in an amount within a range of 0.1 to 50 % by weight with respect to the total solids, preferably 0.5 to 30 % by weight and more preferably 5 to 20 % by weight. An amount of addition less than 0.1 % by weight results in a lowered sensitivity, while an amount of addition exceeding 50 % by weight results in a smear in a non-image portion at a printing operation.

These radical generating agents may be advantageously used singly or in a combination of two or more kinds. Also the radical generating agents may be added to a same layer including other components, or to another layer provided separately. Polymerizable Compound

The polymerizable compound to be used in the invention is a radical polymnerizable compound having at least an ethylenic unsaturated double bond, and is selected from compounds including at least one, preferably two or more, terminal ethylenic unsaturated bonds. Such compounds are widely known in the related industrial field, and may be used in the invention without any particular limitation. Such compounds have a chemical structure of a monomer, a prepolymer namely a dimer, a trimer or an oligomer, or a mixture thereof or a copolymer thereof. Examples of the monomer and the copolymer thereof include an unsaturated carboxylic acid (such as acrylic acid, methacrylic acid, itaconic acid, crotonic acid, isocrotonic acid or maleic acid), an ester thereof and an amide thereof, and there is preferably used an ester of an unsaturated carboxylic acid and an aliphatic polyhydric alcohol, or an amide of an unsaturated carboxylic acid and an aliphatic polyvalent amine. Also there can be advantageously used an unsaturated carboxylic acid ester having a nucleophilic substituent such as a hydroxyl group, an amino group or a mercapto group, an addition product of an amide with a monofunctional or polyfunctional isocyanate or with an epoxy compound, or a dehydration condensation product with a monofunctional or polyfunctional carboxylic acid. Also there can be advantageously used an unsaturated carboxylic acid ester having an electrophilic substituent such as an isocyanate group or an epoxy group, an addition product of an amide and a monohydric or polyhydric alcohol, an amine or a thiol, or a substitution reaction product of an unsaturated carboxylic acid ester or an amide having a cleavable substituent such as a halogen group or an tosyloxy group having a monohydric or polyhydric alcohol, an amine or a thiol. As other examples, there can also

be used compounds in which the above-mentioned unsaturated carboxylic acid is replaced by an unsaturated phosphonic acid or styrene.

Among the radical polymerizable compound constituted by an ester of an aliphatic polyhydric alcohol and an unsaturated carboxylic acid, specific examples of an acrylic acid ester, a methacrylic acid ester, an itaconic acid ester, a crotonic acid ester, an isocrotonic acid ester and a maleic acid ester are described in paragraphs [0037] to [0042] of JP-A No. 2001-133969, and these compounds are also applicable in the invention.

Other examples of the ester include aliphatic alcohol esters described in JP-B Nos. 46-27926 and 51-47334 and JP-A No. 57-196231, those having an aromatic skeleton described in JP-A Nos. 59-5240, 59-5241 and 2-226149, and those having an amino group described in JP-A No. 1-165613.

Specific examples of the monomer constituted by an amide of an aliphatic polyvalent amine and an unsaturated carboxylic acid further include methylenebis-acrylamide, methylenebis-methacrylamide, 1,6-hexamethylenebis-acrylamide, 1,6-hexamethylenebis-methacrylamide, diethylenetriamine trisacrylamide, xylilenebisacrylamide and xylilenebismethacrylamide.

Examples of another preferred amide monomer include those having a cyclohexylene structure described in JP-B No. 54-21726.

An urethane addition polymerizable compound which is prepared by an addition reaction of an isocyanate and a hydroxyl group is also preferable. Specific examples of such compound include a vinylurethane compound having two or more polymerizable vinyl groups in a molecule, and prepared by adding a vinyl monomer having a hydroxyl group and represented by a following general formula to a polyisocyanate compound having two or more isocyanate groups in a molecule, as described in JP-B No. 48-41708:

$$CH_2=C(R^{41})COOCH_2CH(R^{42})OH$$

wherein $R^{41}$and $R^{42}$ each represents H or $CH_3$.

Furthermore, there can be advantageous used an urethane acrylate described in JP-A No. 51-37193, JP-B Nos. 2-32293 and 2-16765, and an urethane compound having an ethylene oxide structure described in JP-B Nos. 58-49860, 56-17654, 62-39417 and 62-39418.

Furthermore, there may also be used a radical polymerizable compound having an amino structure or a sulfide structure in a molecule, as described in JP-A Nos. 63-277653, 63-260909 and 1-105238.

Still other examples include a polyfunctional acrylate or methacrylate such as a polyester acrylate or an epoxy acrylate formed by reacting an epoxy resin and (meth)acrylic acid as described in JP-A No. 48-64183, JP-B Nos. 49-43191 and 52-30490. Still other examples include a specified unsaturated compound as described in JP-B Nos. 46-43946, 1-40337 and 1-40336, and a vinylphosphonic acid compound described in JP-A No. 2-25493. Also in certain cases, there is advantageously used a structure including a perfluoroalkyl group described in JP-A No. 61-22048. Also there can be used photocurable monomers and oligomers introduced in *"Nippon Secchaku Kyokai-Shi"* (Bulletin of Japanese Adhesive Society), vol. 20, No. 7, pp300-308 (1984).

Among these polymerizable compounds (A), a compound having four or more aromatic rings within a molecule can be advantageously used in view of providing a strong interaction derived from aromatic nuclei. Specific examples include following compounds (D-1 to D-10).

D-1

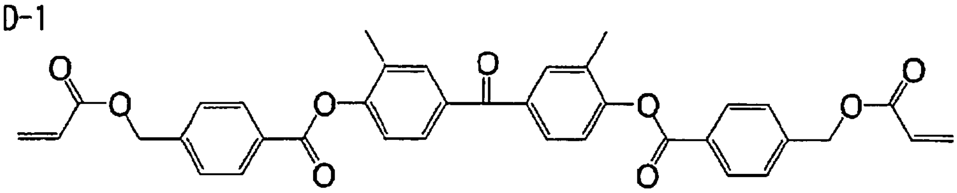

D-2

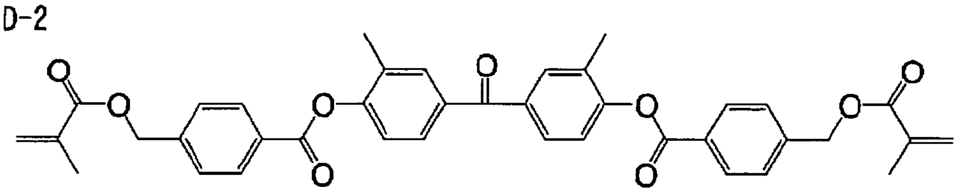

D-3

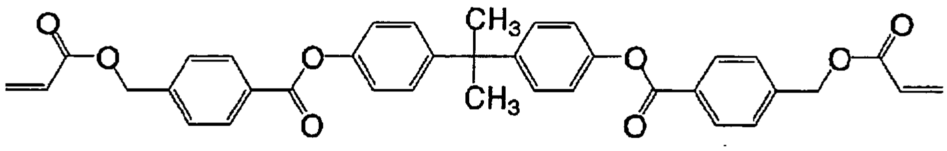

D-4

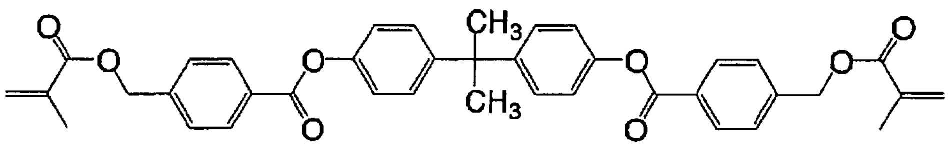

D-5

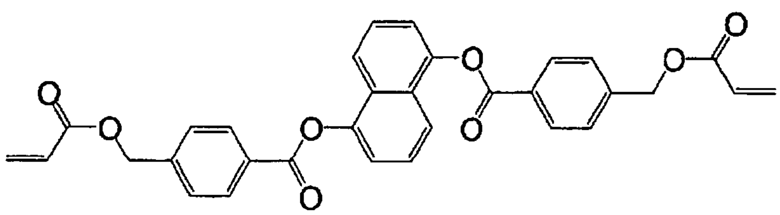

D-6

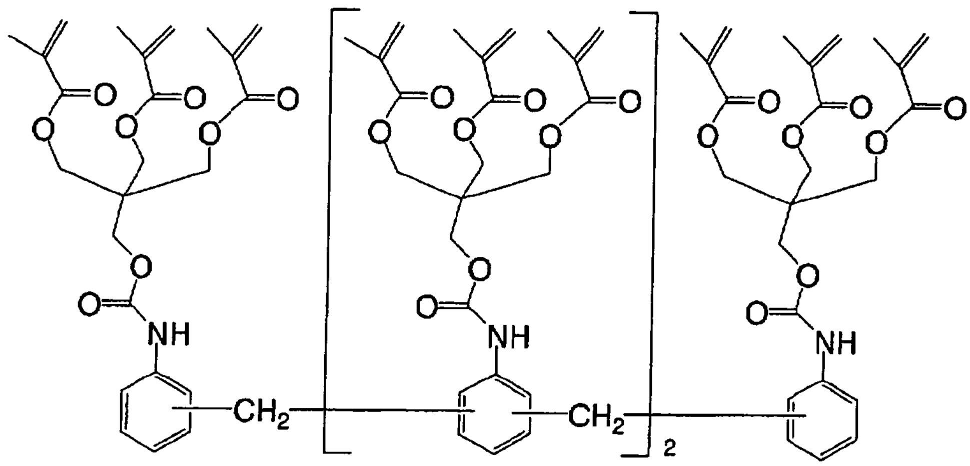

D-7

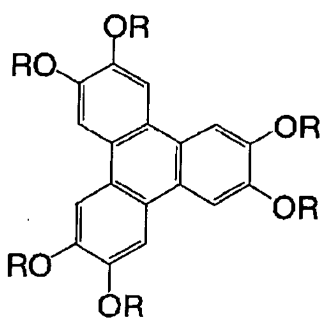

R :

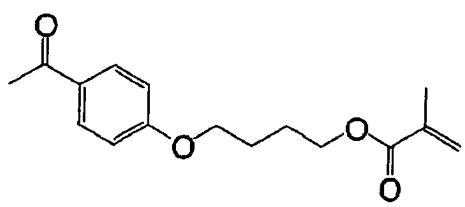

D-8

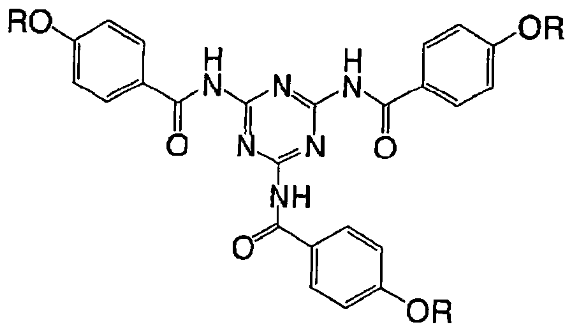

R :

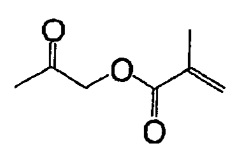

D-9

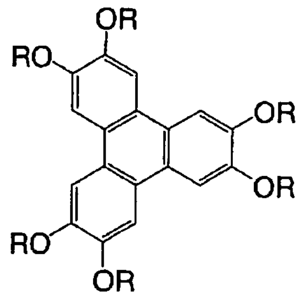

R :

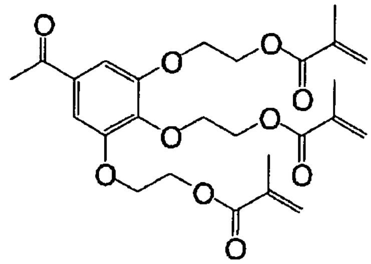

D-10

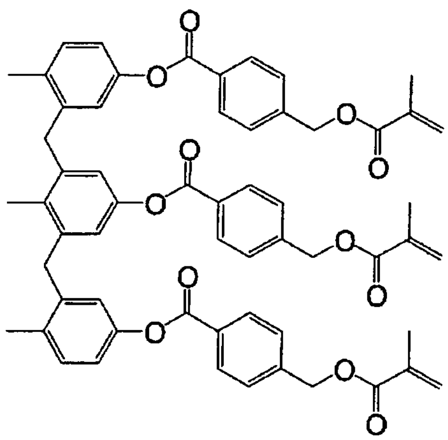

As the polymerizable compound in the invention, a polymer compound having a polymerizable group in a side chain and insoluble in water but soluble in an alkaline aqueous solution may be also used. As such polymer compound, a polymer compound having at least one of groups represented by following general formulas (i) - (iii) and insoluble in water but soluble in an alkaline aqueous solution (hereinafter suitably called "specified alkali soluble resin") are preferably used.

General formula (i)

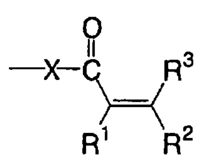

General formula (ii)

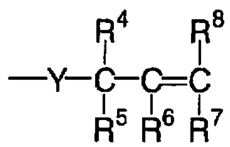

General formula (iii)

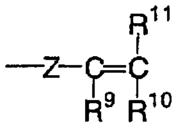

In the general formulas (i) to (iii), $R^1$ to $R^{11}$ each independently represents a monovalent organic group; X and Y each independently represents an oxygen atom, a sulfur atom, or -N-$R^{12}$; Z represents an oxygen atom, a sulfur atom, - N-$R^{12}$ or a phenylene group; and $R^{12}$ represents a hydrogen atom or a monovalent organic group.

In the following there will be given a detailed explanation on the groups represented by the general formulas (i) to (iii).

In the general formula (i) , $R^1$ to $R^3$ each independently represents a monovalent organic group, and $R^1$ can be for example a hydrogen atom or an alkyl group which may have substituent(s), and preferably a hydrogen atom, a methyl group, a methylalkoxy group, or a methylester group. Also $R^2$ and $R^3$ each independently represents a hydrogen atom, a halogen atom, an amino group, a dialkylamino group, a carboxyl group, an alkoxycarbonyl group, a sulfo group, a nitro group, a cyano group, an alkyl group which may have substituent(s), an aryl group which may have substituent (s), an alkoxy group which may have substituent(s), an aryloxy group which may have substituent(s), an alkylamino group which may have substituent(s), an arylamino group which may have substituent(s), an alkylsulfonyl group which may have substituent(s), or an arylsulfonyl group which may have substituent(s), among which preferred is a hydrogen atom, a carboxyl group, an alkoxycarbonyl group, an alkyl group which may have substituent(s) or an aryl group which may have substituent(s).

The substituent that can be introduced can be a methoxycarbonyl group, an ethoxycarbonyl group, an isopropioxycarbonyl group, a methyl group, an ethyl group, a phenyl group etc.

X represents an oxygen atom, a sulfur atom or -N-$R^{12}$, wherein $R^{12}$ can be an alkyl group which may have substituent(s).

In the general formula (ii), $R^4$ to $R^8$ each independently represents a monovalent organic group, and each of $R^4$ to $R^8$ can be for example a hydrogen atom, a halogen atom, an amino group, a dialkylamino group, a carboxyl group, an alkoxycarbonyl group, a sulfo group, a nitro group, a cyano group, an alkyl group which may have substituent (s), an aryl group which may have substituent(s), an alkoxy group which may have substituent(s), an aryloxy group which may have substituent(s), an alkylamino group which may have substituent(s), an arylamino group which may have substituent(s), an alkylsulfonyl group which may have substituent(s), or an arylsulfonyl group which may have substituent(s), among which preferred is a hydrogen atom, a carboxyl group, an alkoxycarbonyl group, an alkyl group which may have substituent(s) or an aryl group which may have substituent(s). The substituent that can be introduced can be those shown for the general formula (i). Y represents an oxygen atom, a sulfur atom or -N-$R^{12}$, wherein $R^{12}$ can be similar to that in the general formula (i) .

In the general formula (iii), $R^9$ to $R^{11}$ each independently represents a monovalent organic group, which can be for example a hydrogen atom, a halogen atom, an amino group, a dialkylamino group, a carboxyl group, an alkoxycarbonyl group, a sulfo group, a nitro group, a cyano group, an alkyl group which may have substituent(s), an aryl group which may have substituent(s), an alkoxy group which may have substituent(s), an aryloxy group which may have substituent(s), an alkylamino group which may have substituent(s), an arylamino group which may have substituent(s), an alkylsulfonyl group which may have substituent(s), or an arylsulfonyl group which may have substituent(s), among which preferred is a hydrogen atom, a carboxyl group, an alkoxycarbonyl group, an alkyl group which may have substituent(s) or an aryl group which may have substituent(s).

The substituent that can be introduced is those shown for the general formula (i).

Z represents an oxygen atom, a sulfur atom or -N-$R^{12}$, or a phenylene group, wherein $R^{12}$ can be similar to that in the general formula (i).

Among the specified alkali soluble resins, the compound having the group represented by the general formula (i) can be produced by at least one of following synthesizing methods 1) and 2).

Synthesizing method 1)

A method of polymerizing one or more of radical polymerizable compounds represented by a following general formula (12) to obtain a polymer compound, and extracting proton and cleaving Z with base to obtain a desired polymer compound:

General formula (12)

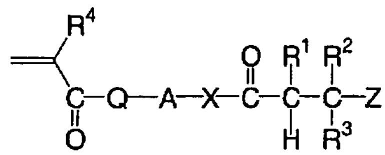

In the general formula (12), Z represents an anionic cleavable group; Q represents an oxygen atom, -NH- or - $NR^{14}$- (wherein $R^{14}$ represents an alkyl group which may have substituent(s)); $R^{13}$ represents a hydrogen atom or an alkyl group which may have substituent(s), among which preferred is a hydrogen atom, a methyl group, a methylalkoxy group or a methyl ester group; and A represents a divalent organic connecting group.

Synthesizing method 2)

A method of polymerizing one or more kinds of a radical polymerizable compound having a functional group to obtain a base polymer compound (a polymer compound constituting a main chain), and then reacting a functional group in a side chain of the base polymer compound with a compound of a structure represented by a following general formula (13) thereby obtaining a desired polymer compound.

General formula (13)

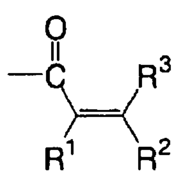

Examples of the radical polymerizable compound represented by the general formula (12) include following compounds (M-1) to (M-12), but such examples are not restrictive.

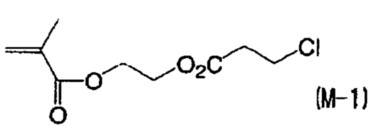
(M-1)

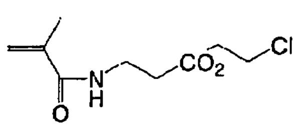
(M-7)

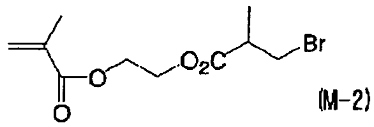
(M-2)

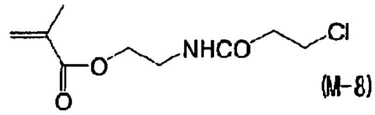
(M-8)

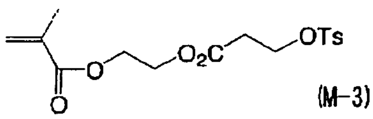
(M-3)

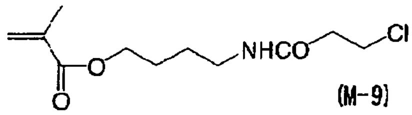
(M-9)

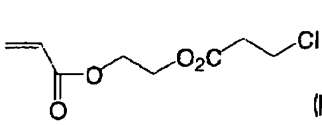
(M-4)

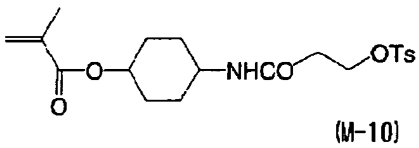
(M-10)

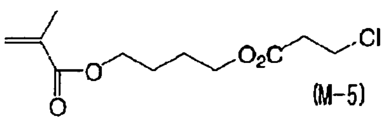
(M-5)

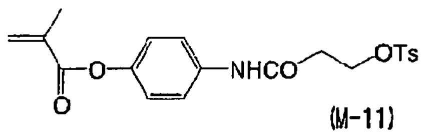
(M-11)

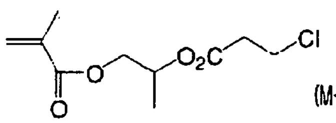
(M-6)

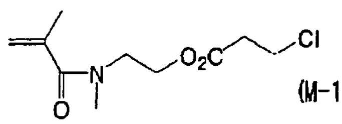
(M-12)

Such radical polymerizable compound represented by the general formula (12) is easily available as a commercial product or by a synthesizing method shown in following synthesis examples.

The group represented by the general formula (i) can be introduced by polymerizing one or more kinds of such radical polymerizable compound, with another radical polymerizable compound if necessary, by an ordinary polymerization method to obtain a polymer compound, and dropping and reacting a base of a desired amount into the polymer solution under cooling or heating, followed by neutralization with an acid if necessary. The polymer compound can be produced by generally known suspension polymerization or solution polymerization.

As the base, there may be used an inorganic compound or an organic compound. Examples of preferred inorganic base include sodium hydroxide, potassium hydroxide, sodium carbonate, sodium hydrogencarbonate, potassium carbonate, and potassium hydrogencarbonate, and examples of preferred organic base include a metal alkoxide such as sodium methoxide, sodium ethoxide, or potassium t-butoxide, and an organic amine compound such as triethylamine, pyridine, or diisopropylethylamine.

In the radical polymerizable compound having a functional group, to be used in the synthesis of the base polymer compound in the synthesizing method 2), examples of the functional group include a hydroxyl group, a carboxyl group, a carboxylic halide group, a carboxylic anhydride group, an amino group, a halogenated alkyl group, an isocyanate group, and an epoxy group. Examples of the radical polymerizable compound having such functional group include 2-hydroxyethyl acrylate, 2-hydroxyethyl methacrylate, 4-hydroxybutyl acrylate, 4-hydroxybutyl methacrylate, acrylic acid, methacrylic acid, acrylic chloride, methacrylic chloride, methacrylic anhydride, N,N-dimethyl-2-aminoethyl methacrylate, 2-chloroethyl methacrylate, ethyl 2-isocyate methacrylate, glycidyl acrylate and glycidyl methacrylate.

One or more kinds of such radical polymerizable compound is polymerized, or copolymerized with another radical polymerizable compound if necessary, to obtain the base polymer compound, and a compound having a group represented by the general formula (13) is reacted to obtain a desired polymer compound.

Examples of the compound having the group represented by the general formula (13) include aforementioned compounds cited as examples of the radical polymerizable compound having the functional group.
The specified alkali soluble resin having the group represented by the general formula (2) can be prepared by at least one of following synthesizing methods 3) and 4).

Synthesizing method 3)

A method of polymerizxing one or more kinds of a radical polymerizable compound having an unsaturated group represented by the general formula (2) and an ethylenic unsaturated group higher in an addition polymerizing property than such unsaturated group, and another radical polymerizable compound if necessary, to obtain a polymer compound. This method uses a compound having plural ethylenic unsaturated groups of different addition polymerizing properties within a molecule, such as allyl methacrylate.

Synthesizing method 4)

A method of polymerizing one or more kinds of a radical polymerizable compound having a functional group to obtain a polymer compound, and then reacting a functional group in a side chain with a compound of a structure represented by a following general formula (14) thereby introducing a group represented by the general formula (ii).

General formula (14)

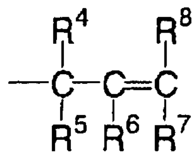

Examples of the radical polymerizable compound having the unsaturated group represented by the general formula (ii) and the ethylenic unsaturated group higher in the addition polymerizing property than the aforementioned unsaturated group include allyl acrylate, allyl methacrylate, 2-allyloxyethyl actylate, 2-allyloxyethyl methactylate, propargyl acrylate, propargyl methacrylate, N-allyl acrylate, N-allyl methacrylate, N,N-diallyl acrylate, N,N-diallyl methacrylate, allylacrylamide and allylmethacrylamide.
Examples of the polymer compound obtained by polymerizing one of mode kinds of the radical polymerizable compound having the functional group can be the examples shown in the foregoing synthesizing method 2).
Examples of the compound having the structure represented by the general formula (14) include allyl alcohol, allylamine, diallylamine, 2-allyloxyethyl alcohol, 2-chloro-1-butene and allylisocyanate.
The specified alkali soluble resin having the group represented by the general formula (iii) can be prepared by at least one of following synthesizing methods 5) and 6).

Synthesizing method 5)

A method of polymerizing one or more kinds of a radical polymerizable compound having an unsaturated group represented by the general formula (iii) and an ethylenic unsaturated group higher in an addition polymerizing property than such unsaturated group, and copolymerizing with another radical polymerizable compound if necessary, to obtain a polymer compound.

Synthesizing method 6)

A method of polymerizing one or more kinds of a radical polymerizable compound having a functional group to obtain a polymer compound, and then reacting a functional group in a side chain with a compound of a structure represented by a following general formula (15) thereby introducing a group represented by the general formula (15).

General formula (15)

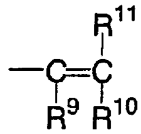

Examples of the radical polymerizable compound having the unsaturated group represented by the general formula (iii) and the ethylenic unsaturated group higher in the addition polymerizing property than the aforementioned unsaturated group include vinyl acrylate, vinyl methacrylate, 2-phenylvinyl actylate, 2-phenylvinyl methactylate, 1-propenyl acrylate, 1-propenyl methacrylate, vinylacrylamide and vinylmethacrylamide.
Examples of the polymer compound obtained by polymerizing one of mode kinds of the radical polymerizable compound having the functional group can be the examples shown in the foregoing synthesizing method 2).
Examples of the compound having the structure represented by the general formula (15) include 2-hydroxyethyl monovinyl ether, 4-hydroxybutyl monovinyl ether, diethylene glycol monovinyl ether and 4-chloromethylstyrene.
In the following there will be shown representative synthesis examples of the specified alkali soluble resin and specific examples of the polymer compound, but the present invention is not limited by such examples.

(1) Synthesis of compound (M-1)

In a 1000 mL three-necked flask, a 520 mL THF solution of 133 g of 2-hydroxyethyl methacrylate was prepared and was cooled to 0°C. Then 130 g of 3-chloropropionyl chloride were dropwise added from a dropping funnel over a period of 1 hour and under agitation, and the temperature was thereafter gradually raised to the room temperature. After agitation for 12 hours at the room temperature, the reaction mixture was poured into 1 L of iced water. After agitation for 1 hour, an extraction was made with 2 L of ethyl acetate in three portions, and an obtained organic layer was washed in succession with water, a saturated aqueous solution of sodium hydrogencarbonate and a saturated sodium chloride aqueous solution, and was dried over magnesium sulfate. After filtration, the solvent was distilled off under a reduced pressure with a rotary evaporator. Obtained residue was purified on a silica gel chromatography (eluting solvent: hexane/ethyl acetate) to obtain 180 g of a compound (M-1). The structure of the compound (M-1) was confirmed by NMR, mass spectroscopy and IR.

(2) Synthesis of compound (M-5)

A compound (M-5) was synthesized in a method similar to that for synthesizing the compound (M-1) but replacing 2-hydroxyethyl methacrylate with 4-hydroxybutyl methacrylate.

(3) Synthesis of compound (M-8)

In a 1000 mL three-necked flask, a 500 mL THF solution of 49 g of ethanolamine was prepared and was cooled to 0°C. Then 51 g of 3-chloropropionyl chloride were dropwise added from a dropping funnel over a period of 1 hour and under agitation, and the temperature was thereafter gradually raised to the room temperature. After agitation for 12 hours at the room temperature, the reaction mixture was filtered and the solvent was distilled off. 10 g of obtained residue were placed in a 100 mL three-necked flask, dissolved in 50 mL of THF and cooled to 0°C. Then 7 g of methacryl chloride were dropwisely added from a dropping funnel over a period of 30 minutes and under agitation, and the temperature was thereafter gradually raised to the room temperature. After agitation for 12 hours at room temperature, the reaction mixture was poured into 300 mL of iced water. After agitation for 1 hour, an extraction was made with 1 L of ethyl acetate in three portions, and an obtained organic layer was washed with water in succession, a saturated aqueous solution of sodium hydrogencarbonate and a saturated sodium chloride aqueous solution, and was dried over magnesium sulfate. After filtration, the solvent was distilled off under a reduced pressure with a rotary evaporator. Obtained residue was purified on a silica gel chromatography (eluting solvent: hexane/ethyl acetate) to obtain 8 g of a compound (M-8). The structure of the compound (M-8) was confirmed by NMR, mass spectroscopy and IR.

(4) Synthesis of compound (M-9)

A compound (M-9) was synthesized in a method similar to that for synthesizing the compound (M-8) but

replacing ethanolamine with 4-hydroxy-1-butylamine.

Synthesis example 1

Synthesis of polymer compound (A-1) [Specific example of synthesizing method 1]

In a 500 mL three-necked flask equipped with a condenser and an agitator, 80 mL of 1-methoxy-2-propanol were charged and heated to 70°C. Under a nitrogen flow, 80 mL of a 1-methoxy-2-propanol solution containing 53.0 g of the example compound M-1, 5.2 g of methacrylic acid and 0.746 g of 2,2'-azobis(2,4-dimethylvaleronitrile) (trade name: V-65, manufactured by Wako Pure Chemicals Industries, Ltd.) were dropwisely added over a period of 2 hours and a half. Reaction was executed for 2 hours at 70°C. The reaction mixture was diluted with 100 mL of 1-methoxy-2-propanol, then cooled to 0°C, added dropwise with 33.4 g of triethylamine dropwise under agitation, and reacted for 12 hours while the temperature was gradually elevated to the room temperature. After the reaction mixture was cooled to 0°C, 5M HCl was dropwise added under agitation, until the pH of the reaction mixture reached 6 or lower. The reaction mixture was poured into 3 L of water to precipitate a polymer. The polymer was collected by filtration, then washed and dried to obtain a polymer compound (A-1). It was confirmed by NMR spectrum that all the groups derived from M-1 were converted to acryl groups. A weight-averaged molecular weight, measured with gel permeation chromatography (GPC) utilizing polystyrene as a standard substance, was 80,000.

Synthesis example 2

Synthesis of polymer compound (A-2) [Specific example of synthesizing method 2]

In a 500 mL three-necked flask equipped with a condenser and an agitator, 90 mL of methyl ethyl ketone were charged and heated to 70°C. Under a nitrogen flow, 90 mL of a methyl ethyl ketone solution containing 15.6 g of 2-hydroxyethyl methacrylate, 5.2 g of methacrylic acid, 12.0 g of methyl methacrylate and 0.775 g of 2,2'-azobis (2,4-dimethylvaleronitrile) (trade name: V-65, manufactured by Wako Pure Chemicals Industries, Ltd.) were dropwisely added over a period of 2 hours and a half. Reaction was executed for 2 hours at 70°C. The reaction mixture was cooled to 0°C, then added dropwise with 10.9 g of acrylic chloride under agitation, and reacted for 12 hours while the temperature was gradually elevated to the room temperature. The reaction mixture was poured into 3 L of water to precipitate a polymer. The polymer was collected by filtration, then washed and dried to obtain a polymer compound (A-2). It was confirmed by NMR spectrum that an acryl group was introduced into a side chain by a polymer reaction. A weight-averaged molecular weight, measured with gel permeation chromatography (GPC) utilizing polystyrene as a standard substance, was 78,000.

Synthesis example 3

Synthesis of polymer compound (A-3) [Specific example of synthesizing method 3]

In a 1000 mL three-necked flask equipped with a condenser and an agitator, 200 mL of 1-methoxy-2-propanol were charged and heated to 70°C. Under a nitrogen flow, 200 mL of a 1-methoxy-2-propanol solution containing 40.9 g of 2-allyloxyethyl methacrylate, 5.2 g of methacrylic acid and 0.746 g of 2,2'-azobis(2,4-dimethylvaleronitrile) (trade name: V-65, manufactured by Wako Pure Chemicals Industries, Ltd.) were dropwise added over a period of 2 hours and a half. Reaction was executed for 2 hours at 70°C. The reaction product was collected by filtration, then washed and dried to obtain a polymer compound (A-3). A weight-averaged molecular weight, measured with gel permeation chromatography (GPC) utilizing polystyrene as a standard substance, was 110,000.

Synthesis example 4

Synthesis of polymer compound (A-4) [Specific example of synthesizing method 4]

In a 500 mL three-necked flask equipped with a condenser and an agitator, 80 mL of methyl ethyl ketone were charged and heated to 70°C. Under a nitrogen flow, 80 mL of a methyl ethyl ketone solution containing 12.5 g of methacryl chloride, 5.2 g of methacrylic acid, 12.0 g of methyl methacrylate and 0.700 g of 2,2'-azobis(2,4-dimethylvaleronitrile) (trade name: V-65, manufactured by Wako Pure Chemicals Industries, Ltd.) were dropwise added over a period of 2 hours and a half. Reaction was executed for 2 hours at 70°C. The reaction mixture was cooled to 0°C, then dropwise added with 12.5 g of allyloxyethyl alchoal under agitation, and reacted for 12 hours while the temperature was gradually elevated to the room temperature. The reaction mixture was poured into 3 L of water to precipitate a polymer. The polymer was collected by filtration, then washed and dried to obtain a polymer compound (A-4). It was confirmed by NMR spectrum that an allyl group was introduced into a side chain by a polymer reaction. A weight-averaged molecular weight, measured with gel permeation chromatography (GPC) utilizing polystyrene as a standard substance, was 95,000.

Synthesis example 5

Synthesis of polymer compound (A-5) [Specific example of synthesizing method 5]

In a 500 mL three-necked flask equipped with a condenser and an agitator, 150 mL of 1-methoxy-2-propanol were charged and heated to 70°C. Under a nitrogen flow, 150 mL of a 1-methoxy-2-propanol solution containing 26.9 g of vinyl methacrylate, 5.2 g of methacrylic acid and 0.780 g of 2,2'-azobis(2,4-dimethylvaleronitrile) (trade name: V-65, manufactured by Wako Pure Chemicals Industries, Ltd.) were dropwise added over a period of 2 hours and a half. Reaction was executed for 2 hours at 70°C. The reaction product was collected by filtration, then washed and dried to obtain a polymer compound (A-5). A weight-averaged molecular weight, measured with gel permeation chromatography (GPC) utilizing polystyrene as a standard substance, was 120,000.

Synthesis example 6

Synthesis of polymer compound (A-6) [Specific example of synthesizing method 6]

In a 500 mL three-necked flask equipped with a condenser and an agitator, 100 mL of methyl ethyl ketone were charged and heated to 70°C. Under a nitrogen flow, 100 mL of a methyl ethyl ketone solution containing 12.5 g of methacryl chloride, 5.2 g of methacrylic acid, 12.0 g of methyl methacrylate and 0.700 g of 2,2'-azobis (2,4-dimethylvaleronitrile) (trade name: V-65, manufactured by Wako Pure Chemicals Industries, Ltd.) were dropwise added over a period of 2 hours and a half. Reaction was executed for 2 hours at 70°C. The reaction mixture was cooled to 0°C, then dropwise added with 11.0 g of 2-hydroxyethyl monovinyl ether under agitation, and reacted for 12 hours while the temperature was gradually elevated to the room temperature. The reaction mixture was poured into 3 L of water to precipitate a polymer. The polymer was collected by filtration, then washed and dried to obtain a polymer compound (A-6). It was confirmed by NMR spectrum that a vinyl group was introduced into a side chain by a polymer reaction. A weight-averaged molecular weight, measured with gel permeation chromatography (GPC) utilizing polystyrene as a standard substance, was 95,000.

Synthesis examples 7 - 25

Following polymer compounds A-7 to A-25 were prepared in a similar manner as in the synthesis examples 1 to 6 but changing kinds and composition ratio of monomers. The weight-averaged molecular weights of such polymers were measured in the same manner as in the synthesis examples 1 to 6.

The specified alkali soluble resins, obtained in the above-described synthesizing methods, are shown in following tables 1 to 5, by structures and a molar ratio of polymerization of the structural units, with measured weight-averaged molecular weights [(polymer compound A-1) to (polymer compound A-25)].

Table 1

| | Composition of synthesized polymer compound (mol%) | WAMW* |
|---|---|---|
| A-1 | 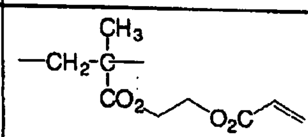 80 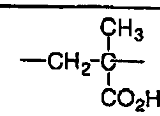 20 | 80,000 |
| A-2 | 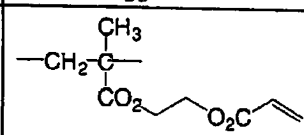 40 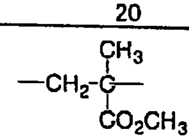 40 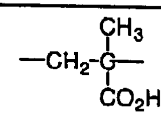 20 | 78,000 |
| A-3 | 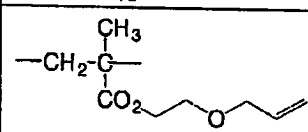 80 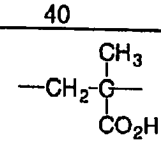 20 | 110,000 |
| A-4 | 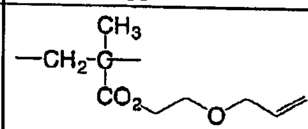 40 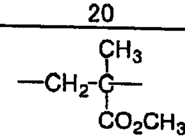 40 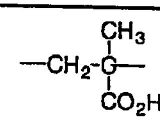 20 | 95,000 |
| A-5 | 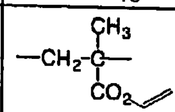 80 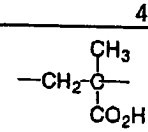 20 | 120,000 |

*WAMW: Weight-Average Molecular Weight

Table 2

| | Composition of synthesized polymer compound (mol%) | WAMW |
|---|---|---|
| A-6 | 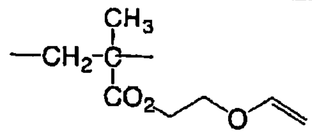 40 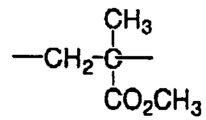 40 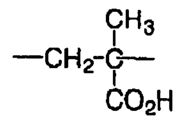 20 | 95,000 |
| A-7 | 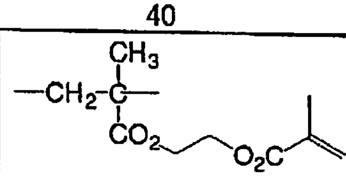 30 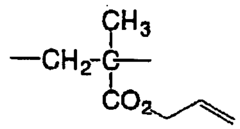 50 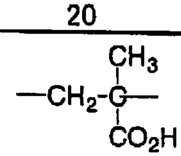 20 | 101,000 |
| A-8 | 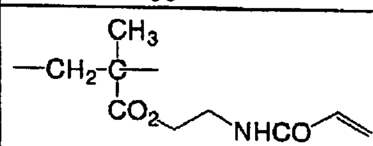 82 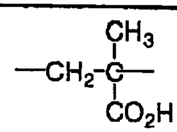 18 | 90,000 |
| A-9 | 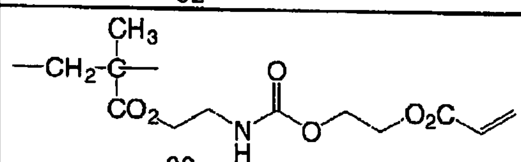 80 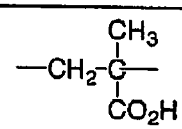 20 | 90,000 |
| A-10 | 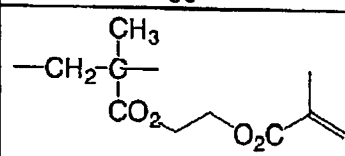 35 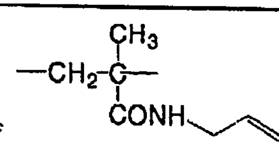 45 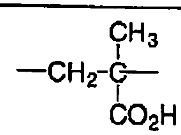 20 | 95,000 |

Table 3

| | Composition of synthesized polymer compound (mol%) | WAMW |
|---|---|---|
| A-11 | 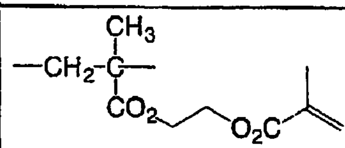 63 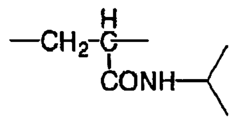 20 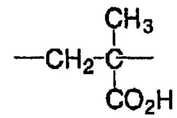 17 | 130,000 |
| A-12 | 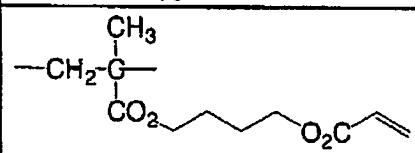 80 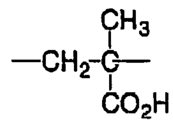 20 | 105,000 |
| A-13 | 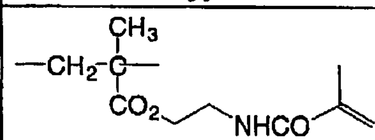 55 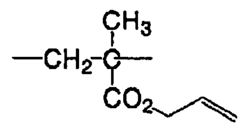 25 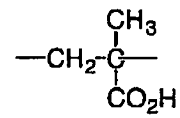 20 | 100,000 |
| A-14 | 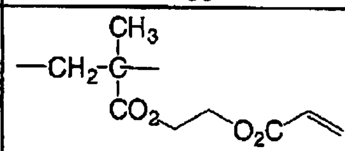 60 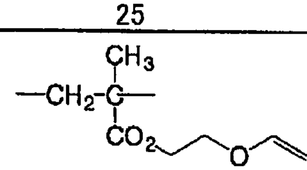 16 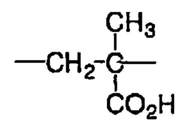 24 | 133,000 |
| A-15 | 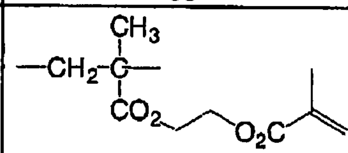 60 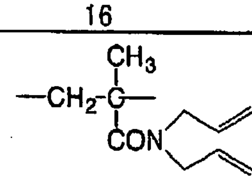 22 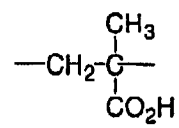 18 | 130,000 |

Table 4

| | Composition of synthesized polymer compound (mol%) | | | WAMW |
|---|---|---|---|---|
| A-16 | 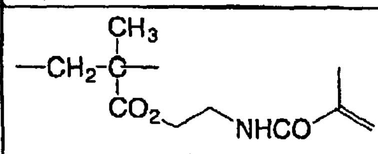 60 | 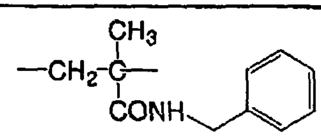 20 | 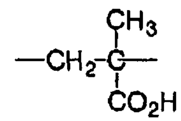 20 | 125,000 |
| A-17 | 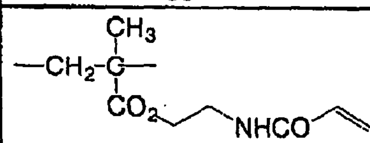 42 | 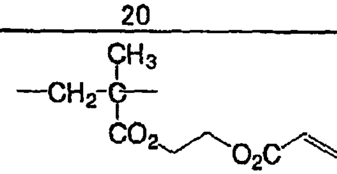 38 | 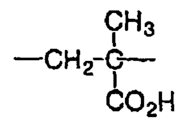 20 | 118,000 |
| A-18 | 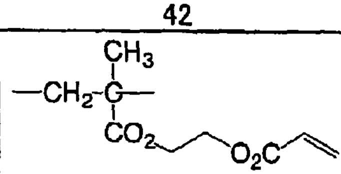 60 | 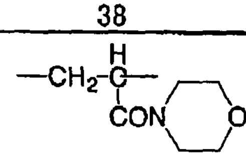 22 | 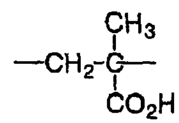 18 | 120,000 |
| A-19 | 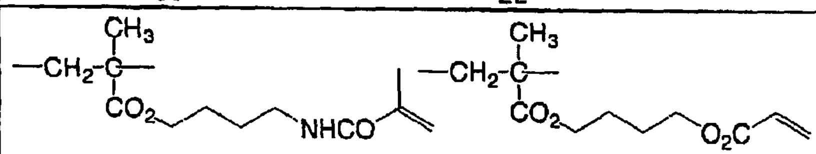 40 | 40 | 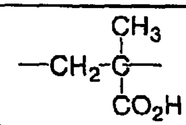 20 | 100,000 |
| A-20 | 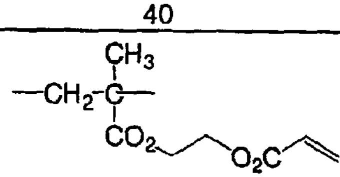 65 | 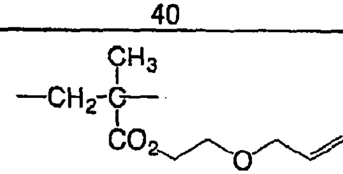 15 | 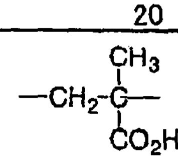 20 | 106,000 |

Table 5

| | Composition of synthesized polymer compound (mol%) | WAMW |
|---|---|---|
| A-21 | 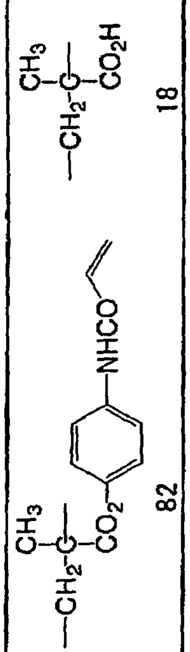 82 18 | 97,000 |
| A-22 | 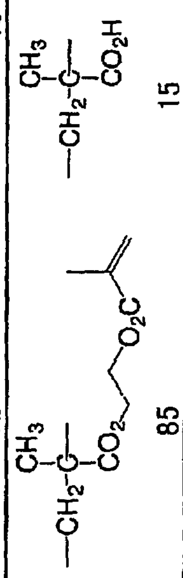 85 15 | 114,000 |
| A-23 | 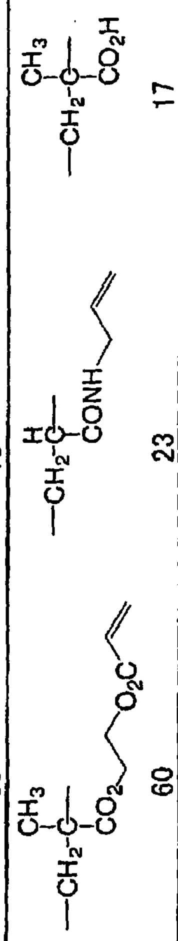 60 23 17 | 130,000 |
| A-24 | 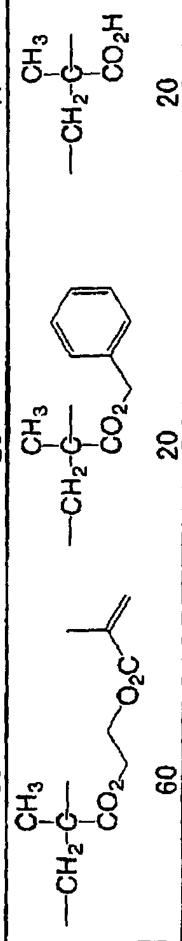 60 20 20 | 100,500 |
| A-25 | 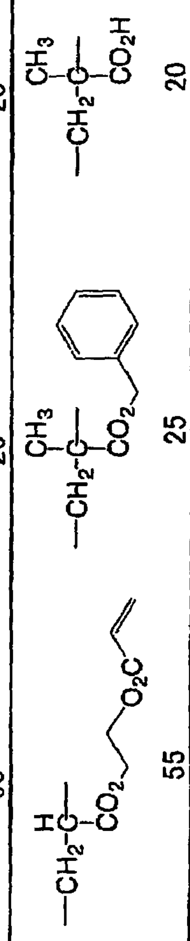 55 25 20 | 110,500 |

In the specified alkali soluble resin of the invention, it is also preferred, in order to improve various properties such as an image strength, to copolymerize another radical polymerizable compound in addition to the radical polymerizable compound described in the foregoing synthesizing methods.

A radical polymerizable compound which can be copolymerized with the specified alkali soluble resin can be, for example, selected from an acrylic acid ester, a methacrylic acid ester, an N,N-disubstituted acrylamide, an N,N-disubstituted methacrylamide, a styrene, an acrylonitrile or a methacrylonitrile.

Specific examples include an acrylic acid ester such as an alkyl acrylate (alkyl group preferably having 1 to

20 carbon atoms) (more specifically methyl acrylate, ethyl acrylate, propyl acrylate, butyl acrylate, amyl acrylate, ethylhexyl acrylate, octyl acrylate, t-octyl acrylate, chloroethyl acrylate, 2,2-dimethylhydroxypropyl acrylate, 5-hydroxypentyl acrylate, trimethylolpropane monoacrylate, pentaerythritol monoacrylate, glycidyl acrylate, benzyl acrylate, methoxybenzyl acrylate, furfuryl acrylate, tetrahydrofurfuryl acrylate etc.) or an aryl acrylate (for example phenyl acrylate).

There is also included an alkyl methacrylate (alkyl group preferably having 1 to 20 carbon atoms) (more specifically methyl methacrylate, ethyl methacrylate, propyl methacrylate, isopropyl methacrylate, amyl methacrylate, hexyl methacrylate, cyclohexyl methacrylate, benzyl methacrylate, chlorobenzyl methacrylate, octyl methacrylate, 4-hydroxybutyl methacrylate, 5-hydroxypentyl methacrylate, 2,2-dimethyl-3-hydroxypropyl methacrylate, trimethylolpropane monomethacrylate, pentaerythritol monomethacrylate, glycidyl methacrylate, furfuryl methacrylate, tetrahydrofurfuryl methacrylate etc.) or an aryl methacrylate (for example phenyl methacrylate, cresyl methacrylate, naphthyl methacrylate etc.).

There is also included styrene, a styrene derivative such as alkylstyrene (for example methylstyrene, dimethylstyrene, trimethylstyrene, ethylstyrene, diethylstyrene, isopropylstyrene, butylstyrene, hexylstyrene, cyclohexylstyrene, decylstyrene, benzylstyrene, chloromethylstyrene, trifluoromethylstyrene, ethoxymethylstyrene, acetoxymethylstyrene etc.), an alkoxystyrene (for example methoxystyrene, 4-methoxy-3-methylstyrene, dimethoxystyrene etc.), a halogenated styrene (for example chlorostyrene, dichlorostyrene, trichlorostyrene, tetrachlorostyrene, pentachlorostyrene, bromostyrene, dibromostyrene, iodostyrene, fluorostyrene, trifluorostyrene, 2-bromo-4-trifluorostyrene, 4-fluoro-3-trifluorostyrene etc.), acrylonitrile or methacrylonitrile.

Among these radical polymerizable compounds, an acrylic acid ester, a meethacrylic acid ester or a styrene can be used advantageously.

Such compounds can be used singly or in a mixture or two or more kinds, and such copolymerization component can be preferably used in a content of 0 to 95 mol%, particularly preferably 20 to 90 mol%.

In the specified alkaly soluble resin of the invention, in order to improve properties such as a removing property for a non-image portion, there may be copolymerized a radical polymerizable compound having an acid group. The acid group contained in the radical polymerizable compound can be, for example, a carboxylic acid group, a sulfonic acid group or a phosphonic acid group, among which a carboxylic acid group is preferred. Examples of a radical polymerizable compound having a carboxylic acid group include acrylic acid, methacrylic acid, itaconic acid, crotonic acid, incrotonic acid, maleic acid, and p-carboxylstyrene, among which particularly preferred is acrylic acid, methacrylic acid or p-carboxylstyrene.

Such compounds can be used singly or in a mixture or two or more kinds, and such copolymerization component can be preferably used in a content of 0 to 85 mol%, particularly preferably 10 to 70 mol%.

The specified alkali soluble resin in the invention can be a homopolymer, but, it is a copolymer of radical polymerizable compounds having different groups represented by the general formulas (1) to (3), or of at least a radical polymerizable compound having a group represented by the general formulas (1) to (3) and at least another aforementioned radical polymerizable compound, such copolymer may be a block copolymer, a random copolymer or a graft copolymer.

A solvent to be used in synthesizing such polymer compound can be, for example, ethylene dichloride, cyclohexanone, methyl ethyl ketone, acetone, methanol, ethanol, propanol, butanol, ethyleneglycol monomethyl ether, ethyleneglycol monoethyl ether, 2-methoxyethyl acetate, 1-methoxy-2-propanol, 1-methoxy-2-propyl acetate, N,N-dimethylformamide, N,N-dimethylacetamide, dimethylsulfoxide, toluene, ethyl acetate, methyl lactate, or ethyl lactate. Such solvent may be used singly or as a mixture of two or more kinds.

As the specified alkali soluble resin, there is particularly preferred a resin including a component having an aromatic group as a copolymerization component.

In the invention, the specified alkali soluble resin preferably has a weight-averaged molecular weight of 2,000 or higher, more preferably from 5,000 to 300,000. Also the specified alkali soluble resin may include an unreacted monomer. In such case, the proportion of the monomer in the specified alkali soluble resin is preferably 15 % by weight or less.

Also in case the specified alkali soluble resin is used as a polymerizable compound component, the specified alkali soluble resin and another radical polymerizable compound in the polymerization compounds have a weight ratio preferably within a range from 1:0.05 to 1:3, more preferably from 1:0.1 to 1:2, further preferably from 1:0.3 to 1 : 1.5.

In case of using the specified alkali soluble resin as a polymerizable compound component, since such resin itself has an excellent film forming property, there can be anticipated further improvements in the film forming property and the printing durability even in the absence of a binder polymer, which is added in desirable for improving the film properties as will be explained later.

In the invention, the polymerizable compound may be used singly or in two or more kinds. Details of method of using such polymerizable compound, such as a structure thereof, either a single use or a combined use, and an amount of addition thereof, can be arbitrarily selected according to a designing of the final performance of the recording material.

In the invention, details of method of using such polymerizable compound, such as a structure thereof, either a single use or a combined use, and an amount of addition thereof, suitably selected according to a designing of the final performance of the recording material, namely maintaining an electrostatic capacitance rate of increase ratio at 0.7 or lower in a model solution simulating a developing solution. Such selection is executed for example from following standpoints. As regards the sensitivity, there is preferred a structure having a larger number of unsaturated group per molecule, and two or more functional groups are preferred in most cases. Also in order to increase the strength of an image portion or namely a hardened film, three or more functional groups are advantageous, and it is also effective to employ a method of regulating both the photosensitivity and the strength, by combining compounds different in the number of the functional groups or in the polymerizable group (for example an acrylate ester compound, a methacrylate ester compound and a styrene compound). In the electrostatic capacitance rate of increase ratio, which is a physical property of the photosensitive composition of the invention, a hardening speed and a film strength are important factors and such method can be considered effective.

A compound of a large molecular weight or a high hydrophobicity is advantageous for providing a higher sensitivity or a higher film strength, but may be undesirable because of a developing speed or a precipitation in the developing solution. Also the selection and the method of use of the radical polymerizable compound are important factors for a mutual solubility with or a dispersibility in other components in the recording layer (for example binder polymer, initiator, coloring agent etc.), and, for example, the mutual solubility may be improved by using a compound of a lower purity or two or more compounds in combination. Also there may be selected a specified structure for the purpose of improving adhesion to the substrate or the overcoat layer. With respect to a composition ratio of the radical polymerizable compound in the image recording layer, a higher composition ratio is advantageous for the sensitivity, but an excessively high composition ratio may result in drawbacks such as an undesirable phase separation, a defect in the manufacturing process resulting from a viscous property of the image recording layer (for example a defect in the manufacture resulting from a transfer or a sticking of a component of the recording layer), or a precipitation from the developing solution. In consideration of the foregoing, a preferred composition ratio of the radical polymerizable compound is, in most cases, 5 to 95 % by weight with respect to all the components of the composition, more preferably 10 to 85 % by weight, and further preferably 20 to 75 % by weight. Also the radical polymerizable compound may be used singly or in a combination of two or more kinds. Furthermore the radical polymerizable compound can be arbitrarily selected in the structure, composition and amount of addition thereof, also in consideration of a magnitude of polymerization inhibition by oxygen, a resolution, a fogging property, a change in the refractive index, a surface tackiness etc.

Binder Polymer

In the photosensitive composition to be used in the image recording material of the invention, there is further used a binder polymer for example for improving film properties of the recording layer to be formed. For such binder, a linear organic polymer is preferably used. For such "linear organic polymer", there can be arbitrarily used any known one. In the image forming material of the first and second embodiments of the invention, there is preferably selected a linear organic polymer which can be one of dissolved and swollen by one of water and an alkaline aqueous solution, in order to enable a development with water or weakly alkaline water. The linear organic polymer is selected not only as a film forming substance for forming the recording layer, but also according to a purpose of use by development with water, weakly alkaline water or an organic solvent. For example, a development with water is made possible by using a water-soluble organic polymer. Such linear organic polymer can be a radical polymerized product having a carboxylic acid group in a side chain, for example compounds described in JP-A No. 59-44615, JP-B Nos. 54-34327, 58-12577 and 54-25957, JP-A Nos. 54-92723, 58-53836 and 59-71048, such as a methacrylic acid copolymer, an acrylic acid copolymer, an itaconic acid copolymer, a crotonic acid copolymer, a maleic acid copolymer or a partially esterified maleic acid copolymer. There is also known an acidic cellulose derivative having a carboxylic acid group in a side chain. In addition, an addition product of a cyclic acid anhydride to a polymer having a hydroxyl group is also useful.

Among these, a (meth)acrylic resin having a benzyl group or an allyl group and a carboxyl group in a side chain is particularly advantageous in consideration of a balance of the film strength, the sensitivity and the developability.

An urethane binder polymer including an acid group, described for example in JP-B Nos. 7-12004, 7-120041, 7-120042 and 8-12424, JP-A Nos. 63-287944, 63-287947. 1-271741 and 11-35269, is also excellent in the strength and is therefore advantageous for improving the printing run length and the performance for a low exposure amount.

As the water-soluble linear organic polymer, polyvinylpyrrolidone or polyethylene oxide is also useful. In order to improve the strength of the hardened film, alcohol-soluble nylon or a polyether compound formed by 2,2-bis- (4-hydroxyphenyl)-propane and epichlorohydrin is useful, too.

In image forming materials of third and fourth embodiments of the present invention, a polymer insoluble in water and soluble in alkaline water (hereinafter suitably referred to as "an alkaline water-soluble polymer") as the binder

polymer may be particularly preferably used. The alkaline water-soluble polymer is a polymer which is insoluble in water but soluble in alkaline water, and can form a film by itself, as it has an excellent film forming property. The alkaline water-soluble polymer in the invention includes a homopolymer having an acidic group in a main chain and/or a side chain of the polymer, a copolymer thereof and a mixture thereof. Therefore, the polymer layer of the invention has a property of being dissolved in contacct with an alkaline developing solution. Among these, there is preferred a polymer having an acidic group shown in following (1) to (6) in the main chain and/or the side chain of the polymer, in consideration of solubility in an alkaline developing solution:

(1) a phenolic hydroxyl group (-Ar-OH);
(2) a sulfonamide group ($-SO_2NH-R$);
(3) a substituted sulfonamide acid group (hereinafter called "active imide group" [$-SO_2NHCOR$, $-SO_2NHSO_2R-$, $CONHSO_2R$];
(4) a carboxylic acid group ($-CO_2H$);
(5) a sulfonic acid group ($-SO_3H$);
(6) a phosphonic acid group ($-OPO_3H_2$).

In the foregoing (1) to (6), Ar represents a divalent aryl connecting group which may have substituent(s), and R represents a hydrocarbon group which may have substituent(s).
The polymer to be used in the invention has a weight-averaged molecular weight preferably of 5,000 or higher, more preferably within a range from 10,000 to 300,000, and a number-averaged molecular weight preferably of 1,000 or higher and more preferably within a range from 2,000 to 250,000. A dispersion level (weight-averaged molecular weight/number-averaged molecular weight) is preferably 1 or higher, more preferably within a range from 1.1 to 10.
Such polymer can be a random polymer, a block polymer, or a graft polymer, but is preferably a random polymer.
The polymer to be used in the invention can be synthesized by an already known method. A solvent to be used in the synthesis can be, for example, tetrahydrofurane, ethylene dichloride, cyclohexanone, methyl ethyl ketone, acetone, methanol, ethanol, ethyleneglycol monomethyl ether, ethyleneglycol monoethyl ether, 2-methoxyethyl acetate, diethyleneglycol dimethyl ether, 1 -methoxy-2-propanol, 1-methoxy-2-propyl acetate, N,N-dimethylformamide, N, N-dimethylacetamide, toluene, ethyl acetate, methyl lactate, ethyl lactate, dimethylsulfoxide or water. Such solvent may be used singly or as a mixture of two or more kinds.
As a radical polymerization initiator to be used in synthesizing the polymer to be used in the invention, there can be used a known compound such as an azo initiator or a peroxide initiator.
The binder polymer to be used in the invention may be used singly or as a mixture of two or more kinds. Such polymer is added to the recording layer in an amount of 20 to 95 wt.% with respect to the total solids of a recording layer coating liquid, preferably 30 to 90 wt.%. An amount of addition less than 20 wt.% results in an insufficient strength of an image portion in the image formation. Also with an amount of addition exceeding 95 wt.%, an image formation is not possible. Also an addition ratio (b/a) of the radical polymerizable compound (b) having the ethylenic unsaturated double bond to the linear organic polymer (a) is preferably within a range of 1/9 to 7/3 in a weight ratio.

Other Components

In case of using the photosensitive composition of the invention as an image recording layer of a planographic printing plate precursor, other various compounds may be added according to the necessity, for improving the characteristics and the handling property of the planographic printing plate precursor, in addition to the aforementioned components relating to the film hardening.
For example, a dye having a large absorption in the visible wavelength region may be used as a coloring agent for the image. Specific examples include oil yellow #101, oil yellow #103, oil pink #312, oil green BG, oil blue BOS, oil blue #603, oil black BY, oil black BS, oil black T-505 (foregoing manufactured by Orient Kagaku Kogyo Co., Ltd.), Victoria pure blue, crystal violet (CI42555), methyl violet (CI42535), ethyl violet, rhodamine B (CI145170B), marachite green (CI42000), methylene blue (CI52015), and dyes described in JP-A No. 62-293247. Also there can be advantageously used a pigment such as a phthalocyanine pigment, an azo pigment, carbon black or titanium oxide.
Addition of such coloring agent is preferred, as an image part and a non-image part can be easily distinguished after image formation. An amount of addition is within a range of 0.01 to 10 wt.% with respect to the total solids of the recording layer coating liquid.
In the present invention, in order to prevent an unnecessary thermal polymerization of the radical polymerizable compound having the ethylenic unsaturated double bond during the preparation or the storage of the recording layer coating liquid, it is desirable to add a small amount of a thermal polymerization inhibitor. Examples of the suitable thermal polymerization inhibitor include hydroquinone, p-methoxyphenol, di-t-butyl-p-cresol, pyrogarol, t-butylcatechol,

benzoquinone, 4,4'-thiobis(3-methyl-6-t-butylphenol), 2,2'-methnylenebis(4-methyl-6-t-butylphenol) and N-nitroso-N-phenylhydroxylamine aluminum salt. An addition amount of the thermal polymerization inhibitor is preferably about 0.01 to 5 wt.% with respect to the weight of the entire composition. Also, if necessary in order to prevent inhibition of polymerization by oxygen, a higher fatty acid derivative such as behenic acid or behenic acid amide may be added and made to be present locally at the surface of the photosensitive layer in the course of a drying step after coating. An addition amount of such higher fatty acid derivative is preferably about 0.1 to 10 wt.% with respect to the entire composition.

In the recording layer coating liquid, for widening the stability of processing in developing conditions, there may be added a nonionic surfactant as described in JP-A Nos. 62-251740 and 3-208514, or an amphoteric surfactant as described in JP-A Nos. 59-121044 and 4-13149.

Specific examples of the nonionic surfactant include sorbitan tristearate, sorbitan monopalmitate, sorbitan trioleate, stearic acid monoglyceride, and polyoxyethylene nonylphenyl ether.

Specific examples of amphoteric surfactant include alkyldi(aminoethyl)glycin, alkylpolyaminoethylglycin hydrochloric acid salt, 2-alkyl-N-carboxyethyl-N-hydroxyethylimidazolinium betain and N-tetradecyl-N,N-betain (for example "Amogen K" (trade name, manufactured by Dai-ichi Kogyo Co., Ltd.)).

The proportion of the nonionic surfactant and amphoteric surfactant in the recording layer coating liquid is preferably 0.05 to 15 wt.%, and more preferably 0.1 to 5 wt.%. In addition, other additives such as an adhesion promoter, a development accelerator, an ultraviolet absorber, and a lubricant may be suitably added according to the purpose.

Also in the recording layer coating liquid of the invention, a plasticizer is added if necessary in order to provide the coated film with a flexibility. For example there can be used polyethylene glycol, tributyl citrate, diethyl phthalate, dibutyl phthalate, dihexyl phthalate, dioctyl phthalate, tricresyl phosphate, tributyl phosphate, trioctyl phosphate, or tetrahydrofurfuryl oleate.

A planographic printing plate precursor can be produced with the photosensitive composition of the invention, by dissolving, in a solvent, the above-described components necessary for the recording layer coating liquid and by coating such liquid on a suitable substrate. Examples of the solvent to be used include ethylene dichloride, cyclohexanone, methyl ethyl ketone, methanol, ethanol, propanol, ethylglycol monomethyl ether, 1-methoxy-2-propanol, 2-methoxyethyl acetate, 1-methoxy-2-propyl acetate, dimethoxyethane, methyl lactate, ethyl lactate, N,N-dimethylacetamide, N,N-dimethylformamide, tetramethyl-urea, N-methylpyrrolidone, dimethylsulfoxide, sulfolane, γ-butyrolactone, toluene, and water but these examples are not restrictive. These solvents may be used singly or in a mixture thereof. The concentration of aforementioned components (all solids including the additives) in the solvent is preferably 1 to 50 wt.%.

Also the coating amount (solid) obtained on the substrate after coating and drying is variable depending on the purpose of use, but, for a planographic printing plate precursor, there is generally preferred a range of 0.5 to 5.0 $g/m^2$. A decrease in the coating amount increases the apparent sensitivity, but deteriorates the film properties of the recording layer serving for image recording.

The coating can be achieved by various methods, such as bar coating, spin coating, spray coating, curtain coating, immersion coating, air knife coating, blade coating or roller coating.

In the recording layer coating liquid of the invention, there may be added a surfactant for improving the coating property, for example a fluorinated surfactant as described in JP-A No. 62-170950. An amount of addition with respect to the total solids of the recording layer is preferably 0.01 to 1 wt.%, more preferably 0.05 to 0.5 wt.%.

Substrate

The negative working image recording material, utilizing the photosensitive composition of the invention, is formed by coating the aforementioned recording layer on a substrate. The employable substrate is not particularly limited as long as it is a dimensionally stable plate-shaped member and can be, for example, paper, paper laminated with a plastic material (for example of polyethylene, polypropylene or polystyrene), a metal plate (for example aluminum, zinc or copper), a plastic film (for example cellulose diacetate, cellulose triacetate, cellulose propionate, cellulose butyrate, cellulose acetate butyrate, cellulose nitrate, polyethylene terephthalate, polyethylene, polystyrene, polypropylene, polycarbonate or polyvinylacetal), or paper or a plastic film laminated or evaporated with the aforementioned metal. A preferred substrate is a polyester film or an aluminum plate.

In case of using the image recording material based on the photosensitive composition of the invention for a planographic printing plate precursor, it is preferred to use, as the substrate therefor, an aluminum plate which is light in weight and has excellent properties for surface treatment, in various workings and in corrosion resistance. The aluminum material usable for such purpose can be, for example, a JIS 1050 material, that contains 0.30 % of Fe, 0.10 % of Si, 0.02 % of Ti and 0.013 % of Cu, an A1-Mg alloy, an A1-Mn alloy, an A1-Mn-Mg alloy, an Al-Zr alloy or an Al-Mg-Si alloy.

A preferred aluminum plate is a pure aluminum plate or an alloy plate principally composed of aluminum and

containing other elements in a small amount as mentioned above, and can also be a plastic film on which aluminum is evaporated or laminated. The other elements contained in the aluminum alloy may be silicon, iron, manganese, copper, magnesium, chromium, zinc, bismuth, nickel and/or titanium. The content of other elements in the alloy is 10 wt.% or less. Pure aluminum plate is preferred, but there may be used aluminum containing other elements in a small amount since completely pure aluminum is difficult to produce in the refining technology. Thus, the aluminum plate employable in the invention is not specified in the composition thereof but there can be suitably utilized an aluminum plate of an already known and utilized material. A thickness of the aluminum plate to be used in the invention is preferably about 0.1 to 0.6 mm, more preferably 0.15 to 0.4 mm, and particularly preferably 0.2 to 0.3 mm.

Prior to the surface roughing of the aluminum plate, there is conducted, if desired, a degreasing process for example with a surfactant, an organic solvent or an aqueous alkali solution, in order to remove rolling oil on the surface. The roughing process of the surface of the aluminum plate can be executed by various methods, for example a mechanical roughing method, a method of surface roughing by electrochemically dissolving the surface, or a method of selectively dissolving the surface chemically. For the mechanical method, there can be used a known method such as a ball abrading method, a brush abrading method, a blast abrading method or a buff abrading method. Also as the electrochemical roughing method, there is known a method utilizing an AC current or a DC current in an electrolyte solution of hydrochloric acid or nitric acid.

Thus surface roughed aluminum plate is subjected, after alkali etched and neutralized if necessary, to an anodizing process, if desired, for improving a water holding property and an abrasion resistance of the surface. An amount of an anodized oxide film, formed by the anodizing, is preferably 1.0 g/m$^2$ or higher. In case the amount of the anodized oxide film is less than 1.0 g/m$^2$, there may result an insufficient printing run length or a tendency of generating scars in a non-image portion in the use as the planographic printing plate, leading to so-called "scar smear" which is caused by an ink deposition on such scars at the printing operation. After the anodizing process, the aluminum is subjected to a process of rendering the surface thereof hydrophilic according to the necessity.

Such aluminum substrate may be subjected, after the anodizing process, to a treatment with an organic acid or a salt thereof, or to an application of an undercoat layer for the recording layer to be coated.

Also an intermediate layer may be provided in order to improve the adhesion between the substrate and the recording layer. For improving the adhesion, the intermediate layer is generally formed by a diazo resin or a phosphoric acid compound adsorbable to the aluminum. A thickness of the intermediate layer can be arbitrarily selected but has to be such that a uniform bonding reaction can be caused with the upper recording layer when exposed. In general a coating amount of 1 to 100 mg/m$^2$ in dry solid is preferred, and a coating amount of 5 to 40 mg/m$^2$ is particularly preferred. A proportion of the diazo resin in the intermediate layer is in a range of 30 to 100 %, preferably 60 to 100 %.

After the surface of the substrate is subjected to a treatment or an undercoating as explained above, a back coating is provided on the rear surface of the substrate if necessary. Such back coating is preferably formed by a coated layer of an organic polymer compound described in JP-A No. 5-45885 or a metal oxide obtained by hydrolysis and condensation polymerization of an organic or inorganic metal compound as described in JP-A No. 6-35174.

For a substrate of the planographic printing plate, there is preferred a center line-averaged roughness of 0.10 to 1.2 µm. A roughness lower than 0.10 µm decreases the adhesion to the recording layer, thus leading to a significant loss in the printing run length. Also a roughness higher than 1.2 µm enhances the smear at the printing operation. Also the substrate has a color density in a range of 0.15 to 0.65 in reflective density. A density lighter than 0.15 causes an excessive halation at the image exposure, thus hindering the image formation, while a density darker than 0.65 renders the image not easily visible in a plate inspecting operation after the image development, thus significantly deteriorating the plate inspection property.

On the substrate obtained by the processes explained in the foregoing, there are formed the above-described recording layer and other arbitrary layers such as a surface protective layer and a back coating layer to obtain a planographic printing plate precursor having a negative working image recording layer, utilizing the photosensitive composition of the invention.

In the planographic printing plate precursor using the photosensitive composition of the invention as the recording layer, an image recording is executed with an infrared laser. In the invention, there is preferably made an image exposure with a solid-state laser or a semiconductor laser emitting an infrared ray of a wavelength from 760 to 1200 nm. The laser preferably has an output of 100 mW or higher, and a multi-beam laser device is preferably used in order to shorten the exposure time. Also an exposure time per pixel is preferably 20 µsec or shorter. An energy irradiating the recording material is preferably within a range of 10 to 300 mJ/cm$^2$. An excessively low exposure energy cannot cause a suffient hardening of the image recording layer, thereby being eventually unable to attain the electrostatic capacitance rate of increase ratio defined in the invention. On the other hand, an excessively high exposure energy may cause a laser ablation in the image recording layer, thereby damaging the image.

Exposure in the invention is executed with an overlapping of a light beam of a light source. The overlapping means that a pitch of a sub scanning is smaller than a diameter of the light beam. Such overlapping can be quantitatively expressed, by representing the beam diameter by a width at a half median value of the beam intensity (FWHM), by

FWHM/sub-scanning pitch (overlap coefficient). In the invention, the overlap coefficient is preferably 0.1 or higher.

A scanning method of the light source of an exposure apparatus to be used in the invention is not particularly limited, and there can be used for example an external drum scanning method, an internal drum scanning method or a flat bed scanning method. Also the light source can be of a single channel or multi channels, but multi-channel light sources are preferably used in case of the external drum scanning method.

As a developing solution and a replenishing solution for the planographic printing plate utilizing the image recording material of the invention, there can be used an alkaline aqueous solution already known in the art. By using an alkali aqueous solution, used for the developing solution, as the model solution for measuring the electrostatic capacitance rate of increase ratio, it is possible to estimate a discrimination of the recording layer to the developing solution, and an electrostatic capacitance rate of increase ratio of 0.7 provides a satisfactory discrimination, with a significant improvement also in the screen dot reproducibility.

For example, there can be used an inorganic alkali salt such as sodium silicate, potassium silicate, trisodium phosphate, tripotassium phosphate, triammonium phosphate, disodium phosphate, dipotassium phosphate, diammonium phosphate, sodium carbonate, potassium carbonate, ammonium carbonate, sodium hydrogencarbonate, potassium hydrogencarbonate, ammonium hydrogencarbonate, sodium borate, potassium borate, ammonium borate, sodium hydroxide, ammonium hydroxide, potassium hydroxide or lithium hydroxide. Also there can be used an organic alkali compound such as monomethylamine, dimethylamine, trimethylamine, monoethylamine, diethylamine, triethylamine, monoisopropylamine, diisopropylamine, triisopropylamine, n-butylamine, monoethanolamine, diethanolamine, triethanolamine, monoisopropanolamine, diisopropanolamine, ethylenimine, ethylenediamine or pyridine. Such alkaline compounds may be used singly or in a combination of two or more kinds.

A particularly preferred developer among these alkali compounds is an aqueous silicate solution such as of sodium silicate or potassium silicate. It is because the developability can be regulated by the ratio and concentration of silicon oxide $SiO_2$ and a metal oxide $M_2O$ constituting the silicate salt, and alkali metal silicate salts as described in JP-A No. 54-62004 and JP-B No. 57-7427 can be effectively used.

Further, in case of a development with an automatic developing apparatus, it is already known that many presensitized plates can be developed without replacing the developer in a developing tank over a long period, by adding, to the developer, an aqueous solution with an alkali strength higher than that in the developer. Such replenishing method can be advantageously used also in the invention. In the developer solution and the replenishing solution, various surfactants and organic solvents may be added according to the necessity, for the purpose of increasing or suppressing the developability, dispersing development dregs and improving an ink affinity to an image portion of the printing plate.

A preferred surfactant can be an anionic, cationic, nonionic or amphoteric surfactant. Also if necessary, there may be added, to the developer solution and the replenishing solution, a reducing agent such as hydroquinone, resorcin, a sodium salt or a potassium salt of an inorganic acid such as sulfurous acid or hydrogensulfurous acid, also an organic carboxylic acid, a defoamer or a water softening agent.

The printing plate developed with the aforementioned developer solution and the replenishing solution is post-processed with rinsing water, a rinse solution containing for example a surfactant, or a desensitizing solution including gum Arabic or a starch derivative. In case of using the image recording material of the invention as the planographic printing plate, these processes may be used in various combinations as the post-processing.

An automatic development apparatus is generally composed of a development unit and a post-process unit and is provided with an apparatus for conveying a printing plate, tanks for various liquids and a spraying apparatus, in which an exposed printing plate is subjected, while conveyed horizontally, to a development process by spraying various process solutions supplied by pumps from spray nozzles. Recently there is also known a method of processing by conveying a printing plate, for example by in-liquid guide rollers, in a state immersed in a processing solution filled in a processing tank. In such automatic processing, the processing can be executed under a replenishment of a replenishing solution to each processing solution according to the processed amount or the working time. It is also possible to achieve an automatic replenishment, by detecting an electrical conductivity by a sensor. Also there may be used so-called disposable processing method in which the processing is executed with a substantially unused processing solution. The present invention, being free from concerns for a time-dependent loss of developability resulting from carbon dioxide gas or a loss in the printing durability resulting from the developing solution, is advantageously applicable to any of these automatic developing apparatus.

The planographic printing plate thus obtained may be subjected to a printing process after coating, if desired, of a desensitizing gum, but a burning process is executed in case a longer printing run length is desired.

In case of burning a planographic printing plate, there is preferably executed, prior to the burning, a process with a counter-etching solution as described in JP-B Nos. 61-2518 and 55-28062 and JP-A Nos. 62-31859 and 61-159655.

For such process, there can be used a method of coating the counter-etching solution on the planographic printing plate with a sponge or a cotton pad, or immersing the printing plate in a vat filled with the counter-etching

solution, or coating with an automatic coater. Also a more preferable result can be provided by making the coating amount uniform with a squeezee or a squeezing roller after the coating. The coating amount of the counter-etching solution is generally within a range of 0.03 to 0.8 g/$m^2$ (dry weight).

The planographic printing plate coated with the counter-etching solution is heated, after drying if necessary, to a high temperature by a burning processor (for example a burning processor Trad name: "BP-1300" supplied by Fuji Photo Film Co., Ltd.). The temperature and time of heating in such operation depend on the kind of components constituting the image, but are preferably in ranges of 180 to 300°C and 1 to 20 minutes.

The planographic printing plate after the burning process may be suitably subjected to conventional processes such as rinsing and gumming, but so-called desensitizing process such as gumming may be dispensed with in case a counter-etching solution including a water-soluble polymer compound is used.

The planographic printing plate utilizing the photosensitive composition of the invention in the image recording layer, being excellent in the printing durability and the screen dot reproducibility, can provide a large number of prints of a high quality in a printing operation for example on an offset printing press.

## EXAMPLES

In the following, the present invention will be clarified in more details by examples thereof, but the scope of the invention is not limited by such examples. Examples 1-1 - 1-5, Comparative Examples 1-1, 1-2

### Preparation of substrate

A melt of an aluminum alloy JIS A1050, containing 99.5% or higher of aluminum, 0.30 % of Fe, 0.10 % of Si, 0.02 % of Ti and 0.013 % of Cu, was subjected to a purifying process and cast. The purifying process was conducted by a degassing in order to eliminate unnecessary gas such as hydrogen in the melt, and by a ceramic tube filtration. The casting was conducted by a DC casting. A solidified cast block of a thickness of 500 mm was surfacially scraped off by 10 mm from the surface, and was subjected to a homogenization process for 10 hours at 550°C in order to avoid growth of intermetal compounds.

It was then subjected to a hot rolling at 400°C, an intermediate annealing for 60 seconds at 500°C in a continuous annealing oven, and a cold rolling to obtain a rolled aluminum plate of a thickness of 0.30 mm. A roughness of rolling rollers was so controlled as to obtain a center-line averaged surface roughness Ra of 0.2 μm after the cold rolling. Thereafter, a process by a tension leveler was executed in order to improve the flatness.

Then a surface treatment was conducted in order to obtain a substrate for a planographic printing plate.

The aluminum plate was at first subjected to a degreasing with a 10 % aqueous solution of sodium aluminate for 30 seconds at 50°C in order to remove the rolling oil on the surface, then neutralized with a 30 % aqueous solution of sulfuric acid for 30 seconds at 50°C, to achieve desmutting.

Then there was conducted so-called graining, for making a rough surface on the substrate, in order to improve the adhesion between the substrate and the recording layer and to provide a non-image portion with a water holding property. An aqueous solution containing nitric acid at 1% and aluminum nitrate at 0.5% was maintained at 45°C, and, while the aluminum web was carried through the aqueous solution, an electrolytic graining was executed by providing an anode-side electricity of 240 C/$dm^2$ from an indirect electric power supply cell with an AC current of a current density of 20 A/$dm^2$ and a duty ratio 1:1. Then an etching was conducted with a 10 % aqueous solution of sodium aluminate for 30 seconds at 50°C and a neutralization was conducted with a 30 % aqueous solution of sulfuric acid for 30 seconds at 50°C to achieve desmutting.

Then an oxide film was formed on the substrate by anodizing, in order to improve the abrasion resistance, the chemical resistance and the water holding property. A 20 % aqueous solution of sulfuric acid was used at 35°C as an electrolyte, and, while the aluminum web was carried through the electrolyte, an electrolytic process was executed with a DC current of 14 A/$dm^2$ from an indirect electric power supply cell thereby forming an anodic oxide film of 2.5 g/$m^2$. The substrate thus prepared had a center-line surface roughness Ra of 0.5 μm.

### Recording layer

Synthesis example: Synthesis of binder polymer (P-2)

In a 1000 mL three-necked flask equipped with a condenser and an agitator, 175 g of 1-methoxy-2-propanol were charged and heated to 70°C. Under a nitrogen flow, 175 g of a 1-methoxy-2-propanol solution containing 18.1 g of methacrylic acid, 69.7 g of t-butyl methacrylate and 0.673 g of V-59 (trade name, manufactured by Wako Pure Chemicals Industries, Ltd.) were dropwise added over a period of 2 hours and a half. Reaction was further executed for 2 hours at 70°C. The reaction mixture, after cooling to the room temperature, was poured into 3 L of water to precipitate a polymer. The polymer was collected by filtration, then washed and dried to obtain 83.0 g of a base polymer

compound (P-2) which is a precursor of a binder polymer (P-2). A weight-averaged molecular weight, measured with gel permeation chromatography (GPC) utilizing polystyrene as a standard substance, was 121,000. Also an acid value measured by a titration was 2.30 meq/g.

Then, in a 1000 mL three-necked flask equipped with a condenser and an agitator, 80 g of the base polymer compound (P-2) and 1 g of p-methoxyphenol were charged and dissolved in 320 g of dimethylsulfoxide, and 48.0 g of 1,8-diazabicyclo[5,4,0] -7-undecene were dropwise added with a dropping funnel. After agitation for 30 minutes at the room temperature, 19.5 g of 3-bromomethyl methacrylate were dropwise added, and the reaction mixture was agitated for 8 hours at 60°C. The reaction mixture, after cooling to the room temperature, was poured into 3 L of water to precipitate a polymer. The polymer was collected by filtration, then washed and dried to obtain 72 g of a binder polymer (P-2). A weight-averaged molecular weight, measured with gel permeation chromatography (GPC) utilizing polystyrene as a standard substance, was 128,000. Also an acid value measured by a titration was 1.01 meq/g. A following structure was confirmed from a difference in the acid value between the base polymer compound (P-2) and the binder polymer (P-2) and from $^1$H-NMR.

Binder polymer (P-2)

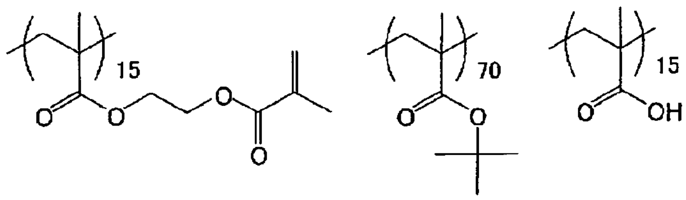

Then, a following recording layer coating liquid 1 was prepared, was coated with a wire bar on the aluminum plate subjected to the above-described surface treatment, and dried in a hot air drying apparatus for 45 seconds at 115°C to form a photosensitive layer as shown in Table 6. Similarly negative-working planographic printing plate precursors of Examples 1-2 to 1-5 and Comparative Examples 1-1 and 1-2. A coating amount after drying was within a range of 1.2 to 1.3 g/m$^2$.

Structures of an infrared absorbing agent [IR-1] and an onium salt [OS-1] used in the recording layer coating liquid 1 are shown in the following.

| | |
|---|---|
| Photosensitive layer coating liquid 1 infrared absorbing agent [IR-1] (following structure) | 0.08 g |
| onium salt [OS-1] (following structure) (amount in Table 6) dipentaerythritol hexaacrylate | 0.66 g |
| binder polymer (material shown in Table 6) | 1.33 g |
| naphthalenesulfonic acid salt of Victoria pure blue | 0.04 g |
| fluorinated surfactant (Megafac F176; Dai-Nippon Ink and Chemical Industries, Co. Ltd.) | 0.01 g |
| stearoyl methylamide | 0.02 g |
| methyl ethyl ketone | 14.0 g |
| methanol | 6.5 g |
| 1-methoxy-2-propanol | 10.0 g |

[IR-1]

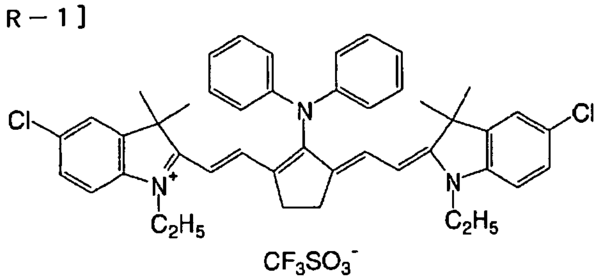

[OS-1]

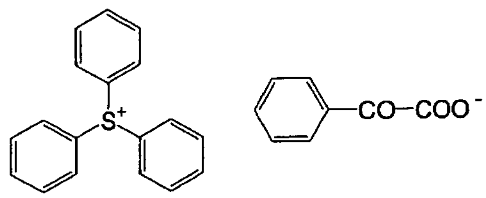

The binder polymers used in the foregoing were as follows:

(P-1)
allyl methacrylate/methacrylic acid (80/20)
weight-averaged molecular weight 123,000 (pKa ≅ 5)

(P-2)
methacryloylethyl methacrylate (obtained in the foregoing synthesis example)/t-butyl methacrylate/methacrylic acid (15/70/15)
weight-averaged molecular weight 128,000 (pKa ≅ 5)

(P-3)
methyl methacrylate/methacrylic acid (80/20)
weight-averaged molecular weight 114,000 (pKa ≅ 5)

Exposure

The obtained negative-working planographic printing plate precursor was exposed with a solid image (exposure over entire area) on an exposure apparatus (trade name: Trendsetter 3244VFS, manufactured by Creo Inc.) equipped with a 40 W water-cooled infrared semiconductor laser under conditions of an output of 9 W, an external drum revolution of 210 rpm, an energy of 100 $mJ/cm^2$ on the plate and a resolution of 175 lpi, for measuring the electrostatic capacitance rate of increase ratio. Also the planographic printing plate precursor was similarly exposed with screen dot images of 0.5 % to 99.5 %, for evaluating the screen dot reproducibility.

Electrostatic capacitance rate of increase ratio

As the binder polymer had an acidity pKa < 10 (carboxylic acid pKa ≅ 5), a model solution 1 of a following formulation (pH 11.8) was prepared for measuring the electrostatic capacitance rate of increase ratio.

A sample similar to the aforementioned planographic printing plate precursor was prepared and the photosensitive layer was subjected to a solid exposure. The photosensitive layer after the exposure (solid image portion) on the substrate surface was covered with a tape (Scotch tape; manufactured by 3M Co.) having an aperture of 1 x 1 cm, then placed together with a counter electrode (aluminum plate) into a container containing the following model solution (25°C), and an electrostatic capacitance under the application of a sinusoidal AC current of 1 V and 1 kHz between the electrodes (substrate of the planographic printing plate precursor and counter electrode) was measured with a 4263A LCR meter (manufactured by Hewlett Packard Inc.) at an interval of 1 second. A similar measurement was made also on an unexposed photosensitive layer.

An obtained electrostatic capacitance rate of increase ratio for the model solution 1 is shown in Table 6.

| Model solution 1 | |
|---|---|
| potassium hydroxide | 0.7 g |
| potassium carbonate | 1.7 g |
| polyethylene glycol mononaphthyl ether | 53 g |
| tetrasodium ethylenediamine tetraacetate | 1.5 g |
| water | 955 g |

Evaluation of screen dot reproducibility

The exposed screen dot images were developed with an automatic developing apparatus (trade name: LP-940H, manufactured by Fuji Photo Film Co.), using the model solution 1 as the developing solution, with a developing bath maintained at 30°C. Also for a finisher there was used FN-6 (trade name: manufactured by Fuji Photo Film Co.) diluted 1:1 with water.

The developed screen dot images were evaluated in following 5 steps by observation under an optical microscope of a magnification of 100 times. Obtained results are shown in Table 6:

5 : 0.5 % to 99.5 % faithfully reproduced
4 : 1 % to 99 % reproduced
3 : 2 % to 98 % reproduced, lower limit of acceptable range
2 : 3 % to 97 % reproduced, practically not acceptable
1 : a level not reaching level 2.

Table 6

| | Photosensitive layer coating liquid | | Electrostatic capacitance increase rate ratio | Screen dot reproducibility |
|---|---|---|---|---|
| | onium salt (OS-1) amount | binder | | |
| Ex. 1-1 | 0.1 | P-1 | 0.67 | 3 |
| Ex. 1-2 | 0.2 | P-1 | 0.45 | 4 |
| Ex. 1-3 | 0.4 | P-1 | 0.35 | 4 |
| Ex. 1-4 | 0.2 | P-2 | 0.25 | 5 |
| Ex. 1-5 | 0.4 | P-2 | 0.05 | 5 |
| Comp. Ex. 1-1 | 0.05 | P-1 | 0.85 | 2 |
| Comp.Ex.1-2 | 0.2 | P-3 | 0.96 | 1 |

As will be apparent from Table 6, the planographic printing plate precursors of Examples 1-1 to 1-5, having the electrostatic capacitance rate of increase ratio of 0.7 or less were superior in the dot reproducibility.

Also these evaluations indicate that the electrostatic capacitance rate of increase ratio was improved in case the content of the onium salt, serving as the radical generating agent, is higher or in case of using the polymer binder having plural polymerizable unsaturated groups.

Example 1-6

On the recording layer of the planographic printing plate precursor obtained in the example 1-2, a following overcoat layer coating liquid was coated with a slide hopper, and was dried for 75 seconds at 120°C in a hot air drying apparatus to obtain a planographic printing plate precursor. The overcoat layer had a coating amount of 2.3 g/m$^2$.

| | |
|---|---|
| Overcoat layer coating liquid polyvinyl alcohol (saponification degree: 98.5 mol%, polymerization degree: 500) | 2.5 g |
| polyvinylpyrrolidone (K30, manufactured by Tokyo Kasei Kogyo Co., molecular weight 40,000) | 0.5 g |

(continued)

| | |
|---|---|
| nonionic surfactant (trade name: EMAREX NP-10, manufactured by Nippon Emulsion Co.) | 0.05 g |
| ion-exchanged water | 96.95 g |

The obtained planographic printing plate precursor was exposed under a condition same as that in the examples 1-1 to 1-5, then, after the removal of the overcoat layer, was subjected to an image formation and an evaluation as in the examples 1-1 to 1-5. The electrostatic capacitance rate of increase ratio was 0.10, and the screen dot reproducibility was a level 5.
These results indicates that the effect of the invention is further enhanced by forming an overcoat layer on the recording layer of the invention.

Examples 1-7, 1-8

A planographic printing plate precursor of an example 1-7 was obtained in the same manner as in the example 1-2, except that the recording layer coating liquid 1 was changed to a following recording layer coating liquid 2.
Also a planographic printing plate precursor of an example 1-8 was obtained by forming an overcoat layer of the example 1-6 on the planographic printing plate precursor of the example 1-7.
A structure of a triazine compound [T-1] used in the recording layer coating liquid is shown in the following.

| | |
|---|---|
| Photosensitive layer coating liquid 2 infrared absorbing agent [IR-1] | 0.08 g |
| onium salt [OS-1] | 0.1 g |
| triazine compound [T-1] | 0.1 g |
| dipentaerythritol hexaacrylate | 0.66 g |
| binder polymer (P-2) | 1.33 g |
| naphthalenesulfonic acid salt of Victoria pure blue | 0.04 g |
| fluorinated surfactant (Megafac F176; Dai-Nippon Ink and Chemical Industries, Co. Ltd.) | 0.01 g |
| stearoyl methylamide | 0.02 g |
| methyl ethyl ketone | 14.0 g |
| methanol | 6.5 g |
| 1-methoxy-2-propanol | 10.0 g |

Triazine compound [T-1]

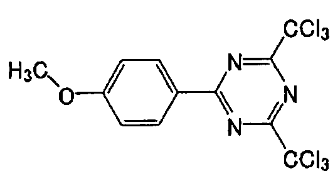

The obtained planographic printing plate precursors of the examples 1-7, 1-8 were subjected to an image formation as in the example 1-6 and an evaluation as in the examples 1-1 to 1-5.
The example 1-7 had a electrostatic capacitance rate of increase ratio of 0.53, and a screen dot reproducibility of a level 4.
Also the example 1-8, provided with an overcoat layer, had a electrostatic capacitance rate of increase ratio of 0.12, and a screen dot reproducibility of a level 5.
These results indicate that similar effects can be obtained in case of using a triazine compound as the radical generating agent, instead of the onium salt.

Example 1-9

A planographic printing plate precursor was obtained by a recording layer coating liquid which was prepared in the same manner as in the example 1-2 except that the binder polymer (P-1) used therein was replaced by a binder polymer (P-4) synthesized in a following manner.

Synthesis example of binder polymer (P-4)

In a 1000 mL three-necked flask equipped with a condenser and an agitator, 175 g of 1-methoxy-2-propanol were charged and heated to 70°C. Under a nitrogen flow, 175 g of a 1-methoxy-2-propanol solution containing 37.9 g of sulfamoylphenyl methacrylamide, 30.2 g of methyl methacrylate, 17.3 g of methacrylic acid and 0.673 g of V-59 (trade name, manufactured by Wako Pure Chemicals Industries, Ltd.) were dropwise added over a period of 2 hours and a half. Reaction was further executed for 2 hours at 70°C. The reaction mixture, after cooling to the room temperature, was poured into 3 L of water to precipitate a polymer. The polymer was collected by filtration, then washed and dried to obtain 80 g of a base polymer compound (P-4) which is a precursor of a binder polymer (P-4). A weight-averaged molecular weight, measured with gel permeation chromatography (GPC) utilizing polystyrene as a standard substance, was 130,000.

Then, in a 1000 mL three-necked flask equipped with a condenser and an agitator, 80 g of the base polymer compound (P-4) and 1 g of p-methoxyphenol were charged and dissolved in 320 g of dimethylsulfoxide, and 48.0 g of 1,8-diazabicyclo[5,4,0]-7-undecene were dropwise added with a dropping funnel. After agitation for 30 minutes at the room temperature, 36.7 g of 3-bromomethyl methacrylate were dropwise added, and the reaction mixture was agitated for 8 hours at 60°C. The reaction mixture, after cooling to the room temperature, was poured into 3 L of water to precipitate a polymer. The polymer was collected by filtration, then washed and dried to obtain 94 g of a binder polymer (P-4). A weight-averaged molecular weight, measured with gel permeation chromatography (GPC) utilizing polystyrene as a standard substance, was 145,000. The obtained binder polymer (P-4) is estimated to have a following structure.

Binder polymer (P-4)

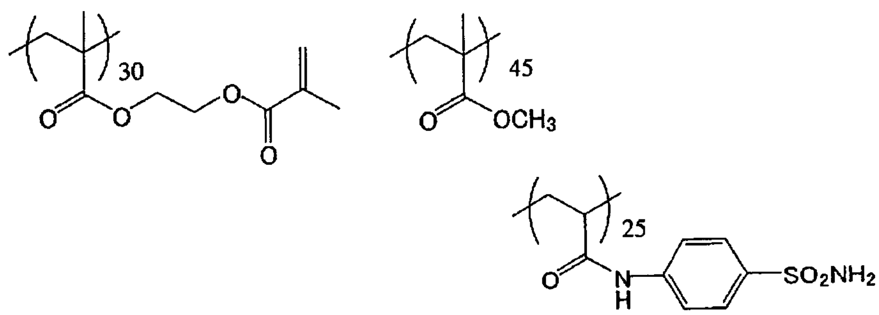

Then an exposure, a measurement of the electrostatic capacitance rate of increase ratio and an evaluation of the screen dot reproducibility were executed under the conditions same as those in the examples 1-1 to 1-5. For the model solution and the developing solution for the evaluation of the screen dots, a following model solution 2 of a following formulation was used since the binder polymer had a pKa value of 9 or higher (sulfamoyl group pKa ≅ 11). Obtained results are shown in Table 7.

| Model solution 2 | |
|---|---|
| potassium hydroxide | 10 g |
| 1K potassium silicate (CAS-1312-76-1) | 50 g |
| tetrasodium ethylenediamine tetraacetate | 0.03 g |
| water | 970 g |

Comparative Example 1-3

A planographic printing plate precursor was obtained in the same manner as in the example 1-9 except that the amount of the onium salt was changed from 0.2 g to 0.05 g.

Then an exposure, a measurement of the electrostatic capacitance rate of increase ratio and an evaluation of the screen dot reproducibility were executed in the same manner as in the example 1-9. Obtained results are shown in Table 7.

Table 7

| | Photosensitive layer coating liquid | | Electrostatic capacitance increase rate ratio | Screen dot reproducibility |
|---|---|---|---|---|
| | onium salt (OS-1) amount | binder | | |
| Ex. 1-9 | 0.2 | P-4 | 0.35 | 4 |
| Comp. Ex. 1-3 | 0.05 | P-4 | 0.91 | 1 |

As will be apparent from Table 7, an excellent screen dot reproducibility can be obtained even in a photosensitive composition including a binder polymer with a pKa value of 9 or higher, as long as the electrostatic capacitance rate of increase ratio was 0.7 or less.

Example 2-1, Comparative Example 2-1

A following recording layer coating liquid 3 was prepared, was coated with a wire bar on a substrate prepared in the same manner as in the examples 1-1 to 1-5, and dried in a hot air drying apparatus for 45 seconds at 115°C to obtain negative-working planographic printing plate precursors of Example 2-1 and Comparative Example 2-1 as shown in Table 8. A coating amount after drying was within a range of 1.2 to 1.3 $g/m^2$.

In the recording layer coating liquid 3, there were used the aforementioned infrared absorbing agent [IR-1] and polymerization initiators shown in Table 8 (structures shown below).

| Photosensitive layer coating liquid 3 | |
|---|---|
| infrared absorbing agent [IR-1] | 0.08 g |
| polymerization initiator(in Table 8) (amount in Table 8) | |
| dipentaerythritol hexaacrylate | (amount in Table 8) |
| allyl methacrylate-methacrylic acid copolymer (molar ratio 80:20)(weight-averaged molecular weight 120,000) | (amount in Table 8) |
| naphthalenesulfonic acid salt of Victoria pure blue | 0.04 g |
| fluorinated surfactant (Trade name: Megafac F176; Dai-Nippon Ink and Chemical Industries, Co. Ltd.) | 0.01 g |
| stearoyl methylamide | 0.02 g |
| methyl ethyl ketone | 14.0 g |
| methanol | 6.5 g |
| 1-methoxy-2-propanol | 10.0 g |

Table 8

| | Photosensitive layer coating liquid | | | | Image gradation (γ) | Dot reproducibility |
|---|---|---|---|---|---|---|
| | polymerization initiator | | dipentaerythritol hexaacrylate (g) | allyl methacrylate/ methacrylic acid copolymer (mol.ratio 80: 20) (g) | | |
| | compound | content (g) | | | | |
| Ex. 2-1 | [B-1] | 0.4 | 1.00 | 1.0 | 6.0 | 5 |
| Comp.Ex 2-1 | [B-2] | 0.4 | 1.00 | 1.0 | 2.5 | 2 |

[B - 1]

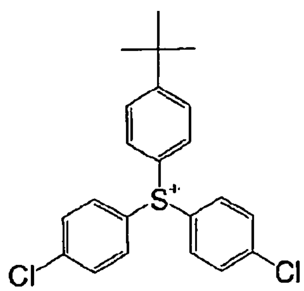

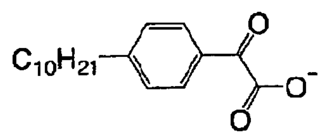

[B - 2]

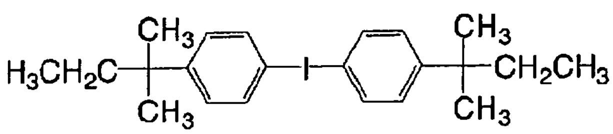

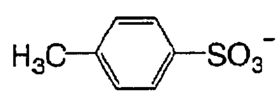

Image gradation (γ)

Each obtained negative-working planographic printing plate precursor was exposed on an exposure apparatus (trade name: Trendsetter 3244, manufactured by Creo Inc.) equipped with a 20 W water-cooled infrared semiconductor laser with energies on the plate changed at a rate of 1.25 times from 50 to 300 mJ/cm$^2$, then an image was formed by a following development process and a gradation of the image of each image recording layer was measured on a characteristic curve obtained from the exposure amount and the image density. Obtained results are shown in Table 8.

Exposure

The obtained negative-working planographic printing plate precursor was exposed on an exposure apparatus (trade name: Trendsetter 3244, manufactured by Creo Inc.) equipped with a 40 W water-cooled infrared semiconductor laser under conditions of an output of 9 W, an external drum revolution of 210 rpm, an energy of 100 mJ/cm$^2$ on the plate and a resolution of 175 lpi, with a solid image and screen dot images of 0.5 to 99.5 %.

Development process

The exposed screen dot images were developed with an automatic developing apparatus (trade name: LP-940H, manufactured by Fuji Photo Film Co.). As a developing solution there was used a 1:17 water-diluted solution (pH 11.1 at 25°C) of DV-2 (trade name, manufactured by Fuji Photo Film Co.). Also as a replenishing solution, there was used a 1:10 diluted solution of DV-2R (Trade name: manufactured by Fuji Photo Film Co.). The developing bath was maintained at 30°C. As a finisher there was used a 1:1 water-diluted solution of FN-6 (trade name: manufactured by Fuji Photo Film Co.).

Evaluation of screen dot reproducibility

The developed screen dot images were evaluated in the same manner as in the example 1-1. Results are shown in Table 8.

As will be apparent from Table 8, the planographic printing plate precursors of the example, 2-1, having a gradation ($\gamma$ value) of the image of at least 4, showed excellent screen dot reproducibility. Also these evaluation results indicate that the image gradation of the photosensitive composition becomes higher as the radical generating agent has a higher reactivity.

On the other hand, the planographic printing plate precursor of the comparative example 2-1, using a polymerization initiator of a relatively low reactivity, showed an image gradation outside the range of the invention, thus being inferior in the screen dot reproducibility.

Examples 3-1 - 3-5, Comparative Examples 3-1 - 3-3

A surface of a substrate prepared in the same manner as in the examples 1-1 to 1-5 was further subjected to a silicate process in order to secure the hydrophilicity in the non-image portion of the printing plate. The process was executed by passing the aluminum web through a 1.5 % aqueous solution of No.3 sodium silicate maintained at 70°C with a contact time of the aluminum web of 15 seconds, follwed by a rinsing with water. A deposition amount of Si was 10 mg/cm$^2$. The substrate thus prepared had a center-line surface roughness Ra of 0.25 $\mu$m.

Preparation of photosensitive (recording) layer

A following recording layer coating liquid 4 was prepared, was coated with a wire bar on an aluminum substrate prepared as explained above, and dried in a hot air drying apparatus for 45 seconds at 115°C to form a photosensitive layer, thereby obtaining a planographic printing plate precursor. A coating amount after drying was within a range of 1.2 to 1.3 g/m$^2$.

In this example, a polymer compound was the alkali soluble resin obtained in the foregoing synthesis example, and a radical polymerizable compound was a compound described in the foregoing example and another compound described later.

| Photosensitive layer coating liquid 4 | |
|---|---|
| alkali soluble resin: component (A) (compound in Table 9) | (amount in Table 9) |
| radical polymerizable compound: component (A) (compound in Table 9) | (amount in Table 9) |
| photothermal converting agent [IR-6]: component (B) | 0.10 g |
| onium salt compound: component (C) (compound in Table 9) | (amount in Table 9) |
| naphthalenesulfonic acid salt of Victoria pure blue | 0.05 g |
| fluorinated surfactant (Trade name: Megafac F176; Dai-Nippon Ink and Chemical Industries, Co. Ltd.) | 0.01 g |
| methyl ethyl ketone | 9.0 g |
| methanol | 10.0 g |
| 1-methoxy-2-propanol | 8.0 g |

Table 9

| | Polymerizable compound(component A) | | Onium salt (component C) | Binder polymer (component D) | Film hardness | | X1/X2 | print rung length |
|---|---|---|---|---|---|---|---|---|
| | specified alkali soluble resin | radical polymerizable compound | | | film hardness after exposure (X1) | film hardness before exposure (X2) | | |
| Ex. 3-1 | A-7 2.0 g | - | I-1 0.32 g | - | 0.61 GPa | 0.55 GPa | 1.11 | 41,000 |
| Ex. 3-2 | A-15 1.2 g | R-1 0.8 g | S-1 0.30 g | - | 0.65 GPa | 0.54 GPa | 1.20 | 45.000 |
| Ex. 3-3 | A-16 1.0 g | D-7 1.0 g | S-1 0.32 g | - | 0.70 GPa | 0.54 GPa | 1.30 | 59,000 |
| Ex. 3-4 | A-24 1.2 g | D-7 0.8 g | S-1 0.28 g | - | 0.60 GPa | 0.43 GPa | 1.40 | 71,000 |
| Ex. 3-5 | A-24 1.1 g | D-8 0.9 g | S-1 0.30 g | - | 0.70 GPa | 0.50 GPa | 1.40 | 75,000 |
| Comp.Ex.3-1 | - | R-1 1.0 g | S-1 0.30 g | B-1 1.0 g | 0.60 GPa | 0.60 GPa | 1.00 | 23,000 |
| Comp.Ex.3-2 | - | R-2 0.9 g | S-1 0.32 g | B-1 1.1 g | 0.70 GPa | 0.69 GPa | 1.01 | 25,000 |
| Comp.Ex.3-3 | - | D-8 0.9 g | S-1 0.30 g | B-1 1.1 g | 0.68 GPa | 0.65 GPa | 1.05 | 26,000 |

R-1: dipentaerythritol hexaacrylate

R-2: pentaerythritol tetraacrylate

B-1: benzyl methacrylate/methacrylic acid copolymer

(molar ratio = 82/18, weight-averaged molecular weight 102,000)

I R − 6

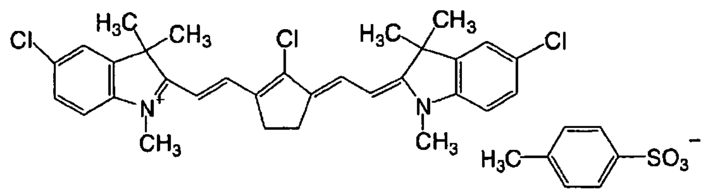

I − 1

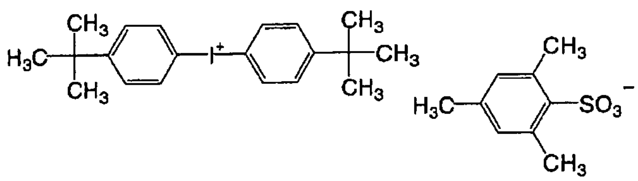

S − 1

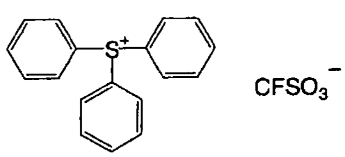

Exposure

Each obtained planographic printing plate precursor was exposed on an exposure apparatus (trade name: Trendsetter 3244, manufactured by Creo Inc.) equipped with a 40 W water-cooled infrared semiconductor laser under conditions of an output of 9 W, an external drum revolution of 210 rpm, an energy of 100 $mJ/cm^2$ on the plate and a resolution of 2400 dpi.

Evaluation of film hardness

A film hardness of each obtained planographic printing plate precursor was measured with a press-in apparatus (trade name: Triboscope, manufactured by Hysitron Inc.), which was mounted on an atomic force microscope (AFM) (trade name: SPA300, manufactured by Seiko Instruments Inc.). Table 9 shows a film hardness (X1) of an exposed area after exposure, a film hardness (X2) before exposure and a film hardness ratio (X1/X2).

Development process

After the exposure, a development process was executed with an automatic developing apparatus (trade name: Stablon 900N, manufactured by Fuji Photo Film Co.). For a developing solution in the developing bath and a replenishing solution, there was used a 1:1 water-diluted solution of DN-3C (trade name, manufactured by Fuji Photo Film Co.). The developing bath was maintained at 30°C. As a finisher there was used a 1:1 water-diluted solution of FN-6 (trade name: manufactured by Fuji Photo Film Co.).

Evaluation of printing durability

A printing operation was executed with a printing press (trade name: Lithrone, manufactured by Komori Corporation). In this operation, the printing durability was evaluated by visually measuring a number of prints having a

sufficient ink density. Obtained results are also shown in Table 9. The planographic printing plates obtained in the comparative examples 3-1 to 3-3 were also evaluated for the printing durability, and obtained results are also shown in Table 9.

Results in Table 9 indicate that an excellent printing durability was attained in the planographic printing plate precursors using, as the photosensitive layer, the image recording material of the invention, having a ratio X1/X2 of at least 1.1.

Examples 3-6 - 3-10, Comparative Examples 3-4 - 3-5

Preparation of substrate

An aluminum plate of a thickness of 0.30 mm was grained with a nylon brush and an aqueous suspension of pumice stone of 400 mesh, and was rinsed well with water. The plate was then etched by immersion in an 10 % by weight aqueous solution of sodium hydroxide for 60 seconds at 70°C, then washed under running water, neutralized with a 20 % by weight solution of nitric acid and rinsed with water. Then it was subjected to an electrolytic graining process in a 1 % by weight aqueous solution of nitric acid, using a sinusoidal AC current of $V_A$ = 12.7 V and an anode electricity of 160 C/dm$^2$. The surface roughness Ra was 0.6 μm. It was then subjected to a desmutting by an immersion in a 30 % by weight aqueous solution of sulfuric acid for 2 minutes at 55°C, and to an anodizing process in a 20 % by weight aqueous solution of sulfuric acid for 2 minutes with a current density of 2 A/dm$^2$ in such a manner as to obtain an anodized film of 2.7 g/m$^2$.

Preparation of undercoat layer

A liquid composition (sol liquid) of SG method was prepared in the following manner.

Sol liquid composition

| | |
|---|---|
| methanol | 130 g |
| water | 20 g |
| 85 % by weight phosphoric acid | 16 g |
| tetraethoxysilane | 50 g |
| 3-methacryloxypropyl trimethoxysilane | 60 g |

The above components of the sol liquid composition were mixed and agitated. Heat generation was observed in about 5 minutes. After a reaction for 60 minutes, the content was transferred to another container and was added with 3000 g of methanol to obtain a sol liquid.

The sol liquid was diluted with methanol/ethylene glycol = 9/1 (weight ratio), then was coated on a substrate so as to obtain a Si amount thereon of 3 mg/m$^2$, and was dried for 1 minute at 100°C.

A following recording layer coating liquid 5 was prepared, was coated with a wire bar on the above-mentioned undercoated aluminum substrate, and dried in a hot air drying apparatus for 45 seconds at 115°C to obtain a planographic printing plate precursor. A coating amount after drying was within a range of 1.2 to 1.3 g/m$^2$.

An alkali soluble resin B-2 used in the comparative example 3-2 was a methyl methacrylate/methacrylic acid copolymer (molar ratio = 75/22, weight-averaged molecular weight 80,000).

Photosensitive layer coating liquid 5

alkali soluble resin: component (A) (compound in Table 10) (amount in Table 10)

radical polymerizable compound: component (A) (compound in Table 10) (amount in Table 10)

photothermal converting agent [IR-2]: component (B) 0.09 g

onium salt compound: component (C) (compound in Table 10) (amount in Table 10)

naphthalenesulfonic acid salt of Victoria pure blue 0.04 g

fluorinated surfactant (Trade name: Megafac F176; Dai-

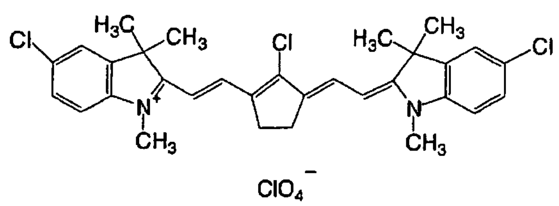

Nippon Ink and Chemical Industries, Co. Ltd.) 0.01 g

methyl ethyl ketone 9.0 g

methanol 10.0 g

1-methoxy-2-propanol 8.0 g

IR-2

Table 10

| | Polymerizable compound (component A) | | Onium salt (component C) | Binder polymer (component D) | Film hardness | | X1/X2 | print rung length |
|---|---|---|---|---|---|---|---|---|
| | specified alkali soluble resin | radial polymerizable compound | | | film hardness after exposure (X1) | film hardness before exposure (X2) | | |
| Ex. 3-6 | A-14 2.0 g | - | I-1 0.31 g | - | 0.70 GPa | 0.53 GPa | 1.21 | 40,000 |
| Ex. 3-7 | A-12 1.2 g | R-2 0.8 g | S-1 0.29 g | - | 0.65 GPa | 0.50 GPa | 1.30 | 44.000 |
| Ex. 3-8 | A-16 1.1 g | D-6 0.9 g | S-1 0.30 g | - | 0.78 GPa | 0.56 GPa | 1.39 | 60,000 |
| Ex. 3-9 | A-24 0.9 g | D-7 1.1 g | S-1 0.30 g | - | 0.73 GPa | 0.52 GPa | 1.40 | 75,000 |
| Ex. 3-10 | A-25 1.0 g | D-9 1.0 g | S-1 0.31 g | - | 0.75 GPa | 0.50 GPa | 1.50 | 74,000 |
| Comp.Ex.3-4 | - | R-2 0.8 g | S-1 0.29 g | B-1 1.2 g | 0.62 GPa | 0.60 GPa | 1.03 | 23,000 |
| Comp.Ex.3-5 | - | D-6 0.9 g | S-1 0.30 g | B-1 1.1 g | 0.60 GPa | 0.58 GPa | 1.04 | 27,000 |

R-1: dipentaerythritol hexaacrylate

R-2: pentaerythritol tetraacrylate

B-1: benzyl methacrylate/methacrylic acid copolymer

(molar ratio = 82/18, weight-averaged molecular weight 102,000)

Exposure

Each obtained planographic printing plate precursor was exposed on an exposure apparatus (trade name: Luxel T-9000CTP, manufactured by Fuji Photo Film Co.) equipped with a multi-channel laser head, under conditions of an output of 250 mW per beam, an external drum revolution of 800 rpm, and a resolution of 2400 dpi.

Evaluation of film hardness

A film hardness of each obtained planographic printing plate precursor before and after exposure was measured under conditions same as those in the examples 3-1 to 3-5. Table 10 shows a film hardness (X1) of an exposed area after exposure, a film hardness (X2) before exposure and a film hardness ratio (X1/X2).

Development process

After the exposure, a development process was executed with an automatic developing apparatus (trade name: Stablon 900N, manufactured by Fuji Photo Film Co.). For a developing solution in the developing bath and a replenishing solution, there was used a 1:8 water-diluted solution of DP-4 (trade name, manufactured by Fuji Photo Film Co.). The developing bath was maintained at 30°C. As a finisher there was used a 1:2 water-diluted solution of GU-7 (trade name: manufactured by Fuji Photo Film Co.).

Evaluation of printing durability

A printing operation was executed with a printing press (trade name: SOR-KZ, manufactured by Heidelberg GmbH). In this operation, the printing durability was evaluated by visually measuring a number of prints having a sufficient ink density. Obtained results are also shown in Table 10.

Results in Table 10 indicate that an excellent printing durability was attained in the planographic printing plate precursors using, as the photosensitive layer, the image recording material of the invention.

Examples 3-11 - 3-15, Comparative Examples 3-6 - 3-7

Preparation of undercoat layer

A following coating liquid was coated with a wire bar on an aluminum substrate used in the examples 3-1 to 3-5, and was dried for 30 seconds at 90°C in a hot air drying apparatus. A coating amount after drying was 10 mg/$m^2$.

Undercoating liquid

| | |
|---|---|
| ethyl methacrylate/sodium 2-acrylamide-2-methyl-1-propanesulfonate copolymer (molar ratio 75:15) | 0.11 g |
| 2-aminoethylphosphonic acid | 0.1 g |
| methanol | 50 g |
| ion-exchanged water | 50 g |

A recording layer coating liquid 6 of a following composition was coated with a wire bar on thus processed aluminum substrate, and dried in a hot air drying apparatus for 45 seconds at 115°C to obtain a planographic printing plate precursor. A coating amount after drying was within a range of 1.2 to 1.3 g/$m^2$.

| Photosensitive layer coating liquid 6 | |
|---|---|
| alkali soluble resin: component (A) (compound in Table 11) | (amount in Table 11) |
| radical polymerizable compound: component (A) (compound in Table 11) | (amount in Table 11) |
| photothermal converting agent [IR-1]: component (B) | 0.09 g |
| onium salt compound: component (C) (compound in Table 11) | (amount in Table 11) |
| naphthalenesulfonic acid salt of Victoria pure blue | 0.04 g |
| fluorinated surfactant (Megafac F176; Dai-Nippon Ink and Chemical Industries, Co. Ltd.) | 0.01 g |

(continued)

| Photosensitive layer coating liquid 6 | |
|---|---|
| methyl ethyl ketone | 9.0 g |
| methanol | 10.0 g |
| 1-methoxy-2-propanol | 8.0 g |

Table 11

| | Polymerizable compound (component A) | | Onium salt (component C) | Binder polymer (component D) | Film hardness | | X1/X2 | print rung length |
|---|---|---|---|---|---|---|---|---|
| | specified alkali soluble resin | radial polymerizable compound | | | film hardness after exposure (X1) | film hardness before exposure (X2) | | |
| Ex. 3-11 | A-10 2.0 g | - | I-1 0.30 g | - | 0.65 GPa | 0.54 GPa | 1.20 | 45,000 |
| Ex. 3-12 | A-11 1.1 g | R-3 0.9 g | S-1 0.32 g | - | 0.68 GPa | 0.57 GPa | 1.19 | 50.000 |
| Ex. 3-13 | A-10 1.1 g | D-10 0.9 g | I-1 0.32 g | - | 0.75 GPa | 0.54 GPa | 1.39 | 71,000 |
| Ex. 3-14 | A-25 1.2 g | D-7 0.8 g | S-1 0.31 g | - | 0.71 GPa | 0.47 GPa | 1.51 | 72,000 |
| Ex. 3-15 | A-16 1.2 g | D-7 0.8 g | S-1 0.33 g | - | 0.73 GPa | 0.49 GPa | 1.49 | 71,000 |
| Comp.Ex.3-6 | - | R-3 0.9 g | S-1 0.32 g | B-1 1.1 g | 0.61 GPa | 0.59 GPa | 1.03 | 24,000 |
| Comp.Ex.3-7 | - | D-10 0.9 g | I-1 0.32 g | B-1 1.1 g | 0.55 GPa | 0.53 GPa | 1.04 | 35,000 |

R-2: pentaerythritol tetraacrylate

R-3:

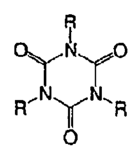

R: 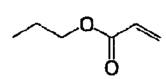

B-1: benzyl methacrylate/methacrylic acid copolymer

(molar ratio = 82/18, weight-averaged molecular weight 102,000)

Each obtained planographic printing plate precursor was subjected to measurements of a film hardness before

and after exposure and of a surface contact angle, under conditions same as those in the examples 3-1 to 3-5. Also it was subjected to a printing durability test by a development process and a printing operation under conditions same as those in the examples 3-1 to 3-5, except that a 1:4 water-diluted solution of CA-1 (trade name, manufactured by Fuji Photo Film Co.) was used as the developing solution. Obtained results are shown in Table 11.

Results in Table 11 indicate that an excellent printing durability was attained in the planographic printing plate precursors using, as the photosensitive layer, the image recording material of the invention.

Examples 3-16 - 3-20, Comparative Examples 3-8 - 3-9

A photosensitive layer was formed on an aluminum substrate in the same manner as in the examples 3-1 to 3-5 except that the components (A), (C) and (D) were changed to compounds and amounts shown in Table 12, and a 3 % by weight aqueous solution of polyvinyl alcohol (saponification degree: 86.5 to 89 mol%, polymerization degree: 1000) was coated so as to obtain a coating weight of 2 $g/m^2$ after drying, and was dried for 2 minutes at 100°C to obtain a planographic printing plate precursor having a protective layer on a photosensitive layer.

Each obtained planographic printing plate precursor was subjected to a printing durability test by an exposure, a a development process and a printing operation under conditions same as those in the examples 3-1 to 3-5. It was also subjected to a measurement of the film hardness before and after exposure, under conditions same as those in the examples 3-1 to 3-5. Obtained results are shown in Table 12.

Table 12

| | Polymerizable compound (component A) | | Onium salt (component C) | Binder polymer (component D) | Film hardness | | X1/X2 | print rung length |
|---|---|---|---|---|---|---|---|---|
| | specified alkali soluble resin | radial polymerizable compound | | | film hardness after exposure (X1) | film hardness before exposure (X2) | | |
| Ex. 3-16 | A-14 2.0 g | - | I-1 0.30 g | - | 0.65 GPa | 0.54 GPa | 1.20 | 41,000 |
| Ex. 3-17 | A-12 1.1 g | R-1 0.9 g | S-1 0.32 g | - | 0.65 GPa | 0.50 GPa | 1.30 | 55.000 |
| Ex. 3-18 | A-10 1.2 g | D-9 0.8 g | S-1 0.32 g | - | 0.73 GPa | 0.52 GPa | 1.40 | 69,000 |
| Ex. 3-19 | A-25 1.2 g | D-9 0.8 g | S-1 0.32 g | - | 0.71 GPa | 0.47 GPa | 1.51 | 85,000 |
| Ex. 3-20 | A-16 1.2 g | D-10 0.8 g | S-1 0.31 g | - | 0.75 GPa | 0.54 GPa | 1.39 | 83,000 |
| Comp.Ex.3-8 | - | R-1 0.9 g | S-1 0.32 g | B-1 1.1 g | 0.62 GPa | 0.61 GPa | 1.02 | 31,000 |
| Comp.Ex.3-9 | - | D-10 0.8 g | S-1 0.31 g | B-1 1.2 g | 0.58 GPa | 0.55 GPa | 1.05 | 32,000 |

R-1: dipentaerythritol hexaacrylate

R-2: pentaerythritol tetraacrylate

B-1: benzyl methacrylate/methacrylic acid copolymer

(molar ratio = 82/18, weight-averaged molecular weight 102,000)

Results in Table 12 indicate that an excellent printing durability was attained in the planographic printing plate

precursors using, as the photosensitive layer, the image recording material of the invention, and that the printing durability was improved by the formation of the protective layer.

Examples 4-1 - 4-15, Comparative Examples 4-1 - 4-7

Planographic printing plate precursors of examples 4-1 to 4-5 and comparative examples 4-1 to 4-3 were prepared in procedures same as those in the examples 3-1 to 3-5 and the comparative examples 3-1 to 3-3 except that the components (A), (C) and (D) were changed to compounds and amounts described in Table 13. Also planographic printing plate precursors of examples 4-6 to 4-10 and comparative examples 4-4 to 4-5 were prepared in procedures same as those in the examples 3-6 to 3-10 and the comparative examples 3-4 to 3-5 except that the components (A), (C) and (D) were changed to compounds and amounts described in Table 14. Further, planographic printing plate precursors of examples 4-11 to 4-15 and comparative examples 4-6 to 4-7 were prepared in procedures same as those in the examples 3-11 to 3-15 and the comparative examples 3-6 to 3-7 except that the components (A), (C) and (D) were changed to compounds and amounts described in Table 15. The precursors were exposed in a similar manner, and subjected to an evaluation of a surface contact angle. They were also subjected to a development process and an evaluation of a printing durability in a similar manner. Obtained results are shown in Tables 13 to 15.

Evaluation of surface contact angle

On a recording layer of each obtained planographic printing plate precursor, water was dropped in the air, and a contact angle was measured with a contact angle meter (trade name: CA-Z, Kyowa Kaimen Kagaku Co.). Tables 13 to 15 show a surface contact angle (Y1) of an exposed area after exposure, a surface contact angle (Y2) before exposure, and a ratio (Y1/Y2) of the surface contact angles.

Table 13

| | Polymerizable compound (component A) | | Onium salt (component C) | Binder polymer (component D) | Surface contact angle | | Y1/Y2 | print rung length |
|---|---|---|---|---|---|---|---|---|
| | specified alkali soluble resin | radial polymerizable compound | | | surface contact angle after exposure (Y1) | surface contact angle before exposure (Y2) | | |
| Ex. 4-1 | A-11 2.0 g | - | I-1 0.30 g | - | 73.4 | 62.2 | 1.18 | 42,000 |
| Ex. 4-2 | A-10 1.2 g | R-3 0.8 g | S-1 0.31 g | - | 71.0 | 54.6 | 1.30 | 51.000 |
| Ex. 4-3 | A-24 1.2 g | D-7 0.8 g | S-1 0.32 g | - | 75.2 | 53.3 | 1.41 | 53,000 |
| Ex. 4-4 | A-16 1.1 g | D-8 0.9 g | S-1 0.32 g | - | 76.5 | 55.4 | 1.38 | 65,000 |
| Ex. 4-5 | A-25 1.1 g | D-10 0.9 g | S-1 0.32 g | - | 72.3 | 54.8 | 1.32 | 69,000 |
| Comp.Ex.4-1 | - | R-2 0.9 g | I-1 0.31 g | B-1 1.1 g | 57.3 | 56.2 | 1.02 | 21,000 |
| Comp.Ex.4-2 | - | R-3 0.9 g | S-1 0.29 g | B-1 1.2 g | 61.5 | 58.6 | 1.05 | 23,000 |
| Comp.Ex.4-3 | | D-8 0.9 g | S-1 0.32 g | B-1 1.1 g | 60.4 | 57.5 | 1.05 | 25,000 |

R-1: dipentaerythritol hexaacrylate

R-2: pentaerythritol tetraacrylate

R-3: the compound shown in Table 11

B-1: benzyl methacrylate/methacrylic acid copolymer

(molar ratio = 82/18, weight-averaged molecular weight 102,000)

Table 14

| | Polymerizable compound(component A) | | Onium salt (component C) | Binder polymer (component D) | Surface contact angle | | Y1/Y2 | print rung length |
|---|---|---|---|---|---|---|---|---|
| | specified alkali soluble resin | radial polymerizable compound | | | surface contact angle after exposure (Y1) | surface contact angle before exposure (Y2) | | |
| Ex. 4-6 | A-18 2.0 g | - | S-1 0.31 g | - | 82.2 | 63.2 | 1.30 | 44,000 |
| Ex. 4-7 | A-20 1.1 g | R-1 0.9 g | I-1 0.32 g | - | 73.3 | 55.5 | 1.32 | 53.000 |
| Ex. 4-8 | A-16 1.1 g | D-3 0.9 g | S-1 0.31 g | - | 78.9 | 57.2 | 1.38 | 62,000 |
| Ex. 4-9 | A-24 1.2 g | D-7 0.8 g | S-1 0.32 g | - | 87.7 | 60.5 | 1.45 | 70,000 |
| Ex. 4-10 | A-25 1.2 g | D-10 0.8 g | S-1 0.32 g | - | 79.2 | 56.2 | 1.41 | 71,000 |
| Comp.Ex.4-4 | - | R-1 0.9 g | S-1 0.32 g | B-1 1.1 g | 55.9 | 54.3 | 1.03 | 25,000 |
| Comp.Ex.4-5 | - | D-3 0.9 g | S-1 0.31 g | B-1 1.1 g | 58.5 | 55.7 | 1.05 | 27,000 |

R-1: dipentaerythritol hexaacrylate

R-2: pentaerythritol tetraacrylate

B-1: benzyl methacrylate/methacrylic acid copolymer

(molar ratio = 82/18, weight-averaged molecular weight 102,000)

Table 15

| | Polymerizable compound(component A) | | Onium salt (component C) | Binder polymer (component D) | Surface contact angle | | Y1/Y2 | print rung length |
|---|---|---|---|---|---|---|---|---|
| | specified alkali soluble resin | radial polymerizable compound | | | surface contact angle after exposure (Y1) | surface contact angle before exposure (Y2) | | |
| Ex. 4-11 | A-20 2.0 g | - | S-1 0.32 g | - | 73.5 | 55.3 | 1.33 | 41,000 |
| Ex. 4-12 | A-10 1.2 g | R-3 0.8 g | I-1 0.32 g | - | 73.1 | 56.2 | 1.30 | 51.000 |
| Ex. 4-13 | A-16 0.9 g | D-1 1.1 g | S-1 0.31 g | - | 85.5 | 60.2 | 1.42 | 60,000 |
| Ex. 4-14 | A-24 1.0 g | D-9 1.0 g | S-1 0.31 g | - | 80.5 | 58.3 | 1.38 | 73,000 |
| Ex. 4-15 | A-25 1.1 g | D-7 0.9 g | S-1 0.32 g | - | 83.8 | 59.4 | 1.41 | 75,000 |
| Comp.Ex.4-6 | - | R-3 1.1 g | I-1 0.32 g | B-1 0.9 g | 58.9 | 57.2 | 1.03 | 26,000 |
| Comp.Ex.4-7 | - | D-1 1.1 g | S-1 0.31 g | B-1 0.9 g | 59.8 | 57.5 | 1.04 | 28,000 |

R-1: dipentaerythritol hexaacrylate

R-2: pentaerythritol tetraacrylate

R-3: the compound shown in Table 11

B-1: benzyl methacrylate/methacrylic acid copolymer

(molar ratio = 82/18, weight-averaged molecular weight 102,000)

Results in Tables 13 to 15 indicate that an excellent printing durability is attained in the planographic printing

plates using the image recording material of the invention, in which a ratio Y1/Y2 is 1.1 or higher.

The present invention provides an image recording material which is directly recordable by digital data for example from a computer, by a recording with a solid-state laser or a semiconductor laser emitting an infrared ray, and a photosensitive composition employable in such image recording material and excellent in image quality, particularly in screen dot reproducibility.

## Claims

1. An image recording material comprising a substrate and an image recording layer provided thereon by coating said substrate with a photosensitive composition, wherein:

    said photosensitive composition comprising a compound capable of causing a hardening reaction by being exposed by an infrared ray; and
    after being exposed by an infrared laser, an electrostatic capacitance rate of increase ratio of said photosensitive composition, which ratio is calculated from the following equation, is no more than 0.7: Electrostatic capacitance rate of increase ratio =
    (electrostatic capacitance rate of increase in an exposed area/
    electrostatic capacitance rate of increase in an unexposed area)

2. An image recording material comprising a substrate and an image recording layer provided on said substrate, wherein said image recording layer comprises an infrared absorbing agent; a radical generating agent; and a radical polymerizable compound, and in said image recording layer, an image obtained by an exposure to an infrared laser and a development has a gradation (γ) of at least 4.

3. An image recording material according to claim 2, wherein the photosensitive composition comprises at least one structural unit represented by the following general formulae (1), (2) and (3) in an amount equal to or higher than 0.1 mol% and less than 30 mol%, and a polymer compound which can be one of dissolved and swollen by one of water and an alkaline aqueous solution:

General formula (1)

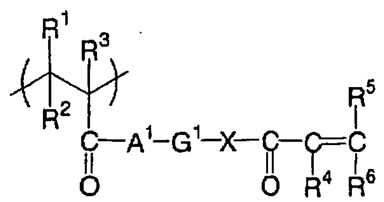

General formula (2)

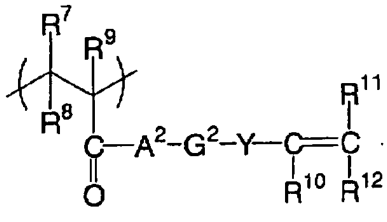

General formula (3)

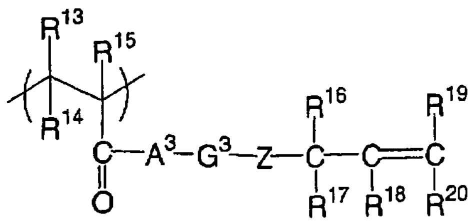

wherein $A^1$, $A^2$ and $A^3$ each independently represents an oxygen atom, a sulfur atom or $-N(R^{21})-$; $R^{21}$ represents an alkyl group which may include substituents; $G^1$, $G^2$ and $G^3$ each independently represents a divalent organic group; X and Z each independently represents an oxygen atom, a sulfur atom or $-N(R^{22})-$; $R^{22}$ represents an alkyl group which may include substituents; Y represents an oxygen atom, a sulfur atom, a phenylene group which may include substituents, or $-N(R^{23})-$; $R^{23}$ represents an alkyl group which may include substituents; and $R^1$ to $R^{20}$ each independently represents a monovalent organic group.

**4.** An image recording material according to claim 2 or 3, wherein said image has a gradation (γ) of at least 6.

**5.** An image recording material according to any of claims 1 to 4, wherein the radical generating agent used in the image recording layer is at least one of an onium salt and a triazine compound.

**6.** An image recording material according to any of claims 1 to 5, wherein said image recording layer further comprises, as a binder, a linear organic polymer which can be one of dissolved and swollen by one of water and an alkaline aqueous solution.

**7.** A photosensitive composition comprising a compound capable of causing a hardening reaction when exposed by an infrared ray, wherein after being exposed by an infrared laser, an electrostatic capacitance rate of increase ratio of said photosensitive composition, which ratio is calculated from the following equation, is no more than 0.7:
Electrostatic capacitance rate of increase ratio =
(electrostatic capacitance rate of increase in an exposed area/
electrostatic capacitance rate of increase in an unexposed area)

**8.** An image recording material comprising a substrate and a recording layer, which is provided on said substrate and capable of image formation by heat mode exposure, wherein said recording layer comprises:

a polymerizable compound;
a photothermal converting agent; and
a radical generating agent, and
in said recording layer, a ratio of a film hardness after exposure to a film hardness before exposure is at least 1.1.

**9.** An image recording material comprising a substrate and a recording layer, which is provided on said substrate and capable of image formation by heat mode exposure, wherein said recording layer comprises:

a polymerizable compound;
a photothermal converting agent; and
a radical generating agent, and
in said recording layer, a ratio of a surface contact angle after exposure to a surface contact angle before exposure is at least 1.1.

**10.** An image recording material according to claim 7 or 8, wherein at least one of a radical polymerizable compound having at least four aromatic rings and a polymer compound having a polymerizable group in a side chain and insoluble in water and soluble in an alkali aqueous solution is included as said polymerizable compound.

**11.** An image recording material according to any of claims 7 to 9, wherein a polymer insoluble in water and soluble in an alkali aqueous solution is included as a binder in said recording layer.

FIG. 1

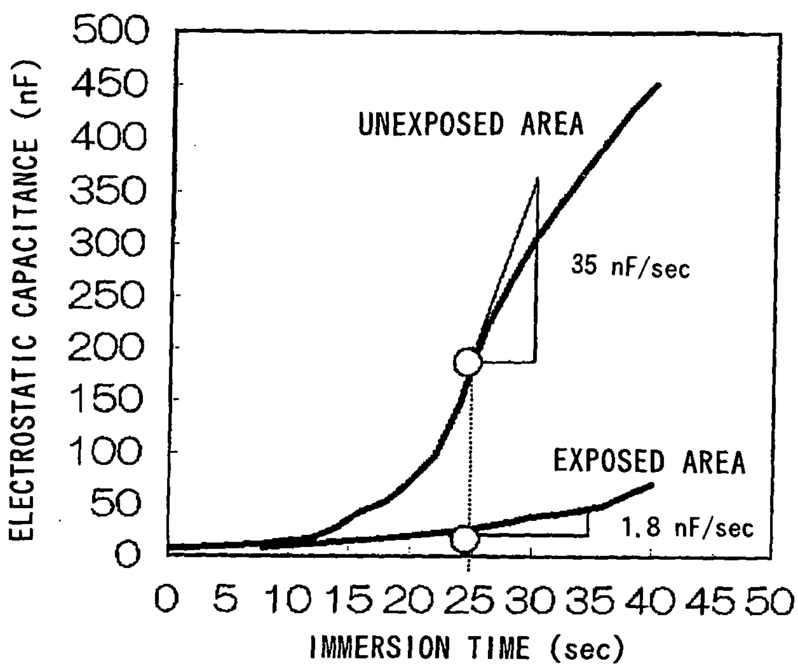
ELECTROSTATIC CAPACITANCE (nF)
500
450
400
350
300
250
200
150
100
50
0
UNEXPOSED AREA
35 nF/sec
EXPOSED AREA
1.8 nF/sec
0 5 10 15 20 25 30 35 40 45 50
IMMERSION TIME (sec)